# EUROPEAN PATENT APPLICATION

(11) **EP 4 804 733 A1**
(43) Date of publication of application: **09.09.2026**
(21) Application number: 24885197.4
(22) Date of filing: 18.01.2024
(51) Int. Cl.: H05H 1/24

(54) **ACTIVE GAS GENERATION DEVICE**

(30) Priority: 01.11.2023 WO PCT/JP2023/039462
(71) Applicant: TMEIC Corporation, Tokyo 104-0031 (JP)
(72) Inventor: ARITA, Ren, Tokyo 104-0031 (JP); ONO, Yuji, Tokyo 104-0031 (JP)
(74) Representative: TBK
(86) International application number: PCT/JP2024/001258
(87) International publication number: WO 2025/094419

(57) **Abstract**

An object of the present disclosure is to provide a structure of an active gas generation apparatus capable of supplying active gas of high purity without complexing a manufacturing process. An electrode unit (81) makes a dielectric film (F2) serve as a protection target dielectric film in dielectric films (F2) and (F3), and includes a dielectric protection film (FC2) firmly attached to a lower surface of the dielectric film F2. A discharge space (4) is provided to include a region where a high voltage electrode (F5) and a ground electrode (F6) are overlapped with each other in a plan view in a dielectric space (18) as a space where the dielectric protection film (FC2) and the dielectric film (F3) face each other. A constituent material of the dielectric protection film (FC2) has protection properties that irradiation of the dielectric film (F2) with ions generated by dielectric barrier discharge is blocked in generation of the dielectric barrier discharge in the discharge space (4) and chemical reaction with the ions does not occur.

## Description

### TECHNICAL FIELD

The present disclosure relates to an active gas generation apparatus having a parallel plate type electrode structure and generating active gas using dielectric barrier discharge.

### BACKGROUND ART

In a conventional active gas generation apparatus with a parallel plate type electrode structure in which a dielectric barrier discharge is adopted, a gap between a metal electrode (electrode conductive film) and a dielectric film (electrode dielectric film) facing each other or a gap between dielectric films facing each other serves as a discharge space.

Adopted to the conventional active gas generation apparatus is a parallel plate type dielectric barrier discharge in which dielectric barrier discharge is generated in a discharge space, and material gas injected in the discharge space is activated to generate the active gas.

For example, an active gas generation apparatus disclosed in Patent Document 1 is an example of an active gas generation apparatus in which the parallel plate type dielectric barrier discharge is adopted.

### PRIOR ART DOCUMENTS

### PATENT DOCUMENT(S)

Patent Document 1: International Publication No. 2019/138456

### SUMMARY

### PROBLEM TO BE SOLVED BY THE INVENTION

In such a conventional active gas generation apparatus, dielectric barrier discharge is generated in a discharge space. Thus, there is a possibility that ions generated by the dielectric barrier discharge and a dielectric film cause chemical reaction depending on a type of material gas and a material of a dielectric film, and a dielectric film reaction phenomenon in which atoms constituting the dielectric film or chemical compounds thereof are discharged from the dielectric film occurs.

When the dielectric film reaction phenomenon occurs, the discharged atoms or chemical compounds thereof are mixed with active gas, and this state indicates that impurity is mixed into the active gas. Such a dielectric film reaction phenomenon can be theoretically prevented by changing the material of the dielectric film to a material which is not chemically reacted.

However, in a case where workability of the material after change is poor, there is a problem that a manufacturing process for forming a dielectric film having a complex shape is complicated when a shape of the dielectric film is complex.

As described above, the conventional active gas generation apparatus has a problem that the above dielectric film reaction phenomenon is not suppressed and active gas of high purity cannot be generated without complicating the manufacturing process.

An object of the present disclosure is to solve the above problems, and provide an active gas generation apparatus capable of supplying active gas of high purity without complicating a manufacturing process.

### MEANS TO SOLVE THE PROBLEM

An active gas generation apparatus according to the present disclosure is an active gas generation apparatus including an electrode unit activating material gas supplied to a discharge space and generating active gas, wherein the electrode unit includes: a first electrode constituting part; and a second electrode constituting part provided to a lower side of the first electrode constituting part, the first electrode constituting part includes a first electrode dielectric film and a first electrode conductive film provided on an upper surface of the first electrode dielectric film, the second electrode constituting part includes a second electrode dielectric film and a second electrode conductive film provided on a lower surface of the second electrode dielectric film, a dielectric space is provided between the first electrode dielectric film and the second electrode dielectric film, the discharge space includes a main discharge space as a region in which the first and second electrode conductive films are overlapped with each other in a plan view in the dielectric space, the electrode unit further includes a dielectric protection member provided on a side of the dielectric space with respect to a protection target dielectric film as at least one of the first electrode dielectric film and the second electrode dielectric film, and a constituent material of the dielectric protection member has protection properties that irradiation of the protection target dielectric film with ions generated by dielectric barrier discharge is blocked in generation of the dielectric barrier discharge in the discharge space and chemical reaction with the ions does not occur.

### EFFECTS OF THE INVENTION

In the active gas generation apparatus according to the present disclosure, the dielectric protection member having the above protection properties is located between the dielectric space including the discharge space and the protection target dielectric film, thus the dielectric film reaction phenomenon that the protection target dielectric film is reacted with the ions in generation of the dielectric barrier discharge in the discharge space can be suppressed.

As a result, the active gas generation apparatus according to the present disclosure reliably prevents mixture of atoms of the protection target dielectric film corresponding to a dielectric film reaction phenomenon, for example, into the discharge space, thus can generate active gas of high purity.

In addition, the electrode unit can be made only by adding a dielectric protection member without changing original constituent materials of the first and second electrode dielectric films, thus the manufacturing process of the electrode unit is not complicated.

These and other objects, features, aspects and advantages of the present disclosure will become more apparent from the following detailed description of the present disclosure when taken in conjunction with the accompanying drawings.

### BRIEF DESCRIPTION OF DRAWINGS

[Fig. 1] is a plan view schematically illustrating a planar structure of an active gas generation apparatus as an embodiment 1 according to the present disclosure.
[Fig. 2] is a cross-sectional view illustrating a cross-section structure of an A-A cross section in Fig. 1.
[Fig. 3] is an explanation diagram (No. 1) schematically illustrating a planar structure of an electrode unit.
[Fig. 4] is an explanation diagram illustrating a cross-section structure of a B-B cross section in Fig. 3.
[Fig. 5] is an explanation diagram (No. 2) schematically illustrating a planar structure of the electrode unit.
[Fig. 6] is an explanation diagram illustrating a cross-section structure of a C-C cross section in Fig. 5.
[Fig. 7] is an explanation diagram schematically illustrating a planar structure of a chassis.
[Fig. 8] is an explanation diagram schematically illustrating a cross-section structure of the chassis.
[Fig. 9] is an explanation diagram schematically illustrating a planar structure of a high voltage side dielectric film.
[Fig. 10] is an explanation diagram schematically illustrating a cross-section structure of the high voltage side dielectric film.
[Fig. 11] is an explanation diagram schematically illustrating a planar structure of a ground side dielectric film.
[Fig. 12] is an explanation diagram schematically illustrating a cross-section structure of the ground side dielectric film.
[Fig. 13] is an explanation diagram schematically illustrating a planar structure of a power supply body.
[Fig. 14] is an explanation diagram schematically illustrating a cross-section structure of the power supply body.
[Fig. 15] is an explanation diagram schematically illustrating a planar structure of a ground conductor.
[Fig. 16] is an explanation diagram schematically illustrating a cross-section structure of the ground conductor.
[Fig. 17] is an explanation diagram illustrating details of a focus region in Fig. 16.
[Fig. 18] is an explanation diagram schematically illustrating a planar structure of a cover dielectric film.
[Fig. 19] is an explanation diagram schematically illustrating a cross-section structure of the cover dielectric film.
[Fig. 20] is an explanation diagram schematically illustrating a planar structure of a ground side electrode constituting part.
[Fig. 21] is an explanation diagram schematically illustrating a cross-section structure of the ground side electrode constituting part.
[Fig. 22] is an explanation diagram schematically illustrating a planar structure of a shield dielectric film.
[Fig. 23] is an explanation diagram schematically illustrating a cross-section structure of the shield dielectric film.
[Fig. 24] is an explanation diagram schematically illustrating a planar structure of a dielectric film support member.
[Fig. 25] is an explanation diagram schematically illustrating a cross-section structure of a dielectric film support member.
[Fig. 26] is an explanation diagram schematically illustrating a planar structure of a dielectric film suppression member.
[Fig. 27] is an explanation diagram schematically illustrating a cross-section structure of the dielectric film suppression member.
[Fig. 28] is an explanation diagram illustrating details of a focus region in Fig. 27.
[Fig. 29] is an explanation diagram schematically illustrating a planar structure of a press member.
[Fig. 30] is an explanation diagram schematically illustrating a cross-section structure of the press member.
[Fig. 31] is an explanation diagram schematically illustrating an ejection form of active gas in an electrode unit in the active gas generation apparatus according to the embodiment 1.
[Fig. 32] is an explanation diagram schematically illustrating an ideal ejection form of the active gas in the electrode unit according to the embodiment 1.
[Fig. 33] is an explanation diagram illustrating a cross-section structure of an electrode unit in an active gas generation apparatus according to an embodiment 2.
[Fig. 34] is an explanation diagram (No. 1) schematically illustrating a structure of the ground conductor according to the embodiment 2.
[Fig. 35] is an explanation diagram (No. 2) schematically illustrating a structure of the ground conductor according to the embodiment 2.
[Fig. 36] is an explanation diagram (No. 1) schematically illustrating a cross-section structure of a plurality of gas ejection ports according to the embodiment 2.
[Fig. 37] is an explanation diagram (No. 2) schematically illustrating a cross-section structure of a plurality of gas ejection ports according to the embodiment 2.
[Fig. 38] is an explanation diagram (No. 1) illustrating an ejection form of active gas in a chassis opening part in the electrode unit according to the embodiment 2.
[Fig. 39] is an explanation diagram (No. 2) illustrating an ejection form of active gas in a chassis opening part in the electrode unit according to the embodiment 2.
[Fig. 40] is an explanation diagram (No. 3) illustrating an ejection form of active gas in the chassis opening part in the electrode unit according to the embodiment 2.
[Fig. 41] is an explanation diagram (No. 4) illustrating an ejection form of active gas in the chassis opening part in the electrode unit according to the embodiment 2.
[Fig. 42] is an explanation diagram schematically illustrating a basic aspect of an electrode unit used for an active gas generation apparatus according to an embodiment 3.
[Fig. 43] is an explanation diagram illustrating an electrode unit used for an active gas generation apparatus of a second aspect according to the embodiment 3.
[Fig. 44] is an explanation diagram illustrating a cross-section structure of an electrode unit 811 used for the active gas generation apparatus of the second aspect according to the embodiment 3.
[Fig. 45] is an explanation diagram schematically illustrating a planar structure of a dielectric film support member illustrated in Fig. 44.
[Fig. 46] is an explanation diagram schematically illustrating a basic aspect of an electrode unit used for an active gas generation apparatus according to an embodiment 4.
[Fig. 47] is an explanation diagram schematically illustrating a basic aspect of an electrode unit used for an active gas generation apparatus according to an embodiment 5.
[Fig. 48] is an explanation diagram schematically illustrating an electrode unit 830 used for the active gas generation apparatus of a second aspect according to the embodiment 5.
[Fig. 49] is an explanation diagram illustrating a cross-section structure of an electrode unit 831 used for the active gas generation apparatus of the second aspect according to the embodiment 5.
[Fig. 50] is an explanation diagram illustrating a detailed structure of a focus region in Fig. 49.
[Fig. 51] is an explanation diagram schematically illustrating a planar structure of a dielectric film support member illustrated in Fig. 49.
[Fig. 52] is an explanation diagram schematically illustrating a basic aspect of an electrode unit used for an active gas generation apparatus according to an embodiment 6.
[Fig. 53] is an explanation diagram schematically illustrating a basic aspect of an electrode unit used for an active gas generation apparatus according to an embodiment 7.
[Fig. 54] is an explanation diagram (No. 1) for illustrating an effect of the active gas generation apparatus according to the embodiment 7.
[Fig. 55] is an explanation diagram (No. 2) for illustrating the effect of the active gas generation apparatus according to the embodiment 7.
[Fig. 56] is an explanation diagram (No. 3) for illustrating the effect of the active gas generation apparatus according to the embodiment 7.
[Fig. 57] is an explanation diagram illustrating a cross-section structure of an electrode unit used for an active gas generation apparatus of a second aspect according to the embodiment 7.
[Fig. 58] is an explanation diagram illustrating details of a focus region in Fig. 57.
[Fig. 59] is an explanation diagram illustrating a cross-section structure of an active gas generation apparatus of first and second aspects according to an embodiment 8.
[Fig. 60] is an explanation diagram illustrating a detailed structure of a focus region in Fig. 59 of a first aspect according to the embodiment 8.
[Fig. 61] is an explanation diagram illustrating a detailed structure of a focus region in Fig. 59 of a second aspect according to the embodiment 8.

### DESCRIPTION OF EMBODIMENT(S)

### <Embodiment 1>

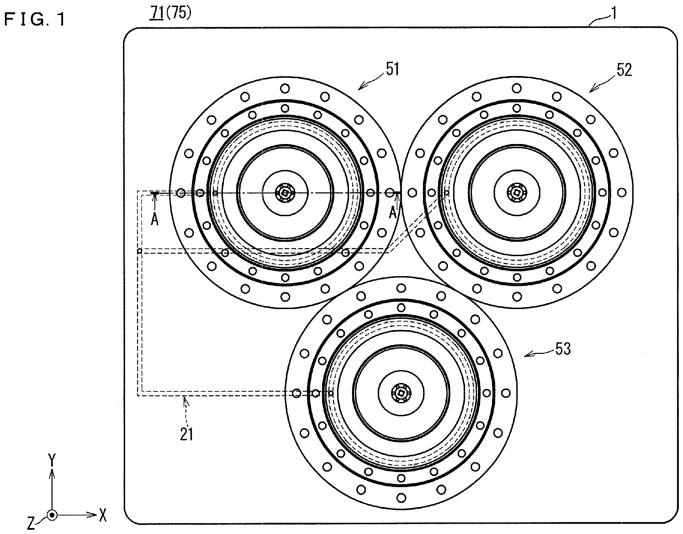

Fig. 1 is a plan view schematically illustrating a planar structure of an active gas generation apparatus 71 as an embodiment 1 according to the present disclosure.

As illustrated in Fig. 1, three electrode units 51 to 53 are housed in a chassis 1 in the active gas generation apparatus 71. Material gas G1 is supplied to each of the electrode units 51 to 53 through a gas flow path 21. Each of the electrode units 51 to 53 activates the material gas G1 supplied to a discharge space 4 to generate active gas G2.

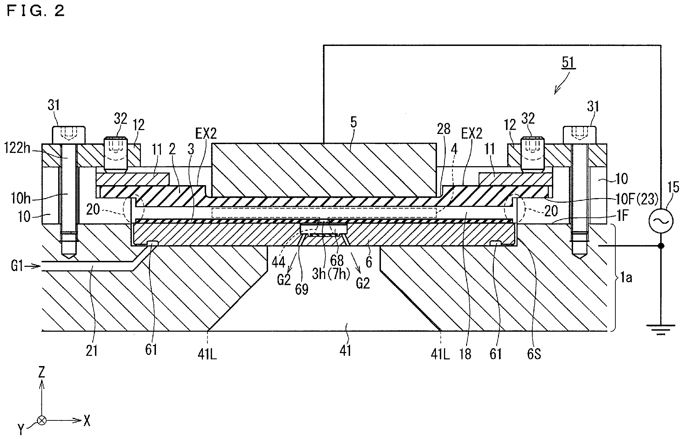

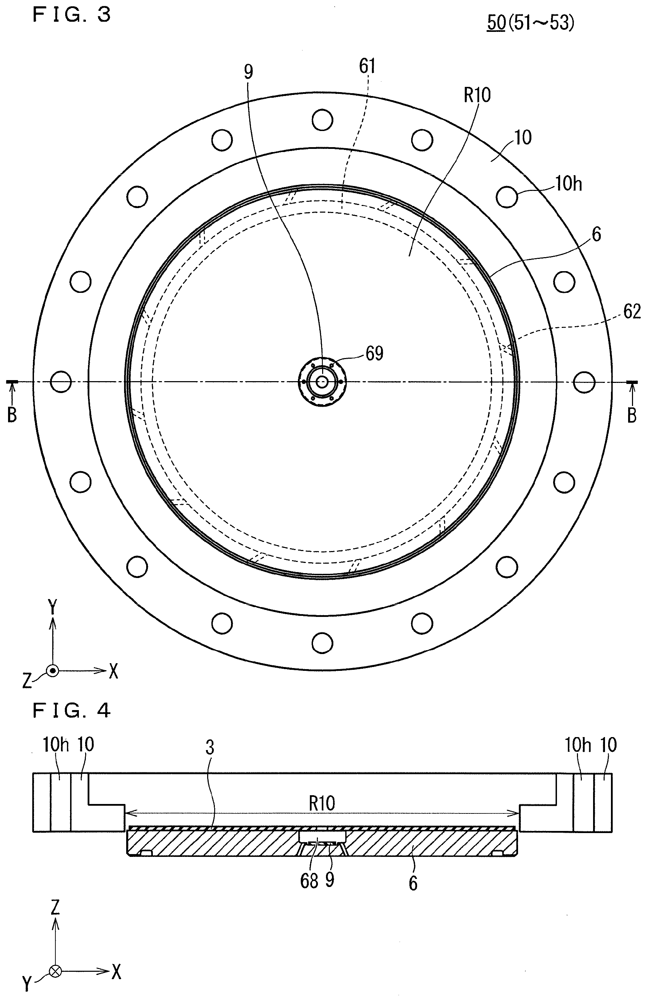

Fig. 2 is a cross-sectional view illustrating a cross-section structure of an A-A cross section in Fig. 1. Fig. 3 to Fig. 6 are explanation diagrams each partially illustrating a structure of an electrode unit 50. The electrode unit 50 corresponds to any of the electrode units 51 to 53. The electrode units 51 to 53 have the same structure as each other.

Fig. 3 is an explanation diagram schematically illustrating a planar structure of the electrode unit 50. Fig. 4 is an explanation diagram illustrating a cross-section structure of a B-B cross section in Fig. 3. Each of Fig. 3 and Fig. 4 is a first explanation diagram illustrating a structure of a ground conductor 6 and an area around the ground conductor 6.

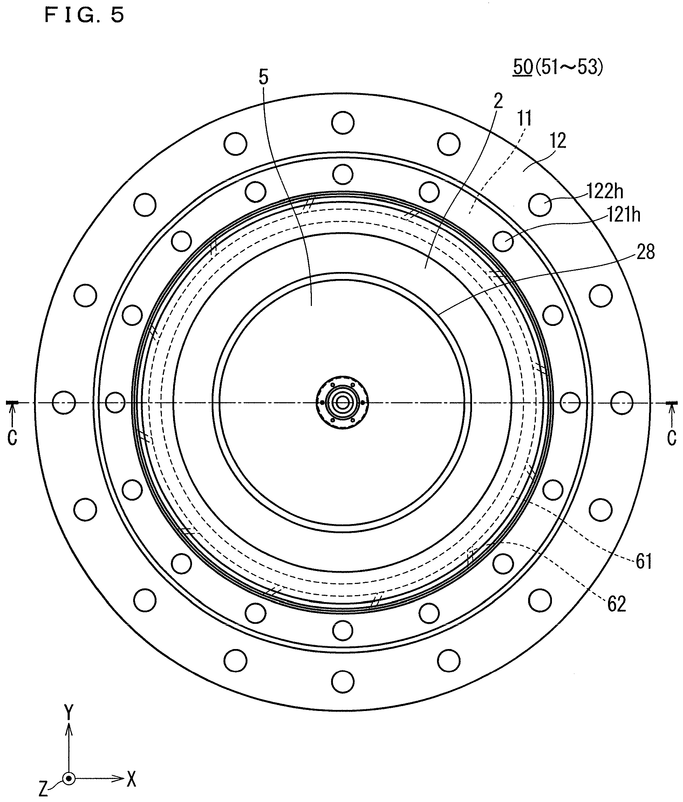

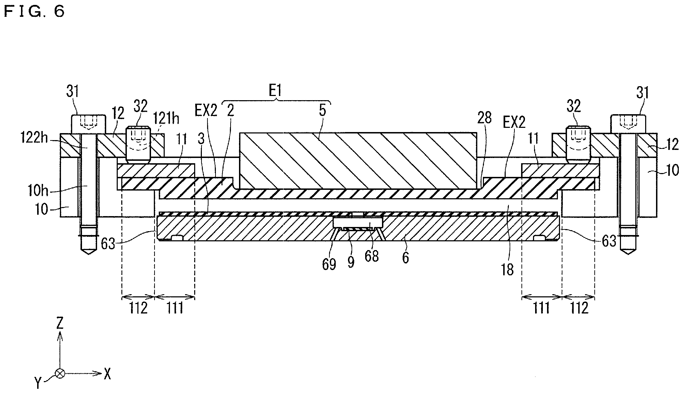

Fig. 5 is an explanation diagram schematically illustrating a planar structure of the electrode unit 50. Fig. 6 is an explanation diagram illustrating a cross-section structure of a C-C cross section in Fig. 5. Each of Fig. 5 and Fig. 6 is a second explanation diagram illustrating a detailed structure of the ground conductor 6 and the area around the ground conductor 6.

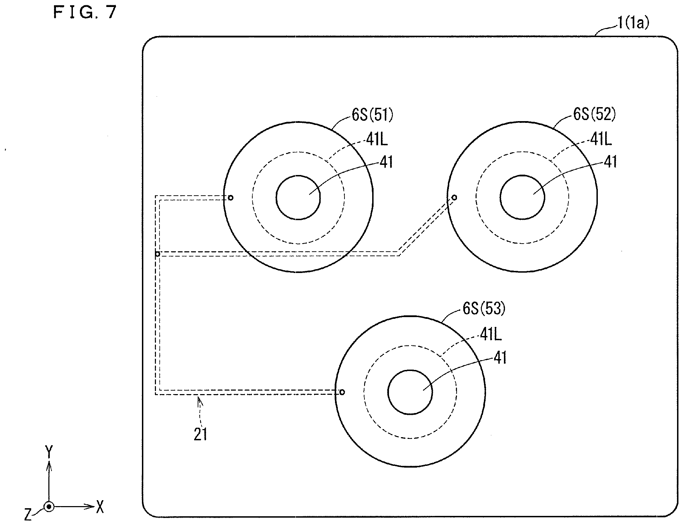

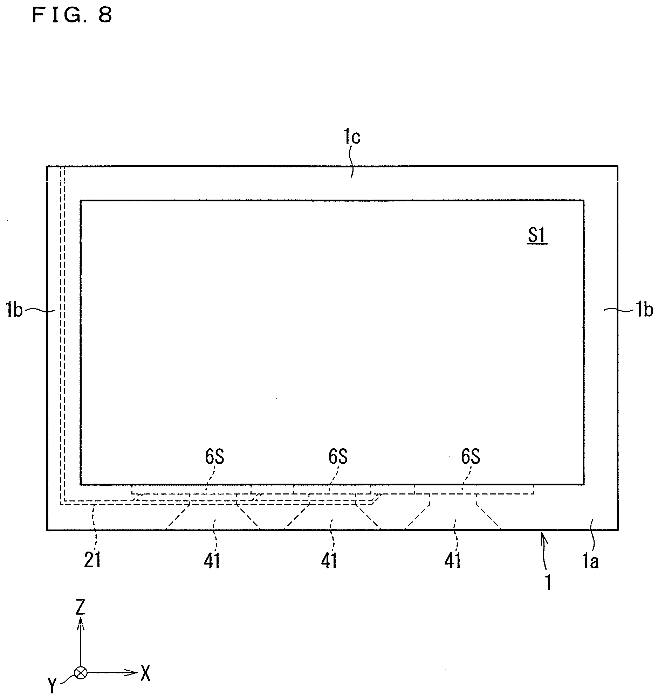

Fig. 7 to Fig. 30 are explanation diagrams each illustrating details of constituent components of the electrode unit 50. Fig. 7 and Fig. 8 are explanation diagrams each schematically illustrating a structure of the chassis 1. Fig. 7 illustrates a planar structure of the chassis 1, and Fig. 8 illustrates a cross-section structure of the chassis 1.

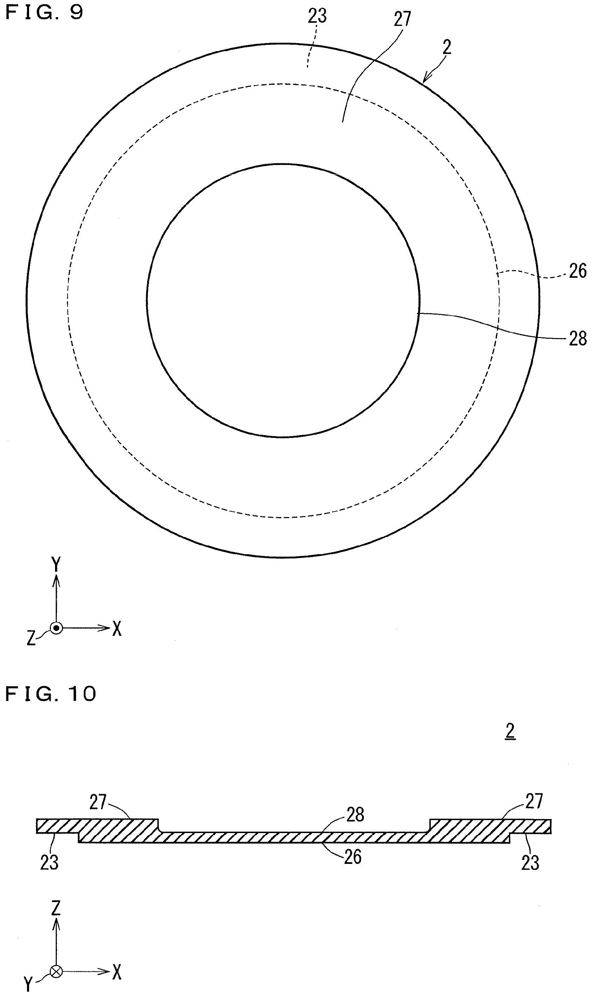

Fig. 9 and Fig. 10 are explanation diagrams each schematically illustrating a structure of a high voltage side dielectric film 2. Fig. 9 illustrates a planar structure of the high voltage side dielectric film 2, and Fig. 10 illustrates a cross-section structure of the high voltage side dielectric film 2.

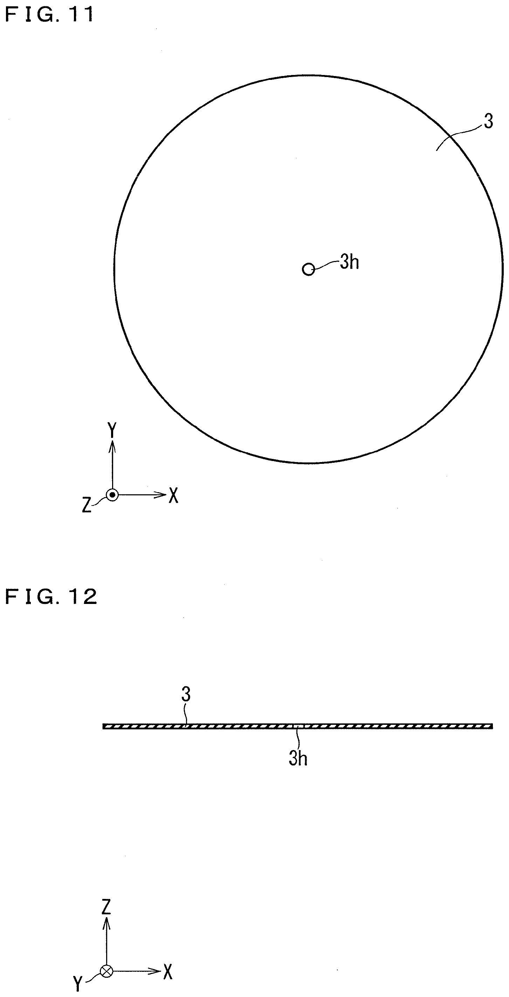

Fig. 11 and Fig. 12 are explanation diagrams each schematically illustrating a structure of a ground side dielectric film 3. Fig. 11 illustrates a planar structure of the ground side dielectric film 3, and Fig. 12 illustrates a cross-section structure of the ground side dielectric film 3.

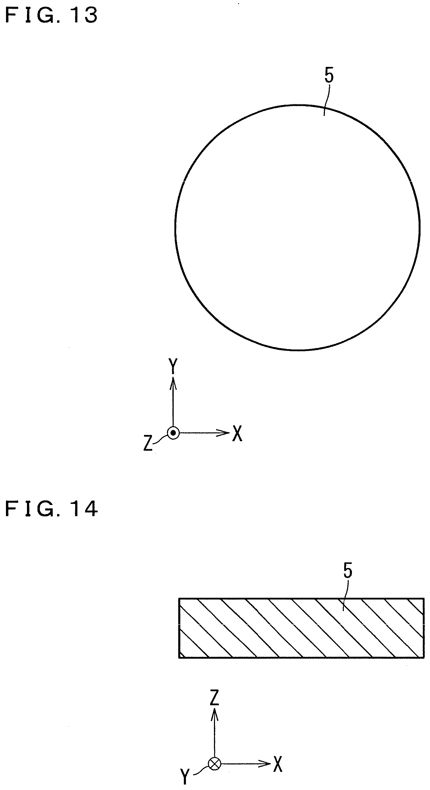

Fig. 13 and Fig. 14 are explanation diagrams each schematically illustrating a structure of a power supply body 5. Fig. 13 illustrates a planar structure of the power supply body 5, and Fig. 14 illustrates a cross-section structure of the power supply body 5.

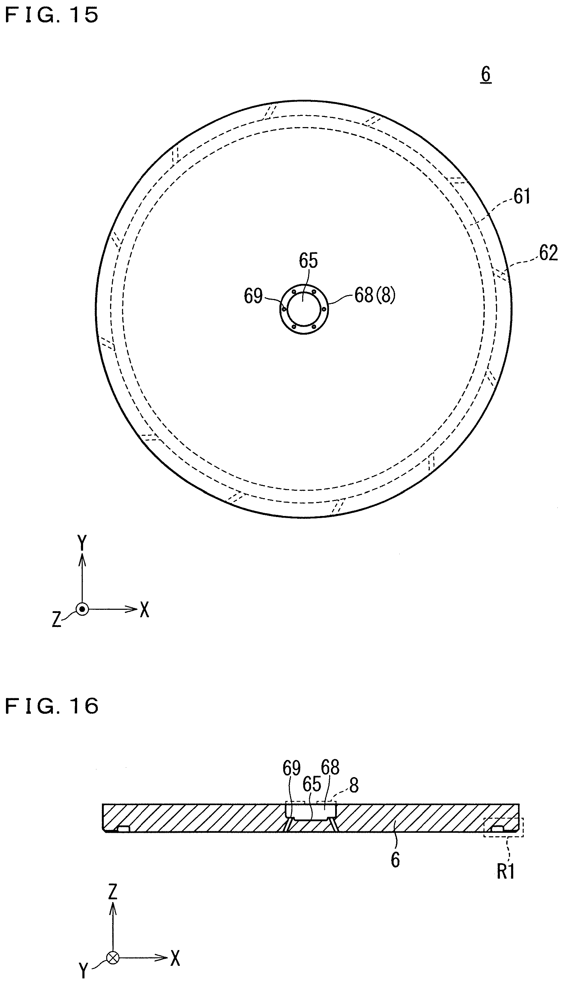

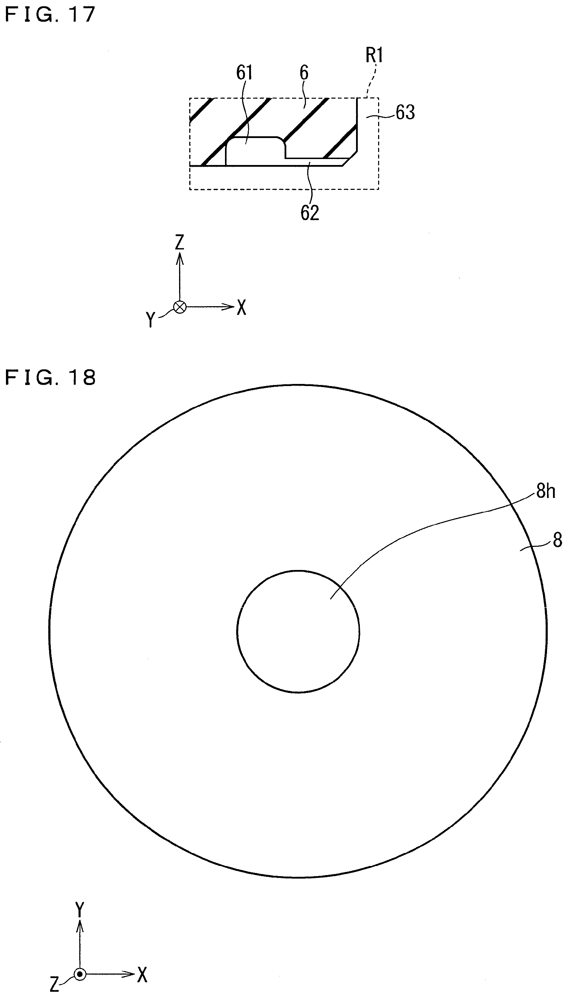

Fig. 15 and Fig. 17 are explanation diagrams each schematically illustrating a structure of the ground conductor 6. Fig. 15 illustrates a planar structure of the ground conductor 6, Fig. 16 illustrates a cross-section structure of the ground conductor 6, and Fig. 17 illustrates details of a focus region R1 in Fig. 16.

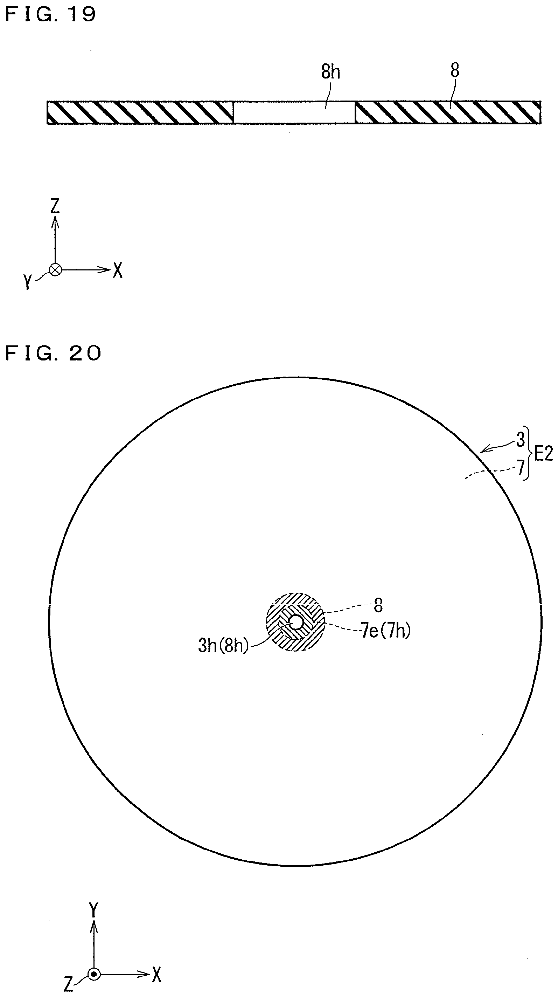

Fig. 18 and Fig. 19 are explanation diagrams each schematically illustrating a structure of a cover dielectric film 8. Fig. 18 illustrates a planar structure of the cover dielectric film 8, and Fig. 19 illustrates a cross-section structure of the cover dielectric film 8.

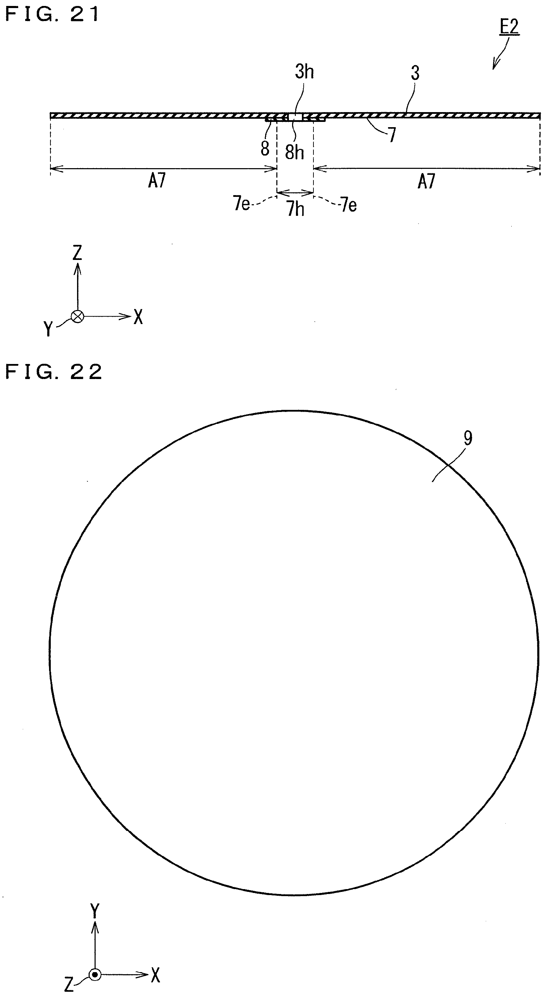

Fig. 20 and Fig. 21 are explanation diagrams each schematically illustrating a structure of a ground side electrode constituting part E2. Fig. 20 illustrates a planar structure of the ground side electrode constituting part E2, and Fig. 21 illustrates a cross-section structure of the ground side electrode constituting part E2. The ground side electrode constituting part E2 includes a combination structure of the ground side dielectric film 3, a conductive film 7, and the cover dielectric film 8.

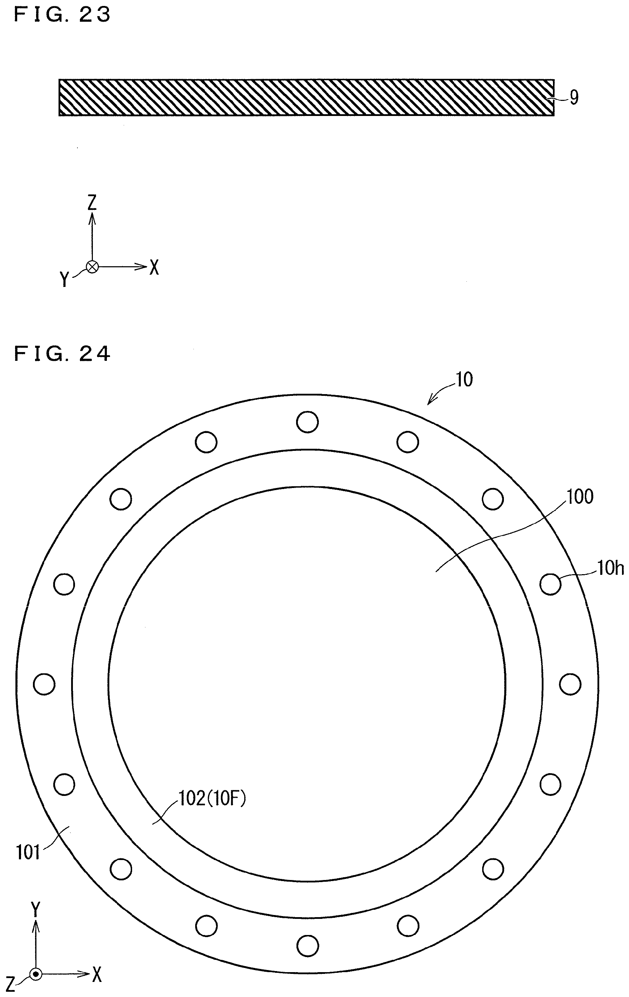

Fig. 22 and Fig. 23 are explanation diagrams each schematically illustrating a structure of a shield dielectric film 9. Fig. 22 illustrates a planar structure of the shield dielectric film 9, and Fig. 23 illustrates a cross-section structure of the shield dielectric film 9.

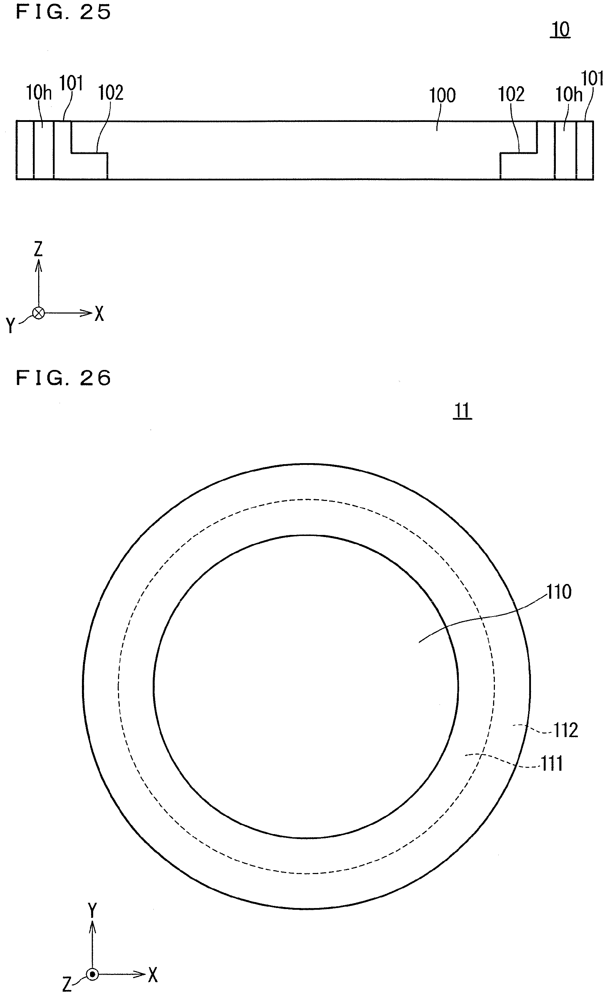

Fig. 24 and Fig. 25 are explanation diagrams each schematically illustrating a structure of a dielectric film support member 10. Fig. 24 illustrates a planar structure of the dielectric film support member 10, and Fig. 25 illustrates a cross-section structure of the dielectric film support member 10.

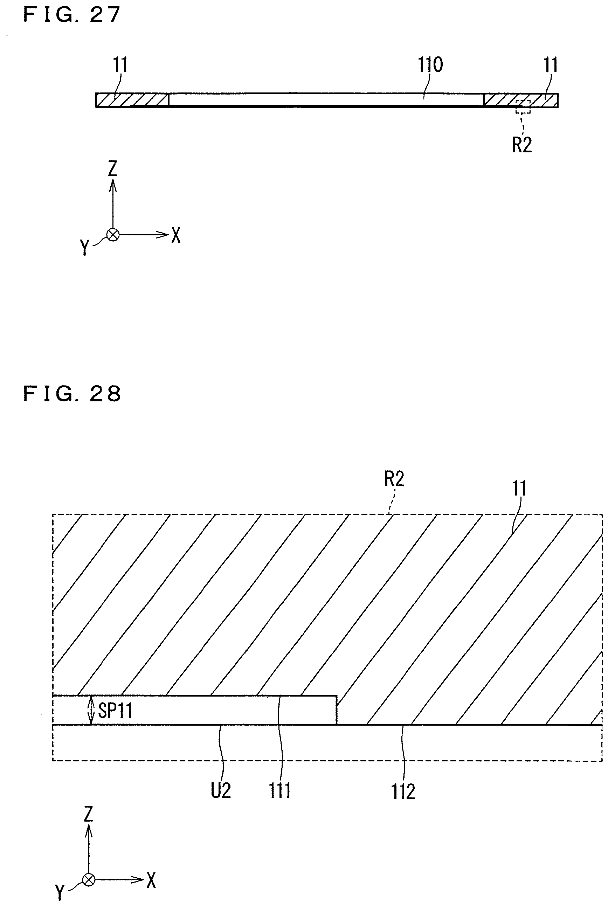

Fig. 26 to Fig. 28 are explanation diagrams each schematically illustrating a structure of a dielectric film suppression member 11. Fig. 26 illustrates a planar structure of the dielectric film suppression member 11, Fig. 27 illustrates a cross-section structure of the dielectric film suppression member 11, and Fig. 28 illustrates details of a focus region R2 in Fig. 27.

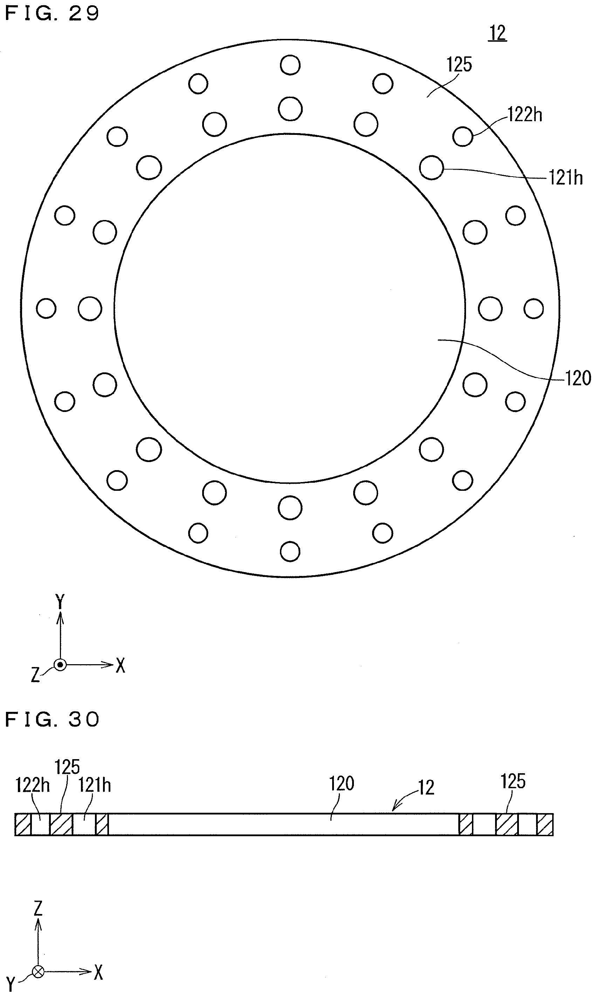

Fig. 29 and Fig. 30 are explanation diagrams each schematically illustrating a structure of a press member 12. Fig. 29 illustrates a planar structure of the press member 12, and Fig. 30 illustrates a cross-section structure of the press member 12.

Each of Fig. 1 to Fig. 30 schematically illustrates constituent components of the active gas generation apparatus 71, the electrode unit 50, or the electrode unit 50, and a shape including scale reduction does not necessarily coincide with each other in Fig. 1 to Fig. 30. An XYZ rectangular coordinate system is illustrated in each of Fig. 1 to Fig. 30.

The active gas generation apparatus 71 according to the embodiment 1 is described hereinafter appropriately with reference to Fig. 1 to Fig. 30 described above.

### (Whole structure)

As illustrated in Fig. 1, the active gas generation apparatus 71 includes the electrode units 51 to 53 as the plurality of electrode units and the chassis 1 housing the electrode units 51 to 53 in a chassis space S1 (refer to Fig. 8) and having conductivity.

As illustrated in Fig. 2 and Fig. 7, the chassis 1 includes a chassis bottom part 1a including a flat surface 1F and a conductor housing space 6S concaved from the flat surface 1F in a depth direction.

As illustrated in Fig. 8, the chassis 1 includes the chassis bottom part 1a, a chassis side part 1b, and a chassis upper part 1c, and the chassis space S1 housing the electrode units 51 to 53 therein is formed by the chassis bottom part 1a, the chassis side part 1b, and the chassis upper part 1c.

Each of the electrode units 51 to 53 is housed in the chassis space S1 in the chassis 1 in a state where the ground conductor 6 is disposed in the conductor housing space 6S. As illustrated in Fig. 7, the material gas G1 supplied from an outer portion is supplied to a material gas flow space provided in a lower surface and a side surface of the ground conductor 6 disposed in the conductor housing space 6S through the gas flow path 21 provided in the chassis bottom part 1a.

The electrode unit 51 (50) includes a high voltage side electrode constituting part E1 as a first electrode constituting part and the ground side electrode constituting part E2 as a second electrode constituting part provided on a lower side of the high voltage side electrode constituting part E1.

The electrode unit 51 further includes the ground conductor 6 as a reference potential conductor provided on a lower side of the ground side electrode constituting part E2 as the second electrode constituting part and housed in the conductor housing space 6S. The ground conductor 6 includes a conductor such as metal as a constituent material.

The high voltage side electrode constituting part E1 as the first electrode constituting part includes the high voltage side dielectric film 2 as the first electrode dielectric film and the power supply body 5 as the first electrode conductive film formed on the upper surface of the high voltage side dielectric film 2. The power supply body 5 as the first electrode conductive film is provided on a power supply body arrangement concave part 28 provided in a center of the high voltage side dielectric film 2 as the first electrode dielectric film.

The high voltage side dielectric film 2 includes a dielectric as a constituent material, and the power supply body 5 includes a conductor such as metal as a constituent material. For example, the power supply body 5 is made of metal.

The ground side electrode constituting part E2 includes the ground side dielectric film 3 as the second electrode dielectric film and the conductive film 7 as the second electrode conductive film formed on the lower surface of the ground side dielectric film 3. The conductive film 7 has a small film thickness, thus illustration thereof is omitted in Fig. 2 etc., and a formation region of the conductive film 7 is illustrated in Fig. 20 and Fig. 21.

The ground side dielectric film 3 includes a dielectric as a constituent material, and the conductive film 7 includes a conductor such as metal as a constituent material.

The ground conductor 6 as the reference potential conductor includes an active gas buffer space 68 which does not pass through an upper portion, and the ground side electrode constituting part E2 is disposed to cover the active gas buffer space 68. Accordingly, a lower surface of the conductive film 7 and an upper surface of the ground conductor 6 have a contact relationship on an outer side of the active gas buffer space 68.

The ground side dielectric film 3 as the second electrode dielectric film includes a dielectric through port 3h passing through the ground side dielectric film 3 in a region overlapped with the active gas buffer space 68 in a plan view, the conductive film 7 as the second electrode conductive film includes a conductive film opening part 7h in a region overlapped with the active gas buffer space 68 in a plan view, and the conductive film opening part 7h is overlapped with the dielectric through port 3h in a plan view.

The chassis bottom part 1a of the chassis 1 includes the gas flow path 21 receiving the material gas G1 from an outer portion, and a material gas flow space is provided between the ground conductor 6 and the conductor housing space 6S in the chassis 1. As described hereinafter, the material gas flow space includes a material gas buffer space 61, a slit space 62, and a side surface space 63.

The material gas G1 is introduced into a main discharge space of the discharge space 4 through the gas flow path 21 and the material gas flow space described above. As described hereinafter, the main discharge space indicates the discharge space 4 in a dielectric space 18 between the high voltage side dielectric film 2 and the ground side dielectric film 3.

Alternating current voltage applied from an alternating current power source 15 is applied to the power supply body 5 as the first electrode conductive film via an electrical connection means such as an electrical wiring or an introduction terminal. Illustration of the electrical connection means is omitted in Fig. 2 etc.

In the meanwhile, the chassis 1 is set to have ground potential as reference potential. Accordingly, the conductive film 7 as the second electrode conductive film is set to have ground potential via the chassis 1 and the ground conductor 6.

The electrode unit 51 (50) further includes an auxiliary member such as the dielectric film support member 10, the dielectric film suppression member 11, and the press member 12.

### (Fixation of high voltage side dielectric film 2)

A level difference part 102 of the dielectric film support member 10 includes an upper surface serving as a support surface 10F provided on the flat surface 1F of the chassis 1 to support the high voltage side dielectric film 2 from a lower side. At this time, the dielectric film support member 10 is disposed on the flat surface 1F so that a side surface of the dielectric film support member 10 and a side surface of the conductor housing space 6S on the chassis bottom part 1a of the chassis 1 coincide with each other.

The dielectric film suppression member 11 is a member for suppressing the high voltage side dielectric film 2 from an upper side, and is not overlapped with the power supply body 5 in a plan view. That is to say, an exposed region EX2 where the dielectric film suppression member 11 and the power supply body 5 are not formed is located on the upper surface of the high voltage side dielectric film 2.

As illustrated in Fig. 6, Fig. 27, and Fig. 28, a lower surface of the dielectric film suppression member 11 includes a dielectric contact region 112 having contact with the upper surface of the high voltage side dielectric film 2 and a dielectric non-contact region 111 which does not have contact with the upper surface of the high voltage side dielectric film 2. The dielectric contact region 112 serves as a region having contact with the high voltage side dielectric film 2 to apply a load, and the dielectric non-contact region 111 serves as a region protruding to a side of the power supply body 5 on the upper surface of the high voltage side dielectric film 2 without having a contact relationship with the high voltage side dielectric film 2.

The dielectric contact region 112 is overlapped with a surrounding region of the high voltage side dielectric film 2 and the support surface 10F of the dielectric film support member 10 in a plan view, and the dielectric non-contact region 111 is overlapped with an intermediate region on an inner side of the surrounding region of the high voltage side dielectric film 2 in a plan view. That is to say, the intermediate region is a region adjacent to a side of the power supply body 5 from the surrounding region of the high voltage side dielectric film 2.

The dielectric film suppression member 11 is made of metal etc., has conductivity, and is set to have ground potential as reference potential via the chassis 1, an attachment bolt 31, and the press member 12. The attachment bolt 31 and the press member 12 also have conductivity.

Accordingly, the high voltage side dielectric film 2 is suppressed by the dielectric film suppression member 11 from the upper side in the dielectric contact region 112. A combination structure of the dielectric film support member 10, the dielectric film suppression member 11, and the press member 12 is described in detail hereinafter.

As illustrated in Fig. 2, the press member 12 is disposed on the upper surface of the dielectric film support member 10, and the press member 12 and the dielectric film support member 10 are fixed on the chassis bottom part 1a of the chassis 1 by the attachment bolt 31.

As illustrated in Fig. 24 and Fig. 25, the dielectric film support member 10 has a circular shape having a center opening part 100 in a center thereof in a plan view. A level difference structure made up of the level difference part 102 and a surrounding part upper surface 101 is provided to have an annular shape around the center opening part 100. An upper surface of the level difference part 102 serves as the support surface 10F. A plurality of through ports 10h are dispersedly disposed to have a circular shape in the surrounding part upper surface 101 on a side of an outer periphery of the level difference part 102 (the support surface 10F).

In the meanwhile, as illustrated in Fig. 9 and Fig. 10, the high voltage side dielectric film 2 has a circular shape with the power supply body arrangement concave part 28 in a center thereof in a plan view. A surrounding surface region 27 is annularly provided around the power supply body arrangement concave part 28. The high voltage side dielectric film 2 includes a circular concave part bottom surface 26 in a plan view, and a bottom surface around the concave part bottom surface 26 serves as an annular convex part bottom surface 23.

As illustrated in Fig. 13 and Fig. 14, the power supply body 5 has a columnar shape. The power supply body 5 is disposed on the upper surface of the high voltage side dielectric film 2 while a bottom surface of the power supply body 5 is located on the power supply body arrangement concave part 28 of the high voltage side dielectric film 2.

Alternating current voltage is applied to the power supply body 5 as the first electrode conductive film from the alternating current power source 15. As illustrated in Fig. 5, the power supply body arrangement concave part 28 includes the power supply body 5 in a plan view, and has a planar shape slightly larger than the power supply body 5.

The high voltage side dielectric film 2 is disposed on the dielectric film support member 10 while the support surface 10F of the dielectric film support member 10 and the convex part bottom surface 23 of the high voltage side dielectric film 2 have contact with each other. The high voltage side dielectric film 2 and the dielectric film support member 10 have contact with each other via a seal member such as an O ring not shown in the diagrams.

As illustrated in Fig. 26 and Fig. 27, the dielectric film suppression member 11 has a circular shape having a center opening part 110 in a center thereof in a plan view. An annular lower surface region provided on a side of an outer periphery of the center opening part 110 serves as the dielectric non-contact region 111, and an annular lower surface region provided on a side of an outer periphery of the dielectric non-contact region 111 serves as the dielectric contact region 112.

As illustrated in Fig. 28, the dielectric contact region 112 protrudes to a lower side of the dielectric non-contact region 111 (-Z direction), and has a contact relationship with an upper surface U2 of the high voltage side dielectric film 2. In the meanwhile, a gap SP11 is located between the dielectric non-contact region 111 and the upper surface U2 of the high voltage side dielectric film 2, thus the dielectric non-contact region 111 does not have contact with the upper surface U2 of the high voltage side dielectric film 2.

As illustrated in Fig. 29 and Fig. 30, the press member 12 has a circular shape having a center opening part 120 in a center thereof in a plan view. A plurality of inner through ports 121h are dispersedly disposed to have a circular shape in an outer surrounding region 125 on a side of an outer periphery of the center opening part 120, and a plurality of outer through ports 122h are dispersedly disposed to have a circular shape on a side of an outer periphery of the plurality of inner through ports 121h.

In this manner, the plurality of inner through ports 121h and the plurality of outer through ports 122h are provided in the outer surrounding region 125 of the press member 12. Each of the plurality of inner through ports 121h is a through port made by cutting a tap.

A part of the outer surrounding region 125 in the press member 12 having the above structure is disposed on the dielectric film support member 10, and the dielectric film support member 10 and the press member 12 are fixed to the chassis bottom part 1a of the chassis 1 by the plurality of attachment bolts 31. A screw part of each of the plurality of attachment bolts 31 passes through each of the plurality of outer through ports 122h and each of the plurality of through ports 10h, and is attached to the chassis bottom part 1a.

As illustrated in Fig. 2 to Fig. 6, the press member 12 is disposed in a region overlapped with the dielectric film support member 10 and the dielectric film suppression member 11 in a plan view.

In the meanwhile, a plurality of suppression auxiliary members 32 are attached to the press member 12 while passing through the plurality of inner through ports 121h of the press member 12. A bolt or a locking screw is considered as the suppression auxiliary member 32. The plurality of suppression auxiliary members 32 are attached to an inner side of the plurality of inner through ports 121h while pressing the dielectric film suppression member 11. The plurality of suppression auxiliary members 32 are provided in a position overlapped with the dielectric contact region 112 of the dielectric film suppression member 11 and the convex part bottom surface 23 of the high voltage side dielectric film 2 in a plan view.

Accordingly, the high voltage side dielectric film 2 is suppressed from the dielectric contact region 112 on an upper side by the dielectric film suppression member 11 receiving suppress strength of the plurality of suppression auxiliary members 32.

As described above, in the electrode unit 50 of the active gas generation apparatus 71 according to the embodiment 1, the high voltage side dielectric film 2 as the first electrode dielectric film is suppressed from the dielectric contact region 112 on the upper side by the dielectric film suppression member 11 receiving suppress strength of the plurality of suppression auxiliary members 32. Thus, a region in which a load is applied to the high voltage side dielectric film 2 by the dielectric film suppression member 11 can be limited to a lower region of the dielectric contact region 112.

As a result, the active gas generation apparatus 71 according to the embodiment 1 can stably fix the high voltage side dielectric film 2 between the dielectric contact region 112 of the dielectric film suppression member 11 and the support surface 10F of the dielectric film support member 10 without unnecessary bending stress applied to the high voltage side dielectric film 2.

The dielectric film suppression member 11 is set to have ground potential as reference potential, and has conductivity. The dielectric non-contact region 111 of the dielectric film suppression member 11 is overlapped with the intermediate region of the high voltage side dielectric film 2 in a plan view.

Accordingly, the electrode unit 50 can reduce electrical field strength of the power supply body 5 by the dielectric film suppression member 11 including the dielectric non-contact region 111 to reduce potential of the intermediate region of the high voltage side dielectric film 2, thus potential of the high voltage side dielectric film 2 and the ground side dielectric film 3 in an outer diameter direction can be reduced.

As a result, the electrode unit 50 in the active gas generation apparatus 71 according to the embodiment 1 can reliably prevent insulation breakdown in a gap 20 between the high voltage side dielectric film 2 and the dielectric film support member 10.

### (Ground conductor 6)

As illustrated in Fig. 15 to Fig. 17, the ground conductor 6 housed in the conductor housing space 6S in the chassis 1 has a circular shape in a plan view, and includes the material gas buffer space 61 and the slit space 62 in an end portion region in the bottom surface.

The material gas buffer space 61 is formed into an annular shape in a plan view, and is connected to the gas flow path 21 as illustrated in Fig. 2, thus can take the material gas G1 supplied from an outer portion in the material gas buffer space 61 through the gas flow path 21.

The plurality of slit spaces 62 are dispersedly provided around the material gas buffer space 61. As illustrated in Fig. 17, each of the plurality of slit spaces 62 is connected to the material gas buffer space 61, and the material gas G1 can flow from the material gas buffer space 61 to the slit space 62.

As illustrated in Fig. 6 and Fig. 17, the side surface space 63 is a gap space between an inner peripheral side surface of the conductor housing space 6S and an outer peripheral side surface of the ground conductor 6, and is annularly provided in a plan view.

The dielectric film support member 10 and the ground conductor 6 have a positional relationship as illustrated in Fig. 3 and Fig. 4, thus the material gas G1 passing through the side surface space 63 is supplied to a lower side surface region R10 in the dielectric film support member 10.

In this manner, the material gas buffer space 61 is provided on the side of the lower surface of the ground conductor 6 to receive the material gas G1 through the gas flow path 21. Each of the plurality of slit spaces 62 is provided on the side of the lower surface of the ground conductor 6, and is connected to the material gas buffer space 61.

The side surface space 63 is provided on a side of the side surface of the ground conductor 6, and is connected to the plurality of slit spaces 62. As described above, the material gas flow space includes the material gas buffer space 61, the plurality of slit spaces 62, and the side surface space 63.

Accordingly, the material gas G1 supplied to the gas flow path 21 from the outer portion is introduced into the discharge space 4 through the material gas buffer space 61, the slit space 62, and the side surface space 63.

Each of the plurality of slit spaces 62 is set to be a narrow space in which material gas hardly flow compared with the material gas buffer space 61 so that the material gas G1 temporarily remains in the material gas buffer space 61, and then flows into each of the plurality of slit spaces 62. That is to say, the plurality of slit spaces 62 are set to have small conductance as a coefficient expressing a degree of flowability of the material gas G1 compared with the material gas buffer space 61 and the side surface space 63.

As a result, the active gas generation apparatus 71 according to the embodiment 1 can uniformly supply the material gas G1 spatially to the discharge space 4. That is to say, the material gas G1 is uniformly supplied from a surrounding part of the circular dielectric space 18 toward the discharge space 4 in the center in a plan view.

The conductance of the slit space 62 is set to be small, thus differential pressure between the material gas buffer space 61 and the side surface space 63 increases, and fluctuation of a flow amount of the material gas G1 flowing in each of the plurality of slit spaces 62 is reduced. Accordingly, the material gas G1 is uniformly supplied toward the discharge space 4. A flow amount of the material gas G1 is adjusted by a mass flow controller (MFC) provided on an upstream of the gas flow path 21, for example.

Accordingly, when the material gas G1 is not uniformly supplied in a general active gas generation apparatus, a time of the material gas G1 passing through the discharge space 4 is changed, and as a result, a failure of deterioration of generation efficiency of the active gas G2 occurs. The active gas generation apparatus 71 according to the embodiment 1 can uniformly supply the material gas G1, thus the failure described above does not occur.

### (Ground side electrode constituting part E2 and active gas buffer space 68)

As described above, the ground side electrode constituting part E2 as the second electrode constituting part includes the ground side dielectric film 3 and the conductive film 7.

As illustrated in Fig. 11 and Fig. 12, the ground side dielectric film 3 has a circular shape in a plan view, and includes the circular dielectric through port 3h in the center thereof.

As illustrated in Fig. 18 and Fig. 19, the cover dielectric film 8 has a circular shape in a plan view, and includes a circular cover through port 8h in the center thereof. It is preferable that the same constituent material is used for the cover dielectric film 8 and the ground side dielectric film 3. The reason is that occurrence of distortion is prevented in a case where a thermal expansion coefficient is different between the cover dielectric film 8 and the ground side dielectric film 3. It is also applicable to select a material having a close thermal expansion coefficient as a material of each of the cover dielectric film 8 and the ground side dielectric film 3.

As illustrated in Fig. 20 and Fig. 21, the conductive film 7 has a circular shape in a plan view, and includes the circular conductive film opening part 7h in the center thereof in a plan view.

Each of the dielectric through port 3h and the conductive film opening part 7h is overlapped with an active gas buffer space 68 in a plan view, and as illustrated in Fig. 21, the conductive film opening part 7h includes the dielectric through port 3h and has a shape larger than the dielectric through port 3h in a plan view.

The conductive film 7 is provided on the lower surface of the ground side dielectric film 3 while a center position of each of the ground side dielectric film 3 and the conductive film 7 coincides with each other. A diameter of the conductive film 7 is set to be substantially the same as that of the ground side dielectric film 3, however, a formation area of the conductive film 7 is smaller than that of the ground side dielectric film 3 by reason that the conductive film opening part 7h larger than the dielectric through port 3h is provided in the center thereof.

A conductive film inner boundary 7e as a circumferential outer peripheral line of the conductive film opening part 7h serves as an end portion of the conductive film 7 on a side of the dielectric through port 3h, and the conductive film 7 is not formed in a region on an inner side of the conductive film inner boundary 7e. The conductive film inner boundary 7e serves as an electrode boundary line of the conductive film 7. Accordingly, as illustrated in Fig. 21, a formation region A7 of the conductive film 7 on the lower surface of the ground side dielectric film 3 is a region ranging from a position of an outer periphery of the ground side dielectric film 3 to the conductive film inner boundary 7e.

As illustrated in Fig. 20 and Fig. 21, the cover dielectric film 8 is provided to have a circular shape from the lower surface of the ground side dielectric film 3 to the lower surface of the conductive film 7 while including the conductive film inner boundary 7e. However, the cover dielectric film 8 includes the cover through port 8h in a center thereof. That is to say, there is a dimensional relationship that an outer diameter of the conductive film opening part 7h of the conductive film 7 is smaller than that of the cover dielectric film 8.

The cover through port 8h has substantially the same shape as the dielectric through port 3h, and is included in the conductive film opening part 7h, thus has a shape smaller than the conductive film opening part 7h. Accordingly, the cover dielectric film 8 covers the conductive film inner boundary 7e (electrode boundary line) of the conductive film 7. The lower surface of the conductive film 7 which is not covered by the cover dielectric film 8 and the upper surface of the ground conductor 6 have a contact relationship with each other.

As illustrated in Fig. 15 and Fig. 16, the active gas buffer space 68 provided on the upper portion of the ground conductor 6 has a circular shape in a plan view, and a plurality of gas ejection ports 69 are provided around a bottom surface 65 of the active gas buffer space 68.

Fig. 16 and Fig. 16 also illustrate a formation region of the cover dielectric film 8. As illustrated in Fig. 15 and Fig. 16, an outer peripheral line of the cover dielectric film 8 is substantially the same as that of the active gas buffer space 68.

As illustrated in Fig. 2 and Fig. 16, the shield dielectric film 9 is provided on the bottom surface 65 of the active gas buffer space 68.

As illustrated in Fig. 22 and Fig. 23, the shield dielectric film 9 is formed into a circular shape with a predetermined film thickness in a plan view.

The shield dielectric film 9 is provided on the bottom surface 65 of the active gas buffer space 68 while a center position of each of the active gas buffer space 68 and the shield dielectric film 9 coincides with each other.

As illustrated in Fig. 15 and Fig. 16, the plurality of gas ejection ports 69 are overlapped with the cover dielectric film 8 in a plan view, and are not overlapped with the dielectric through port 3h and the cover through port 8h in a plan view.

As illustrated in Fig. 16, the plurality of gas ejection ports 69 are provided around the bottom surface 65 of the active gas buffer space 68 to pass through the ground conductor 6. That is to say, the plurality of gas ejection ports 69 are provided in a surrounding region of the shield dielectric film 9 in a plan view.

In the active gas generation apparatus 71 according to the embodiment 1 having such a structure, the material gas G1 is supplied from the outer portion of the metal chassis 1 to the discharge space 4 through the gas flow path 21 and the material gas flow space as described above.

When the material gas G1 is supplied to the discharge space 4 where the dielectric barrier discharge occurs, the material gas G1 is activated to be the active gas G2, and passes through the dielectric through port 3h and the cover through port 8h to be introduced into the active gas buffer space 68. The active gas G2 entering the active gas buffer space 68 passes through the plurality of gas ejection ports 69 provided in the bottom surface of the active gas buffer space 68 to be supplied to a processing space in a subsequent stage.

In the active gas generation apparatus 71 according to the embodiment 1 having such a configuration, a main dielectric space where the high voltage side dielectric film 2 as the first electrode dielectric film and the ground side dielectric film 3 as the second electrode dielectric film face each other serves as the dielectric space 18. The dielectric space 18 has a circular shape in a plan view. A space where the high voltage side dielectric film 2 and the shield dielectric film 9 face each other is regulated as an auxiliary dielectric space. The discharge space 4 includes a main discharge space where the power supply body 5 and the conductive film 7 are overlapped with each other in a plan view in the dielectric space 18.

In order to form the main discharge space described above, the high voltage side dielectric film 2 and the ground side dielectric film 3 are disposed to correspond to each other so as to have a constant distance therebetween in a height direction (Z direction), and the main discharge space described above of the discharge space 4 is located in the dielectric space 18 between the high voltage side dielectric film 2 and the ground side dielectric film 3.

The discharge space 4 further includes an auxiliary discharge space 44 made up of the dielectric through port 3h, the cover through port 8h, and a part of the active gas buffer space 68 on the shield dielectric film 9 in the auxiliary dielectric space described above.

A bottom region below the bottom surface 65 of the ground conductor 6 is used as a ground electrode conductive film set to have ground potential, and discharge voltage is applied between the power supply body 5 receiving alternating current voltage from the alternating current power source 15 and the ground electrode conductive film described above, thus the auxiliary discharge space 44 can be generated.

As described above, the auxiliary discharge space 44 includes the dielectric through port 3h, the cover through port 8h, and a part of the active gas buffer space 68. In this manner, the discharge space 4 formed in the embodiment 1 includes the main discharge space and the auxiliary discharge space 44 in the dielectric space 18.

In the active gas generation apparatus 71 according to the embodiment 1, a path from the auxiliary discharge space 44 to each of the plurality of gas ejection ports 69 is regulated as the active gas flow path.

In the active gas generation apparatus 71 according to the embodiment 1, the auxiliary discharge space 44 as a part of the discharge space 4 includes the dielectric through port 3h, the cover through port 8h, and a part of the active gas buffer space 68, thus can suppress the active gas flow path from the auxiliary discharge space 44 to the plurality of gas ejection ports 69 to have a minimum necessary volume to suppress a deactivation amount of the active gas G2.

Furthermore, the cover dielectric film 8 in the ground side electrode constituting part E2 of the electrode unit 50 covers the conductive film inner boundary 7e as the electrode boundary line of the conductive film 7 in the active gas buffer space 68, and is overlapped with the plurality of gas ejection ports 69 in a plan view, thus can suppress a surface deactivation phenomenon in which the active gas G2 gets dissipated due to collision of the active gas G2 with the conductive film 7.

As a result, the active gas generation apparatus 71 according to the embodiment 1 can supply the high concentration active gas G2 from the plurality of gas ejection ports 69 to the processing space in the subsequent stage.

The electrode unit 50 according to the embodiment 1 has the structure described above, thus only the components (the high voltage side dielectric film 2, the ground side dielectric film 3, the cover dielectric film 8, and the shield dielectric film 9) made up of the dielectric serving as the insulator as the constituent material face the discharge space 4. When a metal material faces discharge, it is easily ionized, and metal ions are included in gas, thus causes contamination.

### (Chassis opening part 41)

As illustrated in Fig. 2, the chassis bottom part 1a of the chassis 1 includes a chassis opening part 41. The chassis opening part 41 is provided in a region overlapped with the active gas buffer space 68 in a plan view, and passes through the chassis bottom part 1a.

Accordingly, the active gas G2 ejected from the plurality of gas ejection ports 69 is introduced into the processing space on the lower side through the chassis opening part 41.

As illustrated in Fig. 2, the chassis opening part 41 provided to the chassis bottom part 1a has a larger opening area with decreasing distance to the lower side, and has a tapered shape with a lowermost outer peripheral edge 41L as illustrated in Fig. 2 and Fig. 7.

In the active gas generation apparatus 71 according to the embodiment 1, the chassis opening part 41 provided to the chassis bottom part 1a of the chassis 1 has the tapered shape with the larger opening area with decreasing distance to the lower side.

Accordingly, the active gas generation apparatus 71 according to the embodiment 1 can suppress loss of the active gas G2 ejected from the plurality of gas ejection ports 69 due to collision of the active gas G2 with the chassis bottom part 1a to a minimum, thus can supply the high concentration active gas G2 to the processing space on the lower side.

### <Embodiment 2>

### (Problem in embodiment 1)

In the active gas generation apparatus 71 according to the embodiment 1 described above, the active gas G2 is supplied from the active gas buffer space 68 to the processing space in the subsequent stage located on the lower side through the plurality of gas ejection ports 69. In the description hereinafter, the active gas G2 ejected from the plurality of gas ejection ports 69 is defined as the plural pieces of partial active gas.

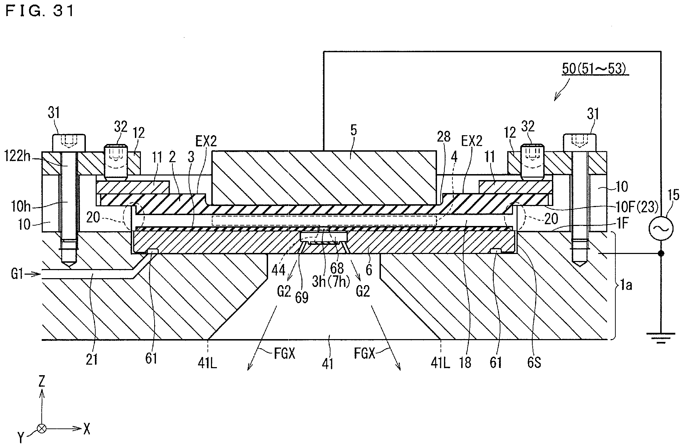

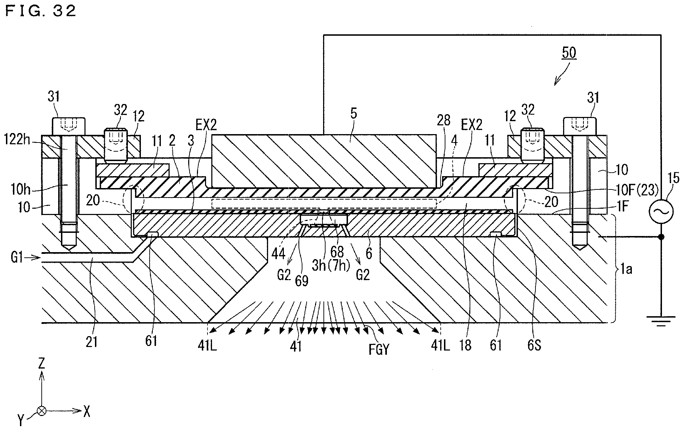

Fig. 31 is an explanation diagram schematically illustrating an ejection form of active gas G2 in the electrode unit 50 (51 to 53) in the active gas generation apparatus 71 according to the embodiment 1. Fig. 32 is an explanation diagram schematically illustrating an ideal ejection form of the active gas G2 in the electrode unit 50. Fig. 31 and Fig. 32 correspond to an A-A cross section in Fig. 1, for example. An XYZ rectangular coordinate system is illustrated in each of Fig. 31 and Fig. 32.

As illustrated in Fig. 31, in the electrode unit 50 (51 to 53) included in the active gas generation apparatus 71 according to the embodiment 1, the plurality of gas ejection ports 69 are provided to be away from each other with decreasing distance to the lower side so that collision does not occur between the plural pieces of partial active gas.

However, when spatial pressure p0 of the active gas buffer space 68 and spatial pressure of the processing space in the subsequent stage are significantly different from each other such as a case of {(p1/p0) < 0.5}, for example, the plural pieces of partial active gas ejected from the plurality of gas ejection ports 69 have a flow of only one direction referred to as a choked flow as illustrated by a gas flow FGX in Fig. 31, and each of the plural pieces of partial active gas is not diffused but proceeds in straight line.

Adopted in the active gas generation apparatus 71 according to the embodiment 1 is a structure of providing the plurality of gas ejection ports 69 for each electrode unit 50 to uniformly supply the active gas G2 to the processing space in the subsequent stage and further providing the plurality of electrode units 50 as the electrode units 51 to 53 to supply the active gas G2 to the processing space having a relatively wide region.

However, each of the plural pieces of partial active gas ejected from each electrode unit 50 is supplied to the processing space with a gas flow FGX in straight line illustrated in Fig. 31 which is not a gas flow FGY diffused to multiple directions illustrated in Fig. 32.

In this manner, the partial active gas ejected from each of the plurality of gas ejection ports 69 of the electrode unit 50 basically has only one directionality. Thus, the active gas generation apparatus 71 according to the embodiment 1 has a problem that the active gas G2 cannot be uniformly supplied to the processing space.

An object of an active gas generation apparatus 75 according to an embodiment 2 described hereinafter is to supply uniform active gas G2.

### (Structure of embodiment 2)

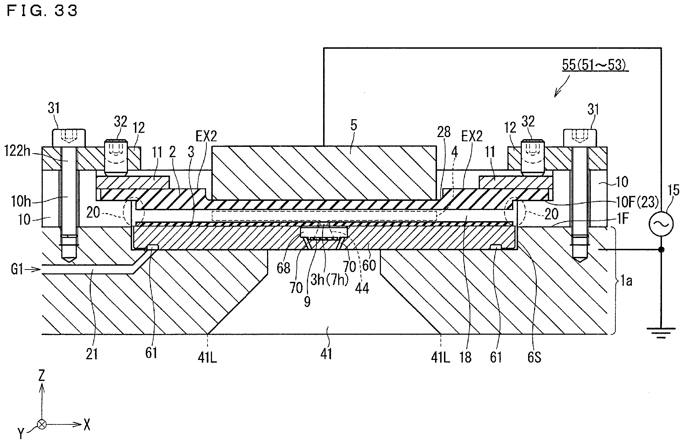

Fig. 33 is an explanation diagram illustrating a cross-section structure of an electrode unit 55 used in the active gas generation apparatus 75 according to the embodiment 2. An XYZ rectangular coordinate system is illustrated in Fig. 33.

A whole configuration of the active gas generation apparatus 75 is similar to that of the active gas generation apparatus 71 illustrated in Fig. 1. Accordingly, the electrode unit 55 illustrated in Fig. 33 corresponds to any of the whole configuration of the electrode units 51 to 53 in the active gas generation apparatus 75 illustrated in Fig. 1.

That is to say, the active gas generation apparatus 75 according to the embodiment 2 includes the electrode units 51 to 53 as the plurality of electrode units and the chassis 1 housing the electrode units 51 to 53 in the chassis space S1 (refer to Fig. 8) and having conductivity in the manner similar to the active gas generation apparatus 71 according to the embodiment 1.

The electrode unit 55 according to the embodiment 2 has characteristics that the ground conductor 6 of the electrode unit 50 according to the embodiment 1 is replaced with a ground conductor 60.

The same sign is assigned to the same constituent parts as those in the electrode unit 50 according to the embodiment 1, and characterizing portions of the electrode unit 55 according to the embodiment 2 is mainly described hereinafter.

As illustrated in Fig. 33, the electrode unit 55 includes the ground conductor 60 as a reference potential conductor, which is provided on the lower side of the ground side electrode constituting part E2 including the ground side dielectric film 3 and is housed in the conductor housing space 6S. The ground conductor 60 includes a conductor such as metal as a constituent material.

The electrode unit 55 according to the embodiment 2 is housed in the chassis space S1 in the chassis 1 while the ground conductor 60 is disposed in the conductor housing space 6S. The material gas G1 supplied from an outer portion is supplied to a material gas flow space provided in a lower surface and a side surface of the ground conductor 60 disposed in the conductor housing space 6S through the gas flow path 21 provided in the chassis bottom part 1a.

### (Ground conductor 60)

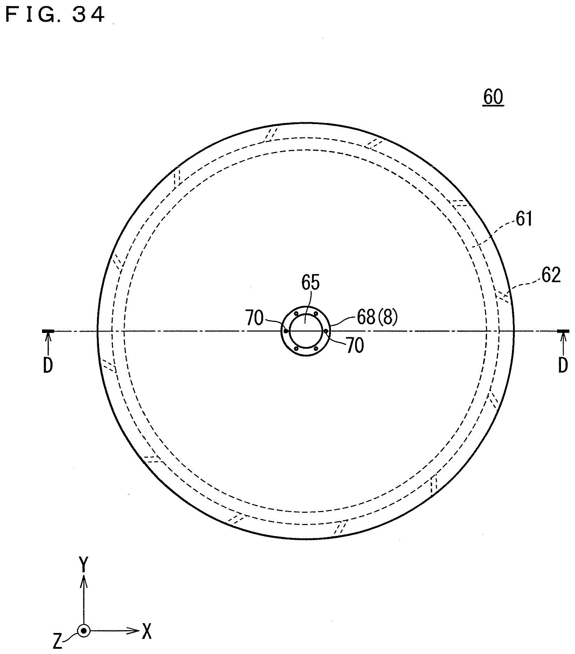

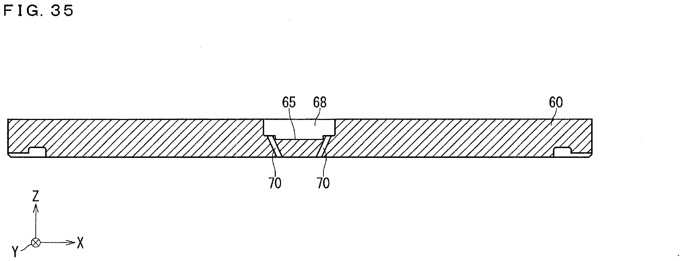

Fig. 34 and Fig. 35 are explanation diagrams each schematically illustrating a structure of the ground conductor 60. Fig. 34 illustrates a planar structure of the ground conductor 60, and Fig. 35 illustrates a cross-section structure of the ground conductor 60. An XYZ rectangular coordinate system is illustrated in each of Fig. 34 and Fig. 35.

The ground conductor 60 as the reference potential conductor includes the active gas buffer space 68 which does not pass through an upper portion, and the ground side electrode constituting part E2 including the ground side dielectric film 3 is disposed to cover the active gas buffer space 68. Accordingly, the lower surface of the conductive film 7 and an upper surface of the ground conductor 60 have a contact relationship on an outer side of the active gas buffer space 68.

The chassis 1 is set to have ground potential as reference potential in the manner similar to the embodiment 1. Accordingly, the conductive film 7 is set to have ground potential via the chassis 1 and the ground conductor 60.

The ground conductor 60 housed in the conductor housing space 6S in the chassis 1 has a circular shape in a plan view as illustrated in Fig. 34, and includes the material gas buffer space 61 and the slit space 62 in an end portion region in the bottom surface.

The material gas flow space including the material gas buffer space 61, the plurality of slit spaces 62, and the side surface space 63 is provided to the ground conductor 60 in the manner similar to the ground conductor 6 according to the embodiment 1.

Accordingly, the material gas G1 supplied to the gas flow path 21 from the outer portion is introduced into the discharge space 4 through the material gas buffer space 61, the slit space 62, and the side surface space 63.

Thus, the active gas generation apparatus 75 according to the embodiment 2 can uniformly supply the material gas G1 spatially to the discharge space 4 in the manner similar to the active gas generation apparatus 71 according to the embodiment 1.

As illustrated in Fig. 34 and Fig. 35, the active gas buffer space 68 provided to the upper portion of the ground conductor 60 has a circular shape in a plan view, and a plurality of gas ejection ports 70 are provided around a bottom surface 65 of the active gas buffer space 68.

The plurality of gas ejection ports 70 are overlapped with the cover dielectric film 8 in a plan view, and are not overlapped with the dielectric through port 3h and the cover through port 8h in a plan view in the manner similar to the plurality of gas ejection ports 69 according to the embodiment 1.

As illustrated in Figs. 33 to 35, the plurality of gas ejection ports 70 are provided around the bottom surface 65 of the active gas buffer space 68 to pass through the ground conductor 60. That is to say, the plurality of gas ejection ports 70 are provided in a surrounding region of the shield dielectric film 9 in a plan view.

When the material gas G1 is supplied to the discharge space 4 where the dielectric barrier discharge occurs, the material gas G1 is activated to be the active gas G2, and passes through the dielectric through port 3h and the cover through port 8h to be introduced into the active gas buffer space 68. The active gas G2 entering the active gas buffer space 68 passes through the plurality of gas ejection ports 70 provided in the bottom surface of the active gas buffer space 68 to be supplied to a processing space in a subsequent stage.

In the active gas generation apparatus 75 according to the embodiment 2, a path from the auxiliary discharge space 44 to each of the plurality of gas ejection ports 70 is regulated as the active gas flow path.

In the active gas generation apparatus 72 according to the embodiment 5, the auxiliary discharge space 44 as a part of the discharge space 4 includes the dielectric through port 3h, the cover through port 8h, and a part of the active gas buffer space 68, thus can suppress the active gas flow path from the auxiliary discharge space 44 to the plurality of gas ejection ports 70 to have a minimum necessary volume to suppress a deactivation amount of the active gas G2.

Furthermore, the cover dielectric film 8 in the ground side electrode constituting part E2 of the electrode unit 55 covers the conductive film inner boundary 7e as the electrode boundary line of the conductive film 7 in the active gas buffer space 68, and is overlapped with the plurality of gas ejection ports 70 in a plan view, thus can suppress a surface deactivation phenomenon in which the active gas G2 gets dissipated due to collision of the active gas G2 with the conductive film 7.

As a result, the active gas generation apparatus 75 according to the embodiment 2 can supply the high concentration active gas G2 from the plurality of gas ejection ports 70 to the processing space in the subsequent stage in the manner similar to the embodiment 1.

The chassis bottom part 1a of the chassis 1 includes the chassis opening part 41 in the region overlapped with the active gas buffer space 68 in a plan view, and the active gas G2 ejected from the plurality of gas ejection ports 70 is introduced into the processing space on the lower side through the chassis opening part 41.

In the active gas generation apparatus 75 according to the embodiment 2, the chassis opening part 41 provided to the chassis bottom part 1a of the chassis 1 has the tapered shape with the larger opening area with decreasing distance to the lower side.

Accordingly, the active gas generation apparatus 75 according to the embodiment 2 can suppress loss of the active gas G2 ejected from the plurality of gas ejection ports 70 due to collision of the active gas G2 with the chassis bottom part 1a, and can supply the relatively high concentration active gas G2 to the processing space on the lower side in the manner similar to the embodiment 1.

### (Plurality of gas ejection ports 70)

The active gas G2 ejected from the plurality of gas ejection ports 70 provided to the electrode unit 55 according to the embodiment 2 is supplied to the processing space in the subsequent stage located on the lower side. Herein, the active gas ejected from the plurality of gas ejection ports 70 is defined as the plural pieces of partial active gas.

In the electrode unit 55 according to the embodiment 2, the plural pieces of partial active gas ejected from the plurality of gas ejection ports 70 is introduced to the lower side through the chassis opening part 41.

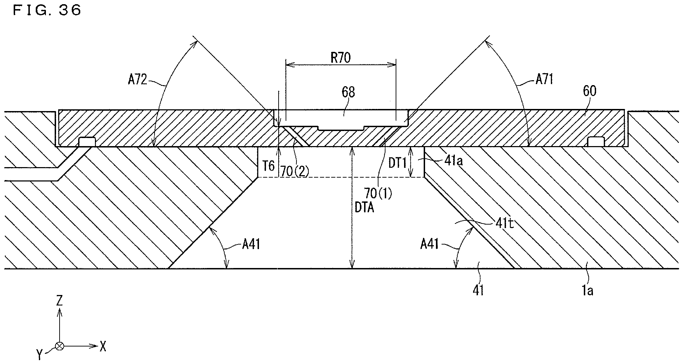

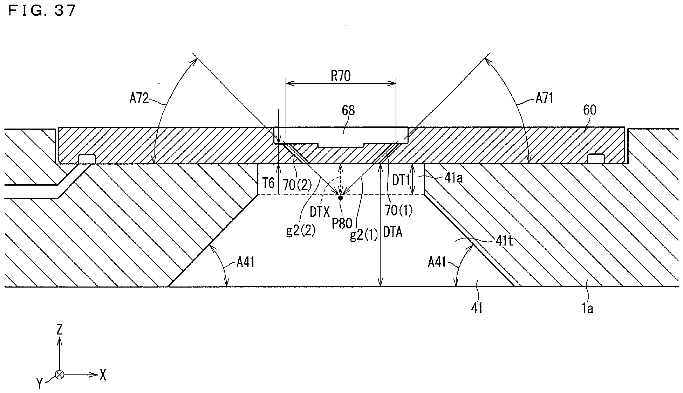

Fig. 36 and Fig. 37 are explanation diagrams each schematically illustrating a cross-section structure of a plurality of gas ejection ports 70, and correspond to a D-D cross-section structure in Fig. 34. An XYZ rectangular coordinate system is illustrated in each of Fig. 36 and Fig. 37.

As illustrated in Fig. 36 and Fig. 37, the chassis opening part 41 includes an upper side region 41a having a constant opening area in a height direction (Z direction) and a lower side tapered region 41t as a tapered region having a tapered shape with a larger opening area with decreasing distance to the lower side. In the chassis opening part 41, the lower side tapered region 41t is a tapered region provided on a lower side of the upper side region 41a.

Fig. 37 illustrates a coordinate position located on a slightly lower side of a center position of a boundary line between the upper side region 41a and the lower side tapered region 41t as a collision point P80. The collision point P80 is located in a collision region 80 described hereinafter, and is a center of the collision region 80.

In the electrode unit 55 according to the embodiment 1, the plurality of gas ejection ports 70 are provided to get closer to each other with decreasing distance to the lower side so that the plural pieces of partial active gas collide with each other in the collision point P80.

A structure of the plurality of gas ejection ports 70 is described in detail hereinafter. Fig. 36 and Fig. 37 illustrate two gas ejection ports 70, however, the number of the plurality of gas ejection ports 70 is "three" or more as illustrated in Fig. 34.

In the description hereinafter, the gas ejection port 70 on a right side (+X direction side) in Fig. 36 and Fig. 37 in two gas ejection ports 70 illustrated in each of Fig. 36 and Fig. 37 is referred to as the gas ejection port 70(1), and the gas ejection port 70 on a left side (-X direction side) therein is referred to as the gas ejection port 70(2).

As described above, the plurality of gas ejection ports 70 are circularly disposed to be away from each other in a plan view. A circular virtual line connecting centers of the plurality of gas ejection ports 70 is referred to as "a virtual gas ejection port circle" hereinafter.

The gas ejection ports 70(1) and 70(2) correspond to a pair of gas ejection ports 70 and 70 facing each other in a diameter direction in the virtual gas ejection port circle described above. Herein, the partial active gas ejected from the gas ejection port 70(1) is referred to as partial active gas g2(1) and the partial active gas ejected from the gas ejection port 70(2) is partial active gas g2(2).

The gas ejection port 70(1) has a constant ejection port inclination A71 larger than "0" and smaller than 90 degrees with respect to a horizontal direction (X direction) as a reference direction. The ejection port inclination A71 is set to a direction in which the partial active gas s2(1) ejected from the gas ejection port 70(1) is directed to the collision point P80.

The gas ejection port 70(2) has a constant ejection port inclination A72 larger than "0" and smaller than 90 degrees with respect to a horizontal direction in the manner similar to the gas ejection port 70(1). The ejection port inclination A72 is set to a direction in which the partial active gas s2(2) ejected from the gas ejection port 70(2) is directed to the collision point P80.

Both the ejection port inclinations A71 and A72 have the same angle, and are set to 45 degrees, for example.

A remaining film thickness T6 of the ground conductor 60 located below the active gas buffer space 68 where the gas ejection ports 70(1) and 70(2) are provided is set to 3 mm, for example. A formation interval R70 between center positions of the gas ejection ports 70(1) and 70(2) in an uppermost portion is set to 16.4 mm, for example. The formation interval R70 coincides with a length of a diameter Φ of a virtual gas ejection port circle.

In the meanwhile, a whole depth DTA along the Z direction of the chassis opening part 41 is set to 18.5 mm, for example, and an upper side depth DT1 along the Z direction of the upper side region 41a in the chassis opening part 41 is set to 5.0 mm, for example.

A side surface of the lower side tapered region 41t as the tapered region of the chassis opening part 41 extends conically along a taper inclination A41. The taper inclination A41 is set to 45 degrees, for example.

In the ground conductor 60 having the above structure, upon the ejection of the pieces of partial active gas g2(1) and g2(2) from the gas ejection ports 70(1) and 70(2), the partial active gas g2(1) and the partial active gas g2(2) collide with each other at the collision point P80. As illustrated in Fig. 37, a formation depth of the collision point P80 from a surface of the ground conductor 60 is a collision depth DTX.

Even in a case where the total number of the gas ejection ports 70 is "three" or more, when each gas ejection port 70 is disposed along the virtual gas ejection port circle having the formation interval R70 as the diameter and an ejection port inclination A70 having the same value in the direction toward the collision point P80 is set, three or more pieces of partial active gas can be made to collide with each other at the same collision point P80. The ejection port inclination A70 is a collective term of the ejection port inclinations A71 and A72, for example.

The collision depth DTX of the collision point P80 is 5.2 mm in a setting example of the ejection port inclinations A71 and A72, the formation interval R70, the remaining film thickness T6, and the upper side depth DT1 described above.

In consideration of diameters of the gas ejection ports 70(1) and 70(2), the plural pieces of partial active gas collide with each other in the collision region 80 extending from the collision point P80 as the center. Accordingly, in the above example, the collision region 80 is formed from an upper portion region of the lower side tapered region 41t toward a lower portion region of the upper side region 41a. That is to say, the collision region 80 is located in the lower side tapered region 41t or in the upper side region 41a on an upper side of the lower side tapered region 41t.

### (Ejection form of active gas G2)

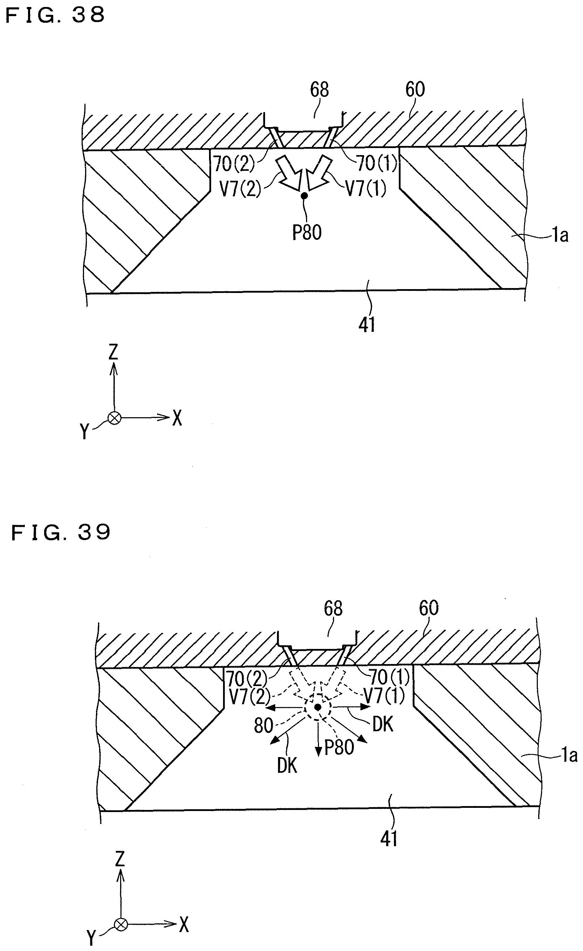

Fig. 38 to Fig. 41 are explanation diagrams each schematically illustrating an ejection form of the active gas G2 in the chassis opening part 41 in the electrode unit 55 according to the embodiment 2. Each of Fig. 38 to Fig. 41 corresponds to a part of a D-D cross section in Fig. 34. An XYZ rectangular coordinate system is illustrated in Fig. 38 to Fig. 41.

Hereinafter, an ejection direction of the partial active gas g2(1) ejected from the gas ejection port 70(1) is defined as a partial active gas ejection direction V7(1), and an ejection direction of the partial active gas g2(2) ejected from the gas ejection port 70(2) is defined as a partial active gas ejection direction V7(2).

As illustrated in Fig. 38, the partial active gas g2(1) is ejected along the partial active gas ejection direction V7(1) to reach the collision point P80, and the partial active gas g2(2) is ejected along the partial active gas ejection direction V7(2) to reach the collision point P80.

That is to say, the direction of the flow of the partial active gas g2(1) is only one direction of the partial active gas ejection direction V7(1), and the direction of the flow of the partial active gas g2(2) is only one direction of the partial active gas ejection direction V7(2).

Subsequently, as illustrated in Fig. 39, the partial active gas g2(1) and the partial active gas g2(2) collides with each other in the collision region 80 including the collision point P80, and the pieces of partial active gas g2(1) and g2(2) are diffused in a plurality of diffusion directions DK.

That is to say, the direction of the flow of the partial active gas g2(1) is diffused to the plurality of diffusion directions DK from one partial active gas ejection direction V7(1), and the direction of the flow of the partial active gas g2(2) is diffused to the plurality of diffusion directions DK from one partial active gas ejection direction V7(2). In this manner, the direction of the flow of each of the plural pieces of active gas is diffused to the plurality of diffusion directions from one direction in the collision region 80.

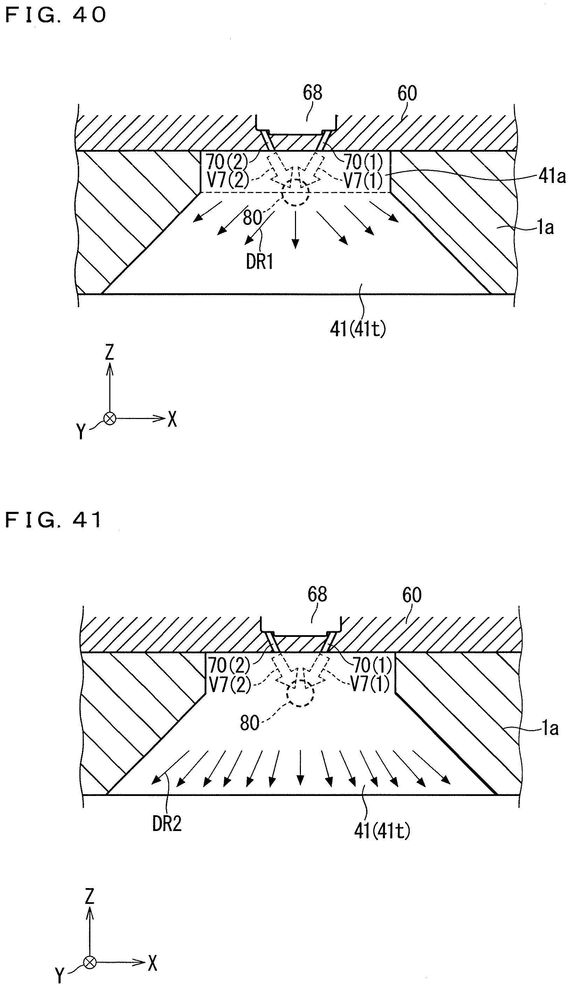

Then, as illustrated in Fig. 40, an intermediate supply direction DR1 of the plural pieces of partial active gas is regulated to be close to the taper inclination A41 under influence of the side surface of the lower side tapered region 41t.

In this manner, the collision region 80 is located in the lower side tapered region 41t and the upper side region 41a on the upper side of the lower side tapered region 41t, thus the plural pieces of partial active gas each diffused flows in the direction along the tapered shape of the side surface of the lower side tapered region 41t toward the lower side.

Subsequently, as illustrated in Fig. 41, the plural pieces of partial active gas are supplied to the processing space in the subsequent stage located on the lower side along a final supply direction DR2 of an extension along the taper inclination A41.

### (Effect)

The active gas generation apparatus 75 according to the embodiment 2 having such a configuration has an effect similar to that according to the embodiment 1 and further has an effect described hereinafter specific to the embodiment 2.

The active ga generation apparatus 75 according to the embodiment 2 houses the electrode unit 55 including the ground conductor 60 described above in the chassis space 1S in the chassis 1. The plurality of gas ejection ports 70 provided to the ground conductor 60 of the electrode unit 55 according to the embodiment 2 are provided in a form of getting closer to each other toward the lower side so that the plural pieces of partial active gas collide with each other in the collision region 80 including the collision point P80, and the collision region 80 is located in the lower side tapered region 41t or on the upper side of the lower side tapered region 41t.

Thus, as illustrated in Fig. 39, the plural pieces of partial active gas collide with each other in the collision region 80, thus the direction of the flow of each of the plural pieces of active gas is diffused to the plurality of diffusion directions DK from one direction.

The collision region 80 is located in the lower side tapered region 41t or on the upper side of the lower side tapered region 41t. Thus, the plural pieces of partial active gas each diffused flow in the direction along the tapered shape of the side surface of the lower side tapered region 41t, that is to say, the intermediate supply direction DR1 illustrated in Fig. 40 with decreasing distance to the lower side.

Subsequently, the active gas G2 including the plural pieces of partial active gas is diffused and flows in the direction along the tapered shape of the side surface of the lower side tapered region 41t, that is to say, the final supply direction DR2 illustrated in Fig. 41 from the lower side tapered region 41t toward the processing space on the lower side.

In this manner, the plural pieces of partial active gas ejected from the plurality of gas ejection ports 70 flows in the chassis opening part 41 as illustrated in Fig. 38 to Fig. 41.

As a result, even when the spatial pressure p0 of the active gas buffer space 68 and spatial pressure p1 of the processing space in the subsequent stage are significantly different from each other, the active gas generation apparatus 75 according to the embodiment 1 can uniformly supply the active gas G2 to the processing space in the subsequent stage.

The plurality of gas ejection ports 70 provided to the electrode unit 55 according to the embodiment 2 are formed to be inclined in the direction close to the collision region 80 including the collision point P80 with decreasing distance to the lower side, and the ejection port inclination A70 as a formation inclination with respect to the horizontal direction as the reference direction of each of the plurality of gas ejection ports 70 is set to have the same value as each other.

Thus, even when the number of the gas ejection ports 70 is "three" or more, the plural pieces of partial active gas ejected from the plurality of gas ejection ports 70 can be made to collide with each other in the same collision region 80.

As a result, the active gas generation apparatus 75 according to the embodiment 2 diffuses the plural pieces of partial active gas in the plurality of diffusion directions in one collision region 80, thus can uniformly supply the active gas G2 toward the processing space in the subsequent stage.

Furthermore, applied to the active gas generation apparatus 75 according to the embodiment 2 is the structure in which the plurality of electrode units 55 are provided as the electrode units 51 to 53 as illustrated in Fig. 1.

Thus, the active gas generation apparatus 75 according to the embodiment 2 ejects the plural pieces of partial active gas from each of the plurality of electrode units 51 to 53 each having the structure similar to the electrode unit 55, thus can uniformly supply the active gas G2 to the processing space in the subsequent stage having the relatively large region.

### <Embodiment 3>

### (Basic aspect)

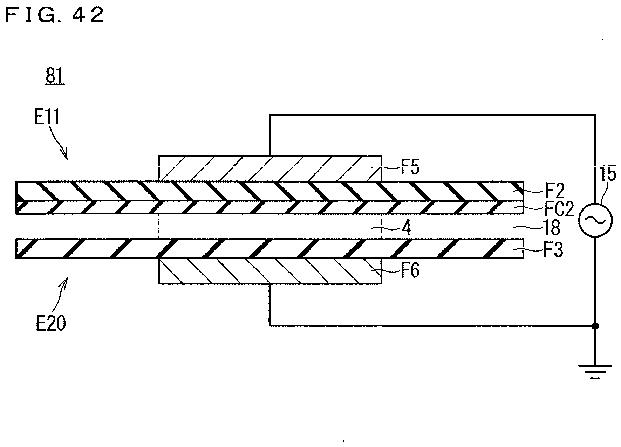

Fig. 42 is an explanation diagram schematically illustrating a basic aspect of an electrode unit 81 used for an active gas generation apparatus according to an embodiment 3. The active gas generation apparatus according to the embodiment 3 includes the electrode unit 81 activating the material gas G1 supplied to a discharge space 4 to generate active gas G2.

As illustrated in Fig. 42, the electrode unit 81 includes a high voltage side electrode constituting part E11 as a first electrode constituting part and a ground side electrode constituting part E20 as a second electrode constituting part provided on a lower side of the high voltage side electrode constituting part E11.

The high voltage side electrode constituting part E11 as the first electrode constituting part includes a dielectric film F2 as a first electrode dielectric film and a high voltage electrode F5 as a first electrode conductive film provided on an upper surface of the dielectric film F2.

The ground side electrode constituting part E20 as the second electrode constituting part includes a dielectric film F3 as a second electrode dielectric film and a ground electrode F6 as a second electrode conductive film provided on a lower surface of the dielectric film F3.

The electrode unit 81 according to the embodiment 3 has a feature that a dielectric protection film FC2 as a dielectric protection member is provided to be firmly attached to the lower surface of the dielectric film F2 without a gap. That is to say, the high voltage side electrode constituting part E11 in the electrode unit 81 according to the embodiment 3 includes the dielectric film F2, the high voltage electrode F5, and the dielectric protection film FC2.

The dielectric space 18 is formed between the dielectric film F2 and the dielectric film F3 via the dielectric protection film FC2. Specifically, a space where the dielectric protection film FC2 and the dielectric film F3 face each other serves as the dielectric space 18. The discharge space 4 includes a main discharge space as a region where the high voltage electrode F5 and the ground electrode F6 are overlapped with each other in a plan view in the dielectric space 18.

In this manner, in the electrode unit 81 according to the embodiment 3, the dielectric film F2 serves as a protection target dielectric film in the dielectric film F2 and the dielectric film F3, and the dielectric protection film FC2 is provided to the dielectric film F2 as the protection target dielectric film on a side of the dielectric space 18.

A constituent material of the dielectric protection film FC2 has protection properties that irradiation of the dielectric film F2 as the protection target dielectric film with ions generated by dielectric barrier discharge is blocked in generation of the dielectric barrier discharge in the discharge space 4 and chemical reaction with the ions does not occur.

Considered as the constituent material of the dielectric protection film FC2 is silicon carbide having semi-insulating properties, for example. Herein, the semi-insulating properties indicates that insulating resistance equal to or larger than 1×10⁵Ω cm and dielectric strength equal to or larger than 1kV/mm are satisfied.

The dielectric protection film FC2 has the semi-insulating properties described above, thus can contribute to dielectric barrier discharge generated in the discharge space 4. The same applies to dielectric protection films FC3 to FC5 in an embodiment 4 to an embodiment 8 described hereinafter.

The electrode unit 81 further includes the alternating-current power source 15 applying alternating current voltage as applied voltage between the high voltage electrode F5 of the high voltage side electrode constituting part E11 and the ground electrode F6 of the ground side electrode constituting part E20. Specifically, the alternating current voltage is applied to the high voltage electrode F5, and the ground electrode F6 is set to have ground potential as reference potential.

Dielectric barrier discharge is generated in the discharge space 4 in application of the applied voltage from the alternating-current power source 15 in the electrode unit 81 as the basic aspect according to the embodiment 3.

A supply form of supplying the material gas G1 to the discharge space 4 and an ejection form of ejecting the active gas G2 are not particularly limited in the electrode unit 81 of the basic aspect illustrated in Fig. 42. For example, it is also applicable that the material gas G1 is supplied from a left side and the active gas G2 is ejected from a right side in Fig. 42.

In the active gas generation apparatus according to the embodiment 3 including the electrode unit 81 as the basic aspect, the dielectric protection film FC2 as the dielectric protection member having the above protection properties is located between the dielectric space 18 including the discharge space 4 and the dielectric film F2 as the protection target dielectric film. Thus, the dielectric film reaction phenomenon that the dielectric film F2 is reacted with the ions in generation of the dielectric barrier discharge in the discharge space 4 can be suppressed.

As a result, the active gas generation apparatus as the basic aspect of the embodiment 3 reliably prevents mixture of atoms of the dielectric film F2 corresponding to the dielectric film reaction phenomenon, for example, into the discharge space 4, thus can generate active gas G2 of high purity.

In addition, the electrode unit 81 can be made only by adding the dielectric protection film FC2 without changing original constituent materials of the dielectric films F2 and F3, thus the manufacturing process of the electrode unit 81 is not complicated.

In the active gas generation apparatus of the basic aspect according to the embodiment 3, the dielectric protection film FC2 is provided to be firmly attached to the lower surface of the dielectric film F2 as the protection target dielectric film without a gap, thus the active gas G2 can be accurately obtained without occurrence of a space other than the discharge space 4 where a discharge phenomenon occurs between the dielectric film F2 and the dielectric film F3.

The high voltage side electrode constituting part E11 in the electrode unit 81 includes the dielectric protection film FC2. The active gas generation apparatus of the basic aspect according to the embodiment 3 including this electrode unit 81 applies the alternating current voltage as the applied voltage between the high voltage electrode F5 and the ground electrode F6 from the alternating-current power source 15, thus can activate the material gas G1 supplied to the discharge space 4 in the dielectric space 18 to generate the active gas G2.

### (Second aspect)

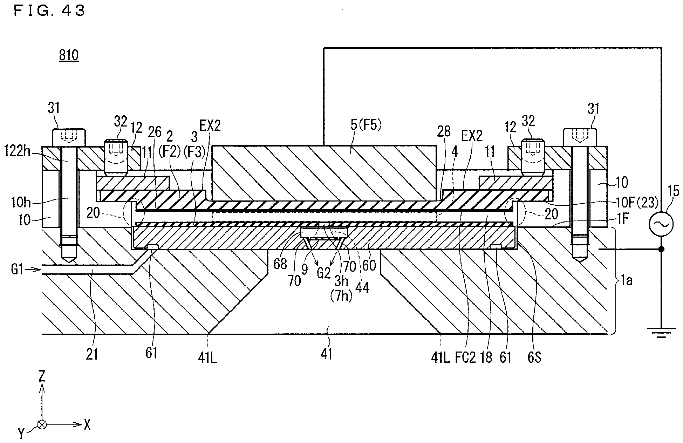

Fig. 43 is an explanation diagram illustrating an electrode unit 810 used for an active gas generation apparatus of a second aspect according to the embodiment 3. An XYZ rectangular coordinate system is illustrated in Fig. 43.

The electrode unit 810 illustrated in Fig. 43 has a conceptual structure that the electrode unit 81 of the basic aspect illustrated in Fig. 42 is applied to the electrode unit 55 according to the embodiment 2. In the electrode unit 810, the high voltage side dielectric film 2 is used as the dielectric film F2, the ground side dielectric film 3 is used as the dielectric film F3, and the power supply body 5 is used as the high voltage electrode F5. A conductive film 7 (Fig. 20 and Fig. 21) not shown in Fig. 43 is used as the ground electrode F6.

As illustrated in Fig. 43, the dielectric protection film FC2 is provided to be firmly attached to a lower surface of the high voltage side dielectric film 2 in the electrode unit 810 indicating the concept of the second aspect. Any method is applicable as a method of forming the dielectric protection film FC2 in the electrode unit 810. An actual usage structure of the electrode unit 810 is achieved in an electrode unit 811 described hereinafter.

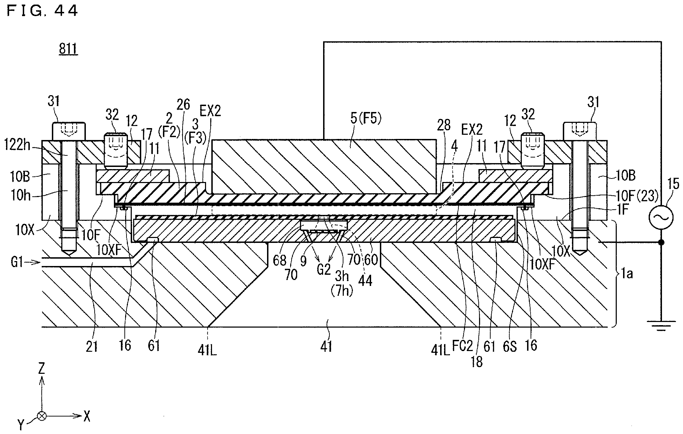

Fig. 44 is an explanation diagram illustrating a cross-section structure of the electrode unit 811 used for an active gas generation apparatus of the second aspect according to the embodiment 3. An XYZ rectangular coordinate system is illustrated in Fig. 44.

The electrode unit 811 illustrated in Fig. 44 has an actual usage structure that the electrode unit 81 of the basic aspect illustrated in Fig. 42 is applied to the electrode unit 55 according to the embodiment 2. In the electrode unit 811, the high voltage side dielectric film 2 is used as the dielectric film F2, the ground side dielectric film 3 is used as the dielectric film F3, and the power supply body 5 is used as the high voltage electrode F5. The conductive film 7 (Fig. 20 and Fig. 21) not shown in Fig. 44 is used as the ground electrode F6.

In this manner, the active gas generation apparatus having the actual usage structure of the second aspect according to the embodiment 3 serves as the active gas generation apparatus including the electrode unit 811.

A whole configuration of the active gas generation apparatus of the second aspect according to the embodiment 3 is similar to that of the active gas generation apparatus 71 illustrated in Fig. 1. Accordingly, the electrode unit 811 illustrated in Fig. 44 corresponds to any of the whole configuration of the electrode units 51 to 53 in the active gas generation apparatus 75 illustrated in Fig. 1.

That is to say, the second aspect of the active gas generation apparatus according to the embodiment 3 includes the electrode units 51 to 53 as the plurality of electrode units and the chassis 1 housing the electrode units 51 to 53 in the chassis space S1 (refer to Fig. 8) and having conductivity in the manner similar to the active gas generation apparatus 71 according to the embodiment 1.

The same sign is assigned to the structure similar to those in the electrode unit 50 (51 to 53) according to the embodiment 1 or those in the electrode unit 55 according to the embodiment 2, and the description is appropriately omitted. Characterizing portions of the electrode unit 811 are mainly described hereinafter.

As illustrated in Fig. 44, the electrode unit 811 includes the concave part bottom surface 26 in the lower surface of the high voltage side dielectric film 2 and the convex part bottom surface 23 provided around the concave part bottom surface in the manner similar to the electrode unit 50 (51 to 53) according to the embodiment 1. A formation position of the convex part bottom surface 23 is set higher than that of the concave part bottom surface 26 in a height direction along the +Z direction. The dielectric protection film FC2 is provided on the concave part bottom surface 26, and is not provided on the convex part bottom surface 23.

The electrode unit 811 includes a dielectric film support member 10B having a support surface 10F as a dielectric support surface supporting the convex part bottom surface 23 of the high voltage side dielectric film 2 from a lower side.

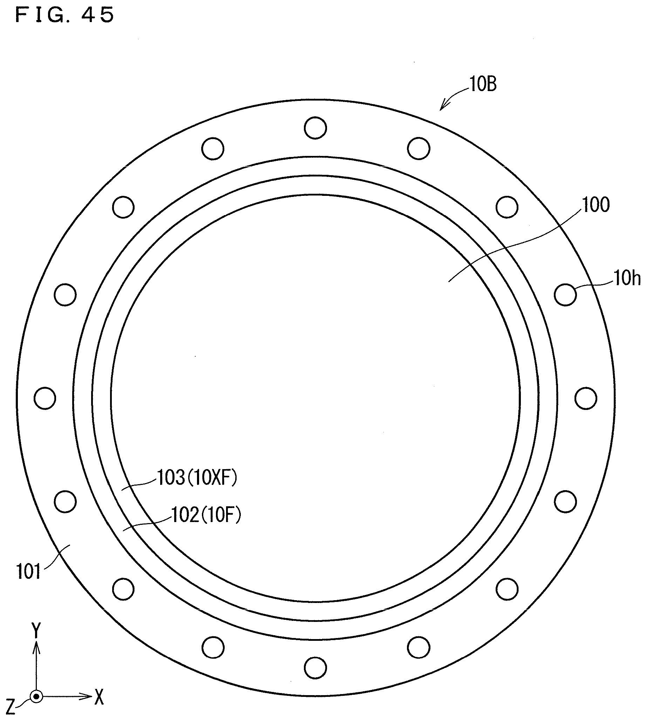

Fig. 45 is an explanation diagram schematically illustrating a planar structure of the dielectric film support member 10B. An XYZ rectangular coordinate system is illustrated in Fig. 45. Illustrations of a groove part 16 and an O ring 17 described hereinafter are omitted in Fig. 45.

As illustrated in Fig. 45, the dielectric film support member 10B has a circular shape having a center opening part 100 in a center thereof in a plan view. A level difference structure made up of a level difference part 103, a level difference part 102, and a surrounding part upper surface 101 is annularly provided around the center opening part 100. An upper surface of the level difference part 103 serves as a fixing auxiliary surface 10XF, and an upper surface of the level difference part 102 serves as the support surface 10F. The level difference part 102 (support surface 10F) is located on a side of an outer periphery of the level difference part 103 (10XF), and the plurality of through ports 10h are dispersedly disposed to have a circular shape in the surrounding part upper surface 101 on a side of an outer periphery of the level difference part 102.

The fixing auxiliary surface 10XF is annularly provided along an outer periphery of the center opening part 100, and the support surface 10F is annularly provided along an outer periphery of the fixing auxiliary surface 10XF.

In the meanwhile, as described in the embodiment 1 with reference to Fig. 9 and Fig. 10, the high voltage side dielectric film 2 includes the circular concave part bottom surface 26 in a plan view, and a bottom surface around the concave part bottom surface 26 serves as the annular convex part bottom surface 23 in a plan view.

As illustrated in Fig. 44 and Fig. 45, the dielectric film support member 10B further includes the fixing auxiliary surface 10XF as a protection member fixing auxiliary surface disposed on a lower side of a surrounding region of the dielectric protection film FC2 provided on the concave part bottom surface 26 of the high voltage side dielectric film 2.

In the manner similar to the electrode units 50 and 55, the electrode unit 811 includes the dielectric film suppression member 11 suppressing the high voltage side dielectric film 2 as the first electrode dielectric film from an upper side, and the dielectric film suppression member 11 is not overlapped with the power supply body 5 in a plan view.

In the dielectric film support member 10B, the O ring 17 functioning as an elastic member is inserted between the fixing auxiliary surface 10XF as the protection member fixing auxiliary surface and the lower surface of the dielectric protection film FC2. The concave part bottom surface 26 of the high voltage side dielectric film 2 and the upper surface of the dielectric protection film FC2 are set to be firmly attached each other by elastic force of the O ring 17. This point is described in detail hereinafter.

The dielectric film support member 10B includes the groove part 16 annularly provided in the fixing auxiliary surface 10XF in a plan view. Then, the annular O ring 17 is provided in the groove part 16 in a plan view. In this manner, the electrode unit 811 includes the dielectric film support member 10B having the groove part 16 and the O ring 17.

The O ring 17 provided in the groove part 16 is normally used as a sealing material sealing a fluid such as gas. The O ring 17 is used as an elastic member in the electrode unit 811. Specifically, elastic force generated when the O ring 17 is deformed is used.

In Fig. 44, the O ring 17 is sandwiched between the dielectric film support member 10B and the high voltage side dielectric film 2 via the dielectric protection film FC2, thereby being deformed. The upper surface of the dielectric protection film FC2 is firmly attached to the lower surface of the high voltage side dielectric film 2 by the elastic force of the O ring 17 functioning as the elastic member.

The electrode unit 811 used in the second aspect according to the embodiment 3 reliably prevents mixture of atoms of the dielectric film F2 corresponding to the dielectric film reaction phenomenon, for example, into the discharge space 4, in the manner similar to the basic aspect, thus can generate active gas G2 of high purity.

In addition, original constituent materials of the high voltage side dielectric film 2 and the ground side dielectric film 3 need not be changed in the electrode unit 811, and main changes from the electrode unit 55 are improvement from the dielectric film support member 10 to the dielectric film support member 10B and addition of the dielectric protection film FC2, for example. Thus, a manufacturing method of the electrode unit 811 is not complicated.

For example, considered is a case of using constituent materials having the protection properties described above as the constituent materials of the high voltage side dielectric film 2 without providing the dielectric protection film FC2 in the structure of the electrode unit 55. Herein, the high voltage side dielectric film 2 using the constituent materials having the protection properties described above is referred to as "a high voltage side dielectric film 2X". The high voltage side dielectric film 2X has a relatively complex structure including the power supply body arrangement concave part 28, the convex part bottom surface 23, and the concave part bottom surface 26, thus when workability of the constituent materials having the protection properties described above is poor, a processing treatment for obtaining the high voltage side dielectric film 2X is a relatively complex processing treatment.

In the meanwhile, the dielectric protection film FC2 in the electrode unit 811 has a relatively simple planar structure, and added is only a relatively simple manufacturing process of locating the dielectric protection film FC2 on the fixing auxiliary surface 10XF of the dielectric film support member 10B via the O ring 17. Accordingly, the manufacturing process of the electrode unit 811 is not complicated.

The dielectric protection film FC2 is provided on the lower surface of the high voltage side dielectric film 2 where no through port is provided in the electrode unit 811, thus the dielectric protection film FC2 can completely protect the high voltage side dielectric film 2 from the dielectric barrier discharge in the discharge space 4.

The second aspect of the active gas generation apparatus according to the embodiment 3 including such an electrode unit 811 has an effect similar to the basic aspect of the active gas generation apparatus including the electrode unit 81 and further has a specific effect described hereinafter.

In the second aspect of the active gas generation apparatus according to the embodiment 3, the dielectric film support member 10B of the electrode unit 811 supports the convex part bottom surface 23 of the ground side dielectric film 3 from a lower side on the support surface 10F as the dielectric support surface. Furthermore, the concave part bottom surface 26 of the high voltage side dielectric film 2 and the upper surface of the dielectric protection film FC2 are set to be firmly attached each other by the elastic force of the O ring 17 functioning as the elastic member.

Accordingly, the second aspect of the active gas generation apparatus according to the embodiment 3 can stably fix the dielectric protection film FC2 firmly attached to the high voltage side dielectric film 2 with the relatively simple structure of providing the dielectric film support member 10B and the O ring 17.

In addition, the second aspect of the active gas generation apparatus according to the embodiment 3 can achieve improvement of an adhesion accuracy between the concave part bottom surface 26 of the high voltage side dielectric film 2 and the upper surface of the dielectric protection film FC2 with a relatively simple structure using the elastic force of the O ring 17.

Furthermore, in the second aspect of the active gas generation apparatus according to the embodiment 3 including the electrode unit 811 illustrated in Fig. 44 and Fig. 45, the plurality of gas ejection ports 70 have a feature similar to the electrode unit 55 according to the embodiment 2. That is to say, the plurality of gas ejection ports 70 are provided in the form of being close to each other toward the lower side so that the plural pieces of partial active gas collide with each other in the collision region 80, and the collision region 80 is located in the lower side tapered region 41t (refer to Fig. 36 and Fig. 37) or on the upper side of the lower side tapered region 41t.

Thus, the second aspect of the active gas generation apparatus according to the embodiment 3 can uniformly supply the material gas G2 to the processing space in the subsequent stage in the manner similar to the active gas generation apparatus according to the embodiment 2.

The electrode unit 811 using the O ring 17 is described as the example of the actual usage structure of achieving the electrode unit 810 in the embodiment 3, however, the electrode unit 810 may be achieved by the other structure. For example, first and second modification examples described hereinafter are considered.

Considered as the first modification example is a structure of firmly attaching the fixing auxiliary surface 10XF of the dielectric film support member 10B to the dielectric protection film FC2 with a general spring in place of the O ring 17 between the fixing auxiliary surface 10XF and the dielectric protection film FC2.

Considered as the second modification example is a structure of providing a magnetic thin film region made by a magnetic body such as iron as constituent materials on an end portion of the dielectric protection film FC2, and attracting the magnetic thin film region by magnetic force of a magnet provided on an upper side of the magnetic thin film region of the dielectric protection film FC2 to hold the dielectric protection film FC2. The magnetic thin film region can be formed using a sputtering method, for example. Considered is an aspect that a magnet is provided in an overlapping region in the dielectric film suppression member 11 or the press member 12 in the electrode unit 811 illustrated in Fig. 44 where the dielectric film suppression member 11 or the press member 12 is overlapped with the fixing auxiliary surface 10XF in a plan view to achieve the second modification example.

The magnetic thin film region may be provided to any of sides facing or not facing the discharge space 4, but is preferably provided to a position where ions or electrons generated in the dielectric barrier discharge do not collide.

### <Embodiment 4>

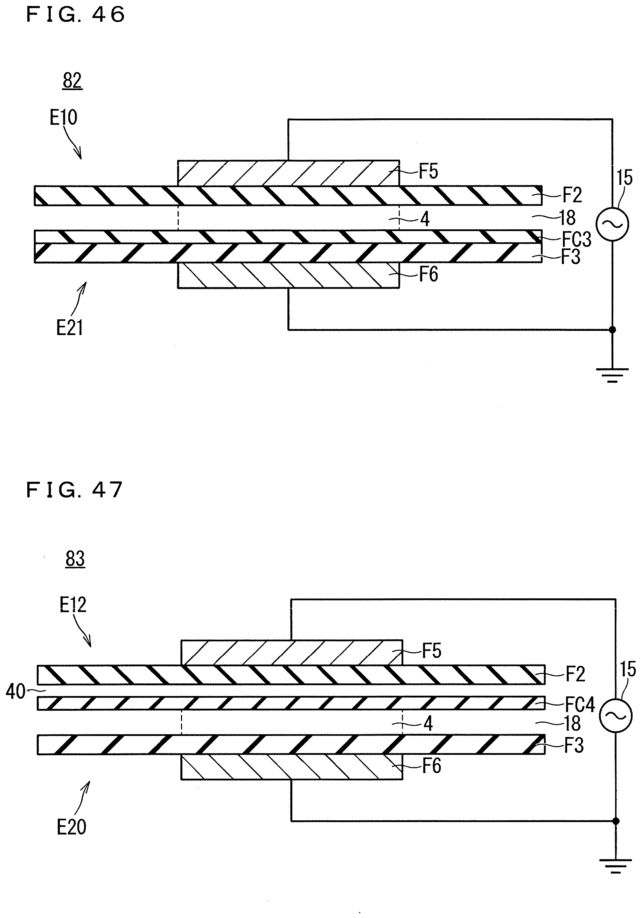

Fig. 46 is an explanation diagram schematically illustrating a basic aspect of an electrode unit 82 used for an active gas generation apparatus according to an embodiment 4. The active gas generation apparatus according to the embodiment 4 includes the electrode unit 82 activating the material gas G1 supplied to the discharge space 4 to generate active gas G2.

As illustrated in Fig. 46, the electrode unit 82 includes a high voltage side electrode constituting part E10 as a first electrode constituting part and a ground side electrode constituting part E21 as a second electrode constituting part provided on a lower side of the high voltage side electrode constituting part E10.

The high voltage side electrode constituting part E10 as the first electrode constituting part includes the dielectric film F2 as the first electrode dielectric film and the high voltage electrode F5 as the first electrode conductive film provided on the upper surface of the dielectric film F2.

The ground side electrode constituting part E21 as the second electrode constituting part includes the dielectric film F3 as the second electrode dielectric film and the ground electrode F6 as the second electrode conductive film provided on the lower surface of the dielectric film F3.

The electrode unit 82 according to the embodiment 4 has a feature that the dielectric protection film FC3 as the dielectric protection member is provided to be firmly attached to the upper surface of the dielectric film F3 without a gap. That is to say, the ground side electrode constituting part E21 in the electrode unit 82 according to the embodiment 4 includes the dielectric film F3, the ground electrode F6, and the dielectric protection film FC3.

The dielectric space 18 is provided between the dielectric film F2 and the dielectric film F3 via the dielectric protection film FC3. Specifically, in the electrode unit 82, the dielectric protection film FC3 is provided to be firmly attached to the upper surface of the dielectric film F3, and a space where the dielectric film F2 and the dielectric protection film FC3 face each other serves as the dielectric space 18. Formed in this dielectric space 18 is the discharge space 4 including the main discharge space as the region where the high voltage electrode F5 and the ground electrode F6 are overlapped with each other in a plan view.

In this manner, in the electrode unit 82 according to the embodiment 4, the dielectric film F3 serves as the protection target dielectric film in the dielectric film F2 and the dielectric film F3, and the dielectric protection film FC3 is provided to the dielectric film F3 as the protection target dielectric film on the side of the dielectric space 18.

A constituting material of the dielectric protection film FC3 has protection properties that irradiation of the dielectric film F3 as the protection target dielectric film with ions generated by dielectric barrier discharge is blocked in generation of the dielectric barrier discharge in the discharge space 4 and chemical reaction with the ions does not occur in the manner similar to the dielectric protection film FC2.

The electrode unit 82 further includes the alternating-current power source 15 applying alternating current voltage as applied voltage between the high voltage electrode F5 of the high voltage side electrode constituting part E10 and the ground electrode F6 of the ground side electrode constituting part E21. Specifically, the alternating current voltage is applied to the high voltage electrode F5, and the ground electrode F6 is set to have ground potential as reference potential.

Dielectric barrier discharge is generated in the discharge space 4 in application of the applied voltage from the alternating-current power source 15 in the electrode unit 82 as the basic aspect according to the embodiment 4.

A supply form of supplying the material gas G1 to the discharge space 4 and an ejection form of ejecting the active gas G2 are not particularly limited in the electrode unit 82 of the basic aspect illustrated in Fig. 46. For example, it is also applicable that the material gas G1 is supplied from a left side and the active gas G2 is ejected from a right side in Fig. 46.

In the active gas generation apparatus according to the embodiment 4 including the electrode unit 82, the dielectric protection film FC3 as the dielectric protection member having the above protection properties is located between the dielectric space 18 including the discharge space 4 and the dielectric film F3 as the protection target dielectric film. Thus, the dielectric film reaction phenomenon that the dielectric film F3 is reacted with the ions in generation of the dielectric barrier discharge in the discharge space 4 can be suppressed.

As a result, the active gas generation apparatus as the basic aspect of the embodiment 4 reliably prevents mixture of atoms of the dielectric film F3 corresponding to the dielectric film reaction phenomenon, for example, into the discharge space 4, thus can generate active gas G2 of high purity.

In addition, the electrode unit 82 can be made only by adding the dielectric protection film FC3 without changing original constituting materials of the dielectric films F2 and F3, thus the manufacturing process of the electrode unit 82 is not complicated.

In the active gas generation apparatus of the basic aspect according to the embodiment 4, the dielectric protection film FC3 is provided to be firmly attached on the upper surface of the dielectric film F3 as the protection target dielectric film without a gap, thus the active gas G2 can be accurately obtained without occurrence of a space other than the discharge space 4 where a discharge phenomenon occurs between the dielectric film F2 and the dielectric film F3.

The ground side electrode constituting part E21 in the electrode unit 82 includes the dielectric protection film FC3. The active gas generation apparatus according to the embodiment 4 including this electrode unit 82 applies the applied voltage between the high voltage electrode F5 and the ground electrode F6, thus can activate the material gas G1 supplied to the discharge space 4 in the dielectric space 18 to generate the active gas G2.

The dielectric protection member typified by the dielectric protection film FC3 can have the above effect as long as the dielectric protection member is provided on the side of the dielectric space 18 with respect to the protection target dielectric film as at least one of the dielectric film F2 and the dielectric film F3.

Accordingly, it is also applicable that the electrode unit 82 is extended and the dielectric protection film FC2 is further provided on the lower surface of the dielectric film F2. In the similar manner, it is also applicable that the electrode unit 81 according to the embodiment 3 is extended and the dielectric protection film FC3 is further provided on the upper surface of the dielectric film F3.

### <Embodiment 5>

### (Basic aspect)

Fig. 47 is an explanation diagram schematically illustrating a basic aspect of an electrode unit 83 used for an active gas generation apparatus according to an embodiment 5. The active gas generation apparatus according to the embodiment 5 includes the electrode unit 83 activating the material gas G1 supplied to the discharge space 4 to generate active gas G2.

The same sign is assigned to the structure similar to those in the electrode unit 81 according to the embodiment 3, and the description is appropriately omitted. Characterizing portions of the electrode unit 83 are mainly described hereinafter.

As illustrated in Fig. 47, the electrode unit 83 includes a high voltage side electrode constituting part E12 as a first electrode constituting part and a ground side electrode constituting part E20 as a second electrode constituting part provided on a lower side of the high voltage side electrode constituting part E12.

The high voltage side electrode constituting part E12 as the first electrode constituting part includes the dielectric film F2 as the first electrode dielectric film and the high voltage electrode F5 as the first electrode conductive film provided on the upper surface of the dielectric film F2.

The ground side electrode constituting part E20 as the second electrode constituting part includes the dielectric film F3 as the second electrode dielectric film and the ground electrode F6 as the second electrode conductive film provided on the lower surface of the dielectric film F3.

The electrode unit 83 according to the embodiment 5 has a feature that it has a structure of providing a dielectric protection film FC4 as a dielectric protection member via a protection member space 40 on the lower side of the dielectric film F2 as the first electrode dielectric film.

In this manner, the high voltage side electrode constituting part E12 in the electrode unit 83 according to the embodiment 5 includes the dielectric film F2, the high voltage electrode F5, and the dielectric protection film FC4, and the dielectric protection film FC4 is provided to have the protection member space 40 as a minute gap between the dielectric protection film FC4 and the dielectric film F2 as the protection target dielectric film.

The dielectric space 18 is provided between the dielectric film F2 and the dielectric film F3 via the dielectric protection film FC4. Specifically, a space where the dielectric protection film FC4 and the dielectric film F3 face each other serves as the dielectric space 18. Formed in this dielectric space 18 is the discharge space 4 including the main discharge space as the region where the high voltage electrode F5 and the ground electrode F6 are overlapped with each other in a plan view.

In this manner, in the electrode unit 83 according to the embodiment 5, the dielectric film F2 serves as the protection target dielectric film in the dielectric film F2 and the dielectric film F3, and the dielectric protection film FC4 is provided to the dielectric film F2 as the protection target dielectric film on the side of the dielectric space 18.

A constituting material of the dielectric protection film FC4 has protection properties that irradiation of the dielectric film F2 as the protection target dielectric film with ions generated by dielectric barrier discharge is blocked in generation of the dielectric barrier discharge in the discharge space 4 and chemical reaction with the ions does not occur in the manner similar to the dielectric protection film FC2 according to the embodiment 3 and the dielectric protection film FC3 according to the embodiment 4.

Dielectric barrier discharge is generated in the discharge space 4 in application of the applied voltage from the alternating-current power source 15 in the electrode unit 83 as the basic aspect according to the embodiment 5.

At this time, the applied voltage, the discharge space 4, and the protection member space 40 are set to satisfy discharge occurrence requirements that the dielectric barrier discharge is generated in the discharge space 4, and the dielectric barrier discharge is not generated in the protection member space 40, in application of the applied voltage. The discharge occurrence requirements are described hereinafter.

Generally, in the dielectric barrier discharge, voltage necessary to generate the discharge has a characteristic that it needs to be high with increasing discharge distance (gap length) when pressure and a type of gas are constant. This characteristic is referred to as Paschen's Law.

For example, in nitrogen gas with pressure of 400 Torr, discharge start voltage is substantially 2900 V when the discharge distance is 1 mm in accordance with Paschen's Law, and the discharge start voltage is substantially 6600 V when the discharge distance is 2.5. In the meanwhile, electrical field strength at which the discharge is started is 2900 V/mm in the former case, and is 2640 V/mm in the latter case. The electrical field strength necessary for discharge gets smaller as the discharge distance increases.

The dielectric barrier discharge adopted to the electrode unit 83 is referred to as a parallel plate type dielectric barrier discharge, and the electrical field strength applied to the protection member space 40 and the discharge space 4 has the same value. According to this feature, when the discharge distance (gap length) of the protection member space 40 is reduced, the discharge start electrical field strength is purposely increased, and a portion where the discharge is generated can be selectively set to only the discharge space 4.

Herein, applied voltage VP is applied voltage applied from the alternating-current power source 15, a gap length Δ4 is a gap length of the discharge space 4, and a gap length Δ40 is a gap length of the protection member space 40. Furthermore, a discharge start electrical field strength E4 is electrical field strength necessary for start of generation of the dielectric barrier discharge in the discharge space 4, a discharge start electrical field strength E40 is electrical field strength necessary for start of generation of the dielectric barrier discharge in the discharge space 40, and electrical field strength EX is electrical field strength having the same value in the discharge space 4 and the protection member space 40 in common.

In this case, {EX < E40} and {EX ≥ E4} are discharge occurrence requirements between the electrical field strength EX, the discharge start electrical field strength E4, and the discharge start electrical field strength E40. When these discharge occurrence requirements are satisfied, the dielectric barrier discharge is generated in the discharge space 4, and is not generated in the protection member space 40.

The gap length Δ40 is set to be sufficiently smaller than the gap length Δ4, thus the discharge occurrence requirement can be set to {E40 >> E4}. Accordingly, the applied voltage VP, the gap length Δ4, and the gap length Δ40 satisfying the above discharge occurrence requirements ({EX < E40} and {EX ≥ E4}) can be set relatively easily.

A supply form of supplying the material gas G1 to the discharge space 4 and an ejection form of ejecting the active gas G2 are not particularly limited in the electrode unit 83 of the basic aspect illustrated in Fig. 47. For example, it is also applicable that the material gas G1 is supplied from a left side and the active gas G2 is ejected from a right side in Fig. 47.

In the active gas generation apparatus according to the embodiment 5 including the electrode unit 83 as the basic aspect, the dielectric protection film FC4 as the dielectric protection member having the above protection properties is located between the dielectric space 18 including the discharge space 4 and the dielectric film F2 as the protection target dielectric film. Thus, the dielectric film reaction phenomenon that the dielectric film F2 is reacted with the ions in generation of the dielectric barrier discharge in the discharge space 4 can be suppressed.

As a result, the active gas generation apparatus as the basic aspect of the embodiment 5 reliably prevents mixture of atoms of the dielectric film F2 corresponding to the dielectric film reaction phenomenon, for example, into the discharge space 4, thus can generate active gas G2 of high purity.

In addition, the electrode unit 83 can be made only by adding the dielectric protection film FC4 without changing original constituting materials of the dielectric films F2 and F3, thus the manufacturing process of the electrode unit 83 is not complicated.

In the basic aspect of the active gas generation apparatus according to the embodiment 5, the dielectric protection film FC4 as the dielectric protection member includes the protection member space 40 between the dielectric protection film FC4 and the dielectric film F2 as the protection target dielectric film. The dielectric protection film FC4 and the dielectric film F2 need not be firmly attached to each other, thus the apparatus configuration can be simplified.

The gap length Δ40 of the protection member space 40 is set to be sufficiently smaller than the gap length Δ4 of the discharge space 4, thus the applied voltage, the discharge space 4, and the protection member space 40 satisfying the above discharge occurrence requirements can be set relatively easily.

As a result, the active gas generation apparatus according to the embodiment 5 can accurately obtain the active gas G2 between the dielectric film F2 and the dielectric film F3 without a space where the discharge phenomenon occurs other than the discharge space 4.

The high voltage side electrode constituting part E12 of the electrode unit 83 includes the dielectric protection film FC4, and in the electrode unit 83, the applied voltage applied between the dielectric films F2 and F3 satisfies the above discharge occurrence requirements. Thus, the active gas generation apparatus according to the embodiment 5 including the electrode unit 83 can generate the dielectric barrier discharge in the discharge space 4 including the main discharge space formed between the dielectric protection film FC4 and the dielectric film F3 without generating the dielectric barrier discharge in the protection member space 40 formed between the dielectric film F2 and the dielectric protection film FC4.

As a result, the active gas generation apparatus according to the embodiment 5 can activate the material gas G1 supplied to the discharge space 4 to generate the active gas G2.

### (Second aspect)

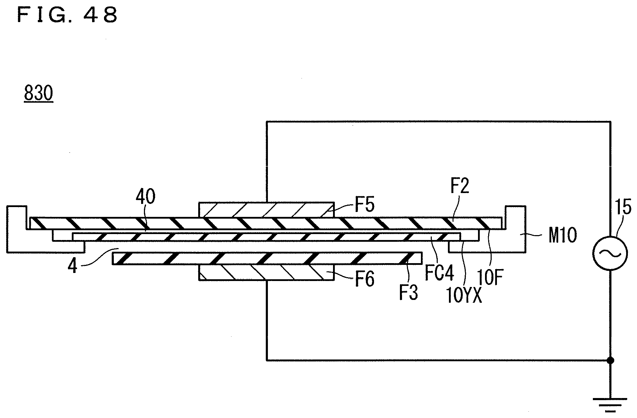

Fig. 48 is an explanation diagram schematically illustrating a concept of an electrode unit 830 used for an active gas generation apparatus of a second aspect according to the embodiment 5. An XYZ rectangular coordinate system is illustrated in Fig. 48.

The electrode unit 830 has a feature part of a conceptual structure that the electrode unit 83 of the basic aspect illustrated in Fig. 47 is applied to the electrode unit 55 according to the embodiment 2.

As illustrated in Fig. 48, the dielectric protection film FC4 is provided via the protection member space 40 as a minute gap on the side of the lower surface of the high voltage side dielectric film 2 in the electrode unit 830 indicating the feature part of the concept of the second aspect.

The electrode unit 830 includes a dielectric film support member M10 including the support surface 10F as the dielectric support surface supporting the surrounding region of the dielectric film F2 from the lower side and a support surface 10YF as a protection member support surface supporting the surrounding region of the dielectric protection film FC4 from the lower side.

An actual usage structure of the electrode unit 830 illustrated in Fig. 48 is achieved in an electrode unit 831 described hereinafter.

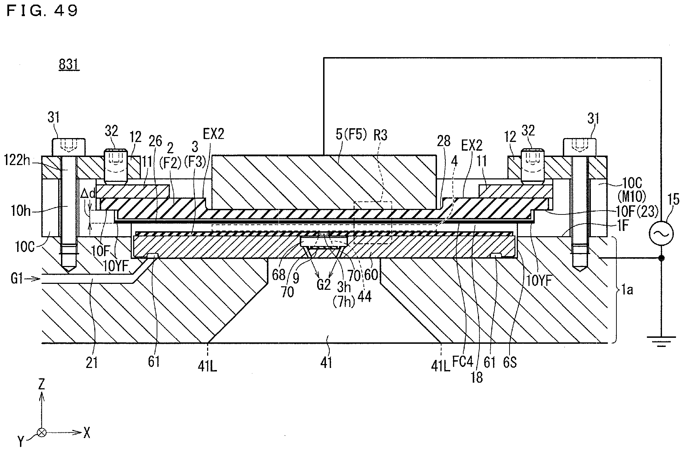

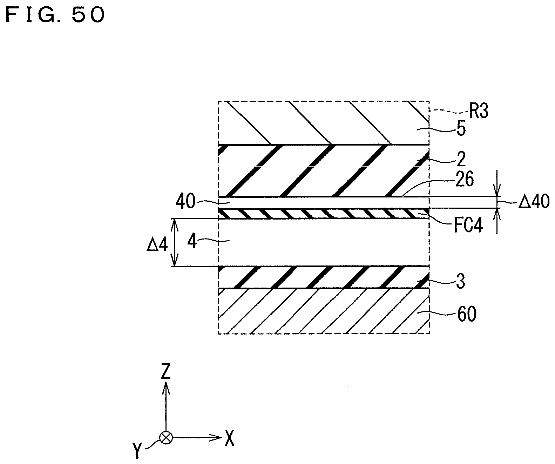

Fig. 49 is an explanation diagram illustrating a cross-section structure of the electrode unit 831 used for an active gas generation apparatus of the second aspect according to the embodiment 5. Fig. 50 is an explanation diagram schematically illustrating a detailed structure of a focus region R3 in Fig. 49. An XYZ rectangular coordinate system is illustrated in each of Fig. 49 and Fig. 50.

The electrode unit 831 illustrated in Fig. 49 has an actual usage structure that the electrode unit 83 of the basic aspect illustrated in Fig. 47 is applied to the electrode unit 55 according to the embodiment 2. In the electrode unit 831, the high voltage side dielectric film 2 is used as the dielectric film F2, the ground side dielectric film 3 is used as the dielectric film F3, the power supply body 5 is used as the high voltage electrode F5, and a dielectric film support member 10C is used as the dielectric film support member M10. The conductive film 7 (Fig. 20 and Fig. 21) not shown in Fig. 49 is used as the ground electrode F6.

In this manner, the active gas generation apparatus of the second aspect according to the embodiment 5 serves as the active gas generation apparatus including the electrode unit 831.

A whole configuration of the active gas generation apparatus of the second aspect according to the embodiment 5 is similar to that of the active gas generation apparatus 71 illustrated in Fig. 1. Accordingly, the electrode unit 831 illustrated in Fig. 49 corresponds to any of the whole configuration of the electrode units 51 to 53 in the active gas generation apparatus 75 illustrated in Fig. 1.

That is to say, the second aspect of the active gas generation apparatus according to the embodiment 5 includes the electrode units 51 to 53 as the plurality of electrode units and the chassis 1 housing the electrode units 51 to 53 in the chassis space S1 (refer to Fig. 8) and having conductivity in the manner similar to the active gas generation apparatus 71 according to the embodiment 1.

The same sign is assigned to the structure similar to those in the electrode unit 50 (51 to 53) according to the embodiment 1 or those in the electrode unit 55 according to the embodiment 2, and the description is appropriately omitted. Characterizing portions of the electrode unit 831 are mainly described hereinafter.

As illustrated in Fig. 49, the electrode unit 831 includes the concave part bottom surface 26 in the lower surface of the high voltage side dielectric film 2 and the convex part bottom surface 23 provided around the concave part bottom surface in the manner similar to the electrode unit 50 (51 to 53) according to the embodiment 1. A formation position of the convex part bottom surface 23 is set higher than that of the concave part bottom surface 26 in a height direction along the +Z direction. The dielectric protection film FC4 is provided on the lower side of the concave part bottom surface 26 via the protection member space 40 (refer to Fig. 50), and is not provided on the convex part bottom surface 23.

The dielectric protection film FC4 in the electrode unit 831 has a planar plate-like structure, and a planar surface shape of the dielectric protection film FC4 in an XY plane is set to a circular shape slightly larger than the concave part bottom surface 26 illustrated in Fig. 9 and Fig. 10.

Illustration of the conductive film 7 is omitted in Fig. 50. The ground side dielectric film 3 is provided on the ground conductor 60 via the conductive film 7 not shown in Fig. 50.

As illustrated in Fig. 50, the dielectric protection film FC4 is disposed on the side of the lower surface of the high voltage side dielectric film 2 via the protection member space 40 having a minute gap length Δ40. The discharge space 4 having the gap length Δ4 is located between the dielectric protection film FC4 and the ground side dielectric film 3. The power supply body 5 is provided on the upper surface of the high voltage side dielectric film 2, and the ground conductor 60 is provided on the side of the lower surface of the ground side dielectric film 3.

In the electrode unit 831, the gap length Δ40 as the discharge distance of the protection member space 40 is set to be sufficiently smaller than the gap length Δ4 as the discharge distance of the discharge space 4 to satisfy the discharge occurrence requirements described above.

The electrode unit 831 includes the dielectric film support member 10C having the support surface 10F as the dielectric support surface supporting the convex part bottom surface 23 of the high voltage side dielectric film 2 from the lower side.

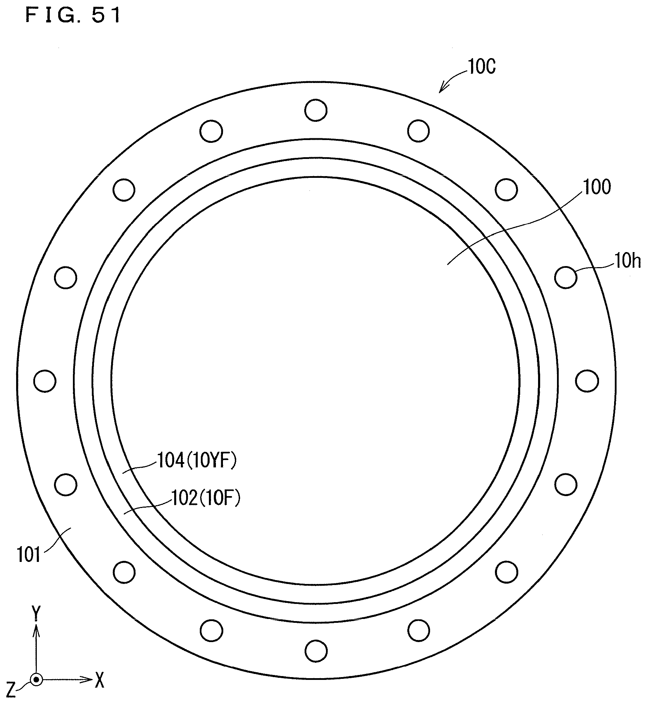

Fig. 51 is an explanation diagram schematically illustrating a planar structure of the dielectric film support member 10C. An XYZ rectangular coordinate system is illustrated in Fig. 51.

As illustrated in Fig. 51, the dielectric film support member 10C has a circular shape having a center opening part 100 in a center thereof in a plan view. A level difference structure made up of a level difference part 104, the level difference part 102, and surrounding part upper surface 101 is annularly provided around the center opening part 100. An upper surface of the level difference part 104 serves as the support surface 10YF, and the upper surface of the level difference part 102 serves as the support surface 10F. The level difference part 102 (support surface 10F) is located on a side of an outer periphery of the level difference part 104 (10YF), and the plurality of through ports 10h are dispersedly disposed to have a circular shape in the surrounding part upper surface 101 on the side of the outer periphery of the level difference part 102.

The support surface 10YF is annularly provided along the outer periphery of the center opening part 100, and the support surface 10F is annularly provided along an outer periphery of the support surface 10YF.

As illustrated in Fig. 49 and Fig. 51, the dielectric film support member 10C further includes the support surface 10YF as the protection member support surface supporting the surrounding region of the dielectric protection film FC4 from the lower side.

The support surface 10YF supports the surrounding region of the dielectric protection film FC4 from the lower side, thus a position of the dielectric protection film FC4 in a height direction along a Z direction can be fixed.

In addition, an inner diameter of the level difference part 102 is set to be slightly larger than a radius of the dielectric protection film FC4 having the circular planar shape, thus a movement of the dielectric protection film FC4 in an XY plane can be limited with high accuracy.

In the manner similar to the electrode units 50 and 55, the electrode unit 831 includes the dielectric film suppression member 11 suppressing the high voltage side dielectric film 2 as the first electrode dielectric film from the upper side, and the dielectric film suppression member 11 is not overlapped with the power supply body 5 in a plan view.

In the dielectric film support member 10C, the formation position of the support surface 10F as the dielectric support surface is higher than the support surface 10YF as the protection member support surface in a height direction, and a difference value Δd between the support surface 10F and the support surface 10YF in the height direction is set so that the protection member space 40 having the gap length Δ40 is formed between the lower surface of the high voltage side dielectric film 2 and the upper surface of the dielectric protection film FC4.

For example, when the dielectric protection film FC4 has a uniform film thickness dC4 and a length of the concave part bottom surface 26 from the convex part bottom surface 23 in a depth direction as a -Z direction is a protrusion length t26, the difference value Δd is set be a length satisfying {Δd = dC4+t26+Δ40}. At this time, the gap length Δ40 of the protection member space 40 needs to be set to be sufficiently smaller than the gap length Δ4 of the discharge space 4 to satisfy the discharge occurrence requirements described above. A film thickness of each of the dielectric protection films FC2 to FC5 including the dielectric protection film FC4 described above is set to be equal to or smaller than 1 mm.

The electrode unit 831 used in the second aspect according to the embodiment 5 reliably prevents mixture of atoms of the dielectric film F2 corresponding to the dielectric film reaction phenomenon, for example, into the discharge space 4, in the manner similar to the basic aspect, thus can generate active gas G2 of high purity.

In addition, original constituting materials of the high voltage side dielectric film 2 and the ground side dielectric film 3 need not be changed in the electrode unit 831, and main changes from the electrode unit 55 are improvement from the dielectric film support member 10 to the dielectric film support member 10C and addition of the dielectric protection film FC4, for example. Thus, a manufacturing method of the electrode unit 831 is not complicated in the manner similar to the manufacturing method of the electrode unit 811.

The dielectric protection film FC4 is provided on the lower surface of the high voltage side dielectric film 4 where no through port is provided in the electrode unit 831, thus the dielectric protection film FC4 can completely protect the high voltage side dielectric film 2 from the dielectric barrier discharge in the discharge space 4.

The second aspect of the active gas generation apparatus according to the embodiment 5 including such an electrode unit 831 has an effect similar to the basic aspect of the active gas generation apparatus including the electrode unit 83 and further has a specific effect described hereinafter.

In the electrode unit 831 in the active gas generation apparatus as the second aspect according to the embodiment 5, the dielectric film support member 10C supports the surrounding region of the high voltage side dielectric film 2 from the lower side on the support surface 10F as the dielectric support surface, and supports the surrounding region of the dielectric protection film FC4 from the lower side on the support surface 10YF as the protection member support surface.

Furthermore, in the electrode unit 831, the difference value Δd between the support surface 10F and the support surface 10YF is set so that the protection member space 40 having the gap length Δ40 is formed between the lower surface of the high voltage side dielectric film 2 and the upper surface of the dielectric protection film FC4.

Accordingly, the active gas generation apparatus as the second aspect according to the embodiment 5 can stably fix the dielectric protection film FC4 having the protection member space 40 with the high voltage side dielectric film 2.

Furthermore, the plurality of gas ejection ports 70 in the second aspect of the active gas generation apparatus according to the embodiment 5 including the electrode unit 831 illustrated in Fig. 49 to Fig. 51 have a feature similar to the electrode unit 55 according to the embodiment 2. That is to say, the plurality of gas ejection ports 70 are provided in the form of being close to each other toward the lower side so that the plural pieces of partial active gas collide with each other in the collision region 80, and the collision region 80 is located in the lower side tapered region 41t (refer to Fig. 36 and Fig. 37) or on the upper side of the lower side tapered region 41t.

As a result, the second aspect of the active gas generation apparatus according to the embodiment 5 can uniformly supply the material gas G2 to the processing space in the subsequent stage in the manner similar to the electrode unit 55 according to the embodiment 2 and the electrode unit 811 as the second aspect according to the embodiment 3.

The electrode unit 831 is described as the example of the actual usage structure of achieving the electrode unit 830 in the embodiment 5, however, the electrode unit 830 may be achieved by the other structure.

### <Embodiment 6>

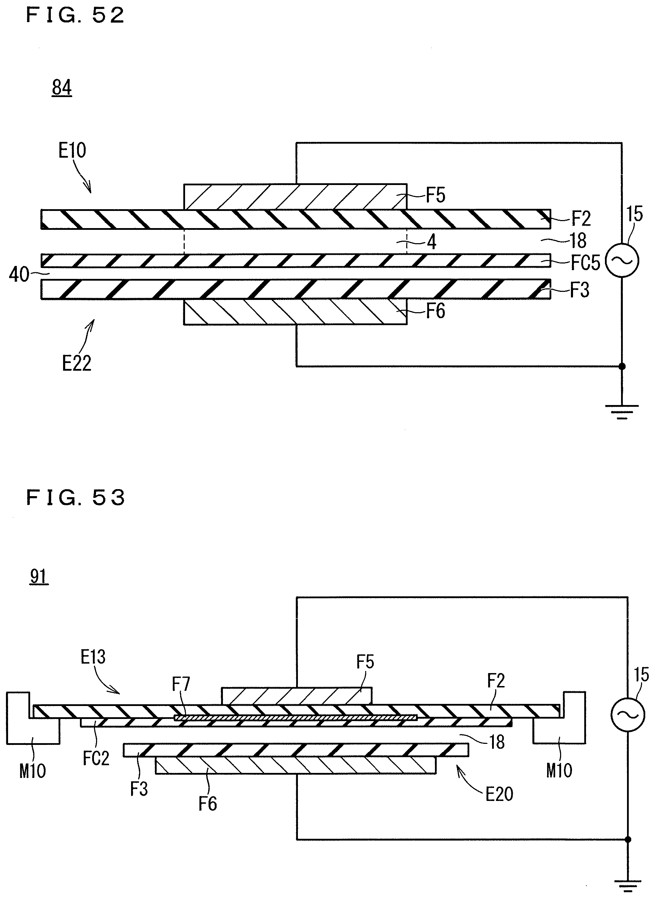

Fig. 52 is an explanation diagram schematically illustrating a basic aspect of an electrode unit 84 used for an active gas generation apparatus according to an embodiment 6. The active gas generation apparatus according to the embodiment 6 includes the electrode unit 84 activating the material gas G1 supplied to the discharge space 4 to generate active gas G2.

As illustrated in Fig. 52, the electrode unit 84 includes the high voltage side electrode constituting part E10 as the first electrode constituting part and a ground side electrode constituting part E22 as a second electrode constituting part provided on the lower side of the high voltage side electrode constituting part E10.

The high voltage side electrode constituting part E10 as the first electrode constituting part includes the dielectric film F2 as the first electrode dielectric film and the high voltage electrode F5 as the first electrode conductive film provided on the upper surface of the dielectric film F2.

The ground side electrode constituting part E22 as the second electrode constituting part includes the dielectric film F3 as the second electrode dielectric film and the ground electrode F6 as the second electrode conductive film provided on the lower surface of the dielectric film F3.

The electrode unit 84 according to the embodiment 6 has a feature that it has a structure of providing the dielectric protection film FC5 as a dielectric protection member via the protection member space 40 as the minute gap on the upper side of the dielectric film F3 as the second electrode dielectric film. That is to say, the ground side electrode constituting part E22 in the electrode unit 84 according to the embodiment 6 includes the dielectric film F3, the ground electrode F6, and the dielectric protection film FC5.

The dielectric space 18 is provided between the dielectric film F2 and the dielectric film F3 via the protection member space 40 and the dielectric protection film FC5. Specifically, a space where the dielectric protection film FC2 and the dielectric protection film FC5 face each other serves as the dielectric space 18. Formed in this dielectric space 18 is the discharge space 4 including the main discharge space as the region where the high voltage electrode F5 and the ground electrode F6 are overlapped with each other in a plan view.

In this manner, in the electrode unit 84 according to the embodiment 6, the dielectric film F3 serves as the protection target dielectric film in the dielectric film F2 and the dielectric film F3, and the dielectric protection film FC5 is provided to the dielectric film F3 as the protection target dielectric film on the side of the dielectric space 18.

A constituting material of the dielectric protection film FC5 has protection properties that irradiation of the dielectric film F3 as the protection target dielectric film with ions generated by dielectric barrier discharge is blocked in generation of the dielectric barrier discharge in the discharge space 4 and chemical reaction with the ions does not occur in the manner similar to the dielectric protection films FC2 to FC4.

The electrode unit 84 further includes the alternating-current power source 15 applying the alternating current voltage as the applied voltage between the high voltage electrode F5 of the high voltage side electrode constituting part E10 and the ground electrode F6 of the ground side electrode constituting part E22. Specifically, the alternating current voltage is applied to the high voltage electrode F5, and the ground electrode F6 is set to have ground potential as reference potential.

The dielectric barrier discharge is generated in the discharge space 4 in application of the applied voltage from the alternating-current power source 45 in the electrode unit 84 as the basic aspect according to the embodiment 6.

A supply form of supplying the material gas G1 to the discharge space 4 and an ejection form of ejecting the active gas G2 are not particularly limited in the electrode unit 84 of the basic aspect illustrated in Fig. 52. For example, it is also applicable that the material gas G1 is supplied from a left side and the active gas G2 is ejected from a right side in Fig. 52.

In the active gas generation apparatus according to the embodiment 6 including the electrode unit 84, the dielectric protection film FC5 as the dielectric protection member having the above protection properties is located between the dielectric space 18 including the discharge space 4 and the dielectric film F3 as the protection target dielectric film. Thus, the dielectric film reaction phenomenon that the dielectric film F3 is reacted with the ions in generation of the dielectric barrier discharge in the discharge space 4 can be suppressed.

As a result, the active gas generation apparatus as the basic aspect of the embodiment 6 reliably prevents mixture of atoms of the dielectric film F3 corresponding to the dielectric film reaction phenomenon, for example, into the discharge space 4, thus can generate active gas G2 of high purity.

In addition, the electrode unit 84 can be made only by adding the dielectric protection film FC5 without changing original constituting materials of the dielectric films F2 and F3, thus the manufacturing process of the electrode unit 84 is not complicated.

In the basic aspect of the active gas generation apparatus according to the embodiment 6, the dielectric protection film FC5 as the dielectric protection member includes the protection member space 40 between the dielectric protection film FC5 and the dielectric film F3 as the protection target dielectric film. The dielectric protection film FC5 and the dielectric film F3 need not be firmly attached to each other, thus the apparatus configuration can be simplified.

The gap length Δ40 of the protection member space 40 is set to be sufficiently smaller than the gap length Δ4 of the discharge space 4, thus the applied voltage from the alternating-current power source 15, the discharge space 4, and the protection member space 40 satisfying the above discharge occurrence requirements can be set relatively easily.

As a result, the active gas generation apparatus according to the embodiment 6 can accurately obtain the active gas G2 between the dielectric film F2 and the dielectric film F3 without a space where the discharge phenomenon occurs other than the discharge space 4.

The ground side electrode constituting part E22 in the electrode unit 84 includes the dielectric protection film FC5. The active gas generation apparatus according to the embodiment 5 including the electrode unit 84 applies the applied voltage between the dielectric film F2 and the dielectric film F3, thereby generating the dielectric barrier discharge in the discharge space 4 without generating the dielectric barrier discharge in the protection member space 40 formed between the dielectric protection film FC5 as the dielectric protection member and the dielectric film F3.

As a result, the active gas generation apparatus according to the embodiment 6 can activate the material gas G1 supplied to the discharge space 4 to generate the active gas G2.

The dielectric protection member corresponding to the dielectric protection film FC5 can have the above effect as long as the dielectric protection member is provided on the side of the dielectric space 18 with respect to the protection target dielectric film as at least one of the dielectric film F2 and the dielectric film F3.

Accordingly, it is also applicable that the electrode unit 84 is extended and the dielectric protection film FC4 is further provided on the side of the lower surface of the dielectric film F2 via the protection member space 40. In the similar manner, it is also applicable that the electrode unit 83 according to the embodiment 5 is extended and the dielectric protection film FC5 is further provided on the side of the upper surface of the dielectric film F3 via the protection member space 40.

In this case, two protection member spaces 40 are formed on the side of the lower surface of the dielectric film F2 and the side of the upper surface of the dielectric film F3, respectively. The gap length Δ40 of each of two protection member spaces 40 are set to be sufficiently smaller than the gap length Δ4 of the discharge space 4 to satisfy the above discharge occurrence requirements.

### <Embodiment 7>

### (Basic aspect)

Fig. 53 is an explanation diagram schematically illustrating a basic aspect of an electrode unit 91 used for an active gas generation apparatus according to an embodiment 7. The active gas generation apparatus according to the embodiment 7 includes the electrode unit 91 activating the material gas G1 supplied to the discharge space 4 to generate active gas G2.

As illustrated in Fig. 53, the electrode unit 91 includes a high voltage side electrode constituting part E13 as a first electrode constituting part and the ground side electrode constituting part E20 as the second electrode constituting part provided on a lower side of the high voltage side electrode constituting part E13.

The high voltage side electrode constituting part E13 as the first electrode constituting part includes the dielectric film F2 as the first electrode dielectric film and the high voltage electrode F5 as the first electrode conductive film provided on the upper surface of the dielectric film F2.

The ground side electrode constituting part E20 as the second electrode constituting part includes the dielectric film F3 as the second electrode dielectric film and the ground electrode F6 as the second electrode conductive film provided on the lower surface of the dielectric film F3.

The high voltage side electrode constituting part E13 in the electrode unit 91 according to the embodiment 7 has a further that it further includes a conductor film F7 as an electrode reinforcement conductive film and the dielectric protection film FC2 as the dielectric protection member. The film thickness of the dielectric protection film FC2 is set to be equal to or smaller than 1 mm.

The conductor film F7 as the electrode reinforcement conductive film is provided to be firmed attached on the lower surface of the dielectric film F2 as the first electrode dielectric film. A metal thin film is considered as the conductor film F7, for example, and a film thickness of the conductor film F7 is set to be equal to or smaller than 500 nm, for example.

The dielectric protection film FC2 as the dielectric protection member covers the whole conductor film F7, and is provided on the lower surface of the high voltage electrode F5. Accordingly, the high voltage side electrode constituting part E13 has a laminated structure with a built-in conductor film as a laminated structure in which the dielectric film F2, the conductor film F7, and the dielectric protection film FC2 are stacked in this order. There is no gap between the dielectric film F2 and the conductor film F7, between the conductor film F7 and the dielectric protection film FC2, and between the dielectric film F2 and the dielectric protection film FC2. The conductor film F7 in the laminated structure with the built-in conductor film is set in an electrically floating state.

That is to say, the high voltage side electrode constituting part E13 in the electrode unit 91 according to the embodiment 7 includes the dielectric film F2, the high voltage electrode F5, the conductor film F7, and the dielectric protection film FC2.

The dielectric space 18 is formed between the dielectric film F2 and the dielectric film F3 via the conductor film F7 and the dielectric protection film FC2. Specifically, a space where the dielectric protection film FC2 and the dielectric film F3 face each other serves as the dielectric space 18.

In this manner, in the electrode unit 91 according to the embodiment 7, the dielectric film F2 serves as the protection target dielectric film in the dielectric film F2 and the dielectric film F3, and the dielectric protection film FC2 is provided to the dielectric film F2 as the protection target dielectric film on the side of the dielectric space 18.

The same sign is assigned to the structure similar to those in the electrode unit 81 according to the embodiment 3 illustrated in Fig. 42 and the description is appropriately omitted. Characterizing portions of the electrode unit 91 are mainly described hereinafter.

The dielectric protection film FC2 as the dielectric protection member covers the whole conductor film F7 as the electrode reinforcement conductive film, and is provided on the lower surface of the dielectric film F2 as the first electrode dielectric film. As described above, the high voltage side electrode constituting part E13 has the laminated structure with the built-in conductor film as the laminated structure including the dielectric film F2, the conductor film F7, and the dielectric protection film FC2. In the laminated structure with the built-in conductor film, there is no gap between the dielectric film F2, the conductor film F7, and the dielectric protection film FC.

Then, a space where the dielectric protection film FC2 and the dielectric film F3 face each other serves as the dielectric space 18, and in the embodiment 7, the protection target dielectric film serves as the dielectric film F2.

The conductor film F7 has a planar shape larger than the high voltage electrode F5 in a plan view, and smaller than the dielectric film F2 and the dielectric protection film FC2 in a plan view. The ground electrode F6 includes the conductor film F7 in a plan view.

The dielectric space 18 includes an extension main discharge space as a region where the conductor film F7 and the ground electrode F6 are overlapped with each other in a plan view, thus a relatively large discharge space 4e is formed. That is to say, the main discharge space in the electrode unit 91 according to the embodiment 7 is extended to be the extension main discharge space by the conductor film F7. Herein, the extension main discharge space is a region where the conductor film F7 and the ground electrode F6 are overlapped with each other in a plan view in the dielectric space 18.

The electrode unit 91 further includes the alternating-current power source 15 applying alternating current voltage as applied voltage between the high voltage electrode F5 of the high voltage side electrode constituting part E13 and the ground electrode F6 of the ground side electrode constituting part E20. Specifically, the alternating current voltage is applied to the high voltage electrode F5, and the ground electrode F6 is set to have ground potential as reference potential.

The dielectric barrier discharge is generated in the discharge space 4 in application of the applied voltage from the alternating-current power source 15 in the electrode unit 91 as the basic aspect according to the embodiment 7.

A supply form of supplying the material gas G1 to the discharge space 4 and an ejection form of ejecting the active gas G2 are not particularly limited in the electrode unit 91 of the basic aspect illustrated in Fig. 53. For example, it is also applicable that the material gas G1 is supplied from a left side and the active gas G2 is ejected from a right side in Fig. 53.

The active gas generation apparatus according to the embodiment 7 including the electrode unit 91 as the basic aspect has the effect similar to the active gas generation apparatus according to the embodiment 3 including the electrode unit 81, and further includes a specific effect described hereinafter.

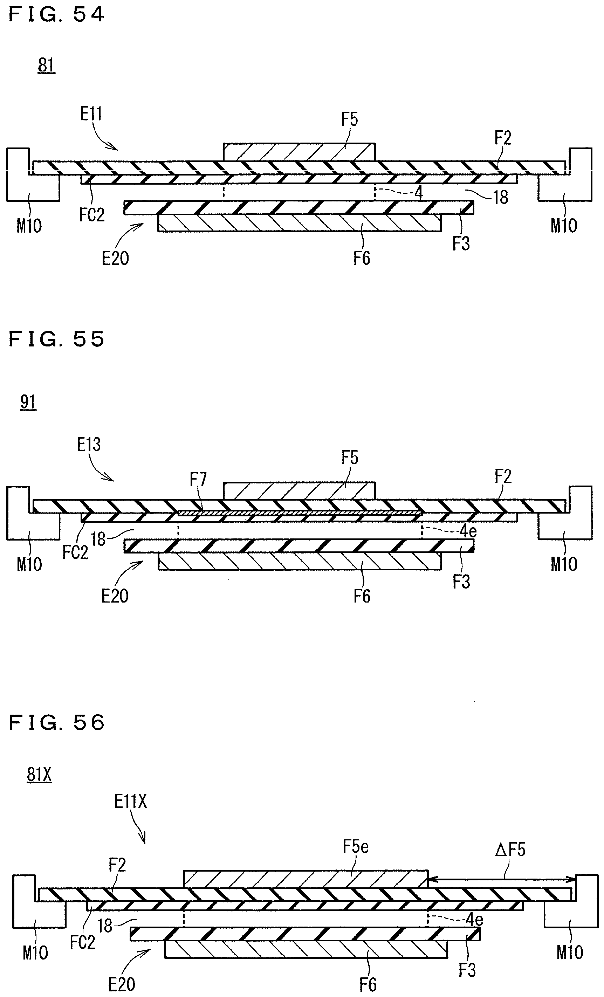

Fig. 54 to Fig. 56 are explanation diagrams for illustrating the effect of the active gas generation apparatus according to the embodiment 7. Fig. 54 is an explanation diagram illustrating the discharge space 4 of the electrode unit 81 as the basic aspect according to the embodiment 3, Fig. 55 is an explanation diagram illustrating the discharge space 4e of the electrode unit 91 as the basic aspect according to the embodiment 7, and Fig. 56 is an explanation diagram illustrating the discharge space 4e of an electrode unit 81X as the extended electrode unit 81.

A formation area of the high voltage electrode F5 is set to be the same between the electrode unit 81 and the electrode unit 91. A formation area of the conductor film F7 and a formation area of an extension high voltage electrode F5e are set to be the same as each other between the electrode unit 91 and the electrode unit 81X.

A high voltage side electrode constituting part E11X in the electrode unit 81X illustrated in Fig. 56 includes the extension high voltage electrode F5e, the dielectric film F2, and the dielectric protection film FC2. In each of the electrode unit 81, the electrode unit 91, and the electrode unit 81X, the ground electrode F6 includes the high voltage electrode F5, the conductor film F7, and the extension high voltage electrode F5e in a plan view.

The discharge space 4e in the electrode unit 91 illustrated in Fig. 55 includes the extension main discharge space as the region where the conductor film F7 and the ground electrode F6 are overlapped with each other in a plan view in the dielectric space 18.

The active gas generation apparatus as the basic aspect of the embodiment 7 makes the conductor film F7 as the electrode reinforcement conductive film intervene between the dielectric protection film FC2 as the dielectric protection member and the dielectric film F2 as the first electrode dielectric film. The conductor film F7 has shape characteristics that it is larger than the high voltage electrode F5 in a plan view.

For example, in a case where a planar shape of both the high voltage electrode F5 and the conductor film F7 is a circular shape, when a diameter of the high voltage electrode F5 is dA (mm), a diameter of the conductor film F7 is set to (dA+20 mm). In this manner, the high voltage electrode F5 has shape characteristics that the formation area thereof is smaller than that of the conductor film F7.

Thus, the basic aspect of the active gas generation apparatus according to the embodiment 7 can obtain the discharge space 4e including the extension main discharge space having a relatively large area by reason that the formation area of the conductor film F7 gets larger than that of the high voltage electrode F5.

This point is described in detail hereinafter. As illustrated in Fig. 54, the electrode unit 81 includes the main discharge space as the region where the high voltage electrode F5 and the ground electrode F6 are overlapped with each other in a plan view in the dielectric space 18, thus the discharge space 4 is formed.

In the meanwhile, as illustrated in Fig. 55, in the electrode unit 91 according to the embodiment 7, the formation area of the conductor film F7 is larger than that of the high voltage electrode F5.

The conductor film F7 as the electrode reinforcement conductive film having conductivity has characteristics that it has sufficiently small internal resistance and inner potential is made to be the same, thus can generate an electrical field generating discharge from the conductor film F7. Accordingly, in the electrode unit 91, the relatively large discharge space 4e including the extension main discharge space as the region where the conductor film F7 and the ground electrode F6 are overlapped with each other in a plan view can be formed in the dielectric space 18.

The film thickness of the conductor film F7 is set to 50 nm, for example. The film thickness of the conductor film F7 is preferably set so that a gap is not generated between the dielectric film F2, the conductor film F7, and the dielectric protection film FC2 in the laminated structure with the built-in conductor film without preventing reduction in resistance.

In the meanwhile, in the electrode unit 81X illustrated in Fig. 56, the formation area of the extension high voltage electrode F5e gets large, thus the discharge space 4e equivalent to the electrode unit 91 is formed without the conductor film F7.

However, the extension high voltage electrode F5e is exposed outside, thus an electrode margin distance ΔF5 to the dielectric film support member M10 decreases by the formation area thereof larger than the high voltage electrode F5. Thus, there is a high possibility that a defect occurs between the extension high voltage electrode F5e and the dielectric film support member M10 in the electrode unit 81X.

For example, in a case where the dielectric film support member M10 is set to a ground level in a conductor, when the electrode margin distance ΔF5 from the extension high voltage electrode F5e to the dielectric film support member M10 is small, there is a possibility that the dielectric film support member M10 and the extension high voltage electrode F5e are short-circuited via creeping discharge.

In the meanwhile, in the active gas generation apparatus as the basic aspect according to the embodiment 7, the conductor film F7 is provided in the laminated structure with the built-in conductor film, thus there is no possibility that the conductor film F7 is electrically connected to an outer constituting member such as the dielectric film support member M10.

Accordingly, in the active gas generation apparatus as the basic aspect according to the embodiment 7, the formation area of the high voltage electrode F5 is limited to bare minimum to set the electrode margin distance ΔF5 from the high voltage electrode F5 to the dielectric film support member M10 to be a sufficiently large distance, thus the possibility of occurrence of the defect such as the short circuit described above can be sufficiently suppressed.

In this manner, the active gas generation apparatus as the basic aspect according to the embodiment 7 can suppress the formation area of the high voltage electrode F5 to bare minimum, and can further generate the dielectric barrier discharge in the discharge space 4e including the relatively large (extension) main discharge space.

In the active gas generation apparatus of the basic aspect according to the embodiment 7, there is no gap between the dielectric film F2, the conductor film F7, and the dielectric protection film FC2 inside the laminated structure with the built-in conductor film, thus the active gas G2 can be obtained with high accuracy without a space where the discharge phenomenon occurs other than the discharge space 4e between the dielectric film F2 and the dielectric film F3.

The high voltage side electrode constituting part E13 in the electrode unit 91 includes the conductor film F7 and the dielectric protection film FC2. The active gas generation apparatus of the basic aspect according to the embodiment 7 including this electrode unit 91 applies the alternating current voltage as the applied voltage between the high voltage electrode F5 and the ground electrode F6 from the alternating-current power source 15, thus can activate the material gas G1 supplied to the discharge space 4 in the dielectric space 18 to generate the active gas G2.

### (Second aspect)

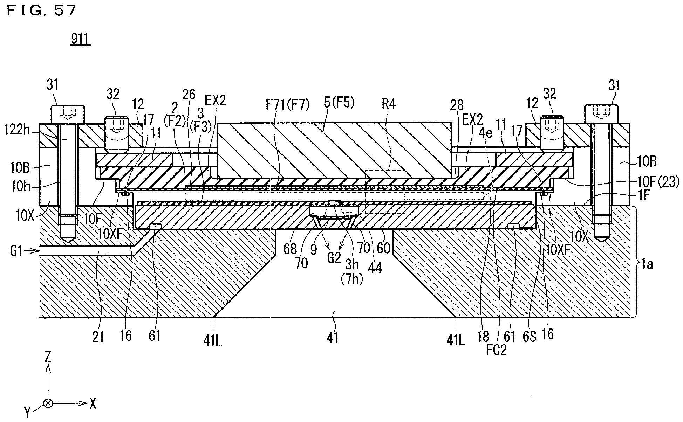

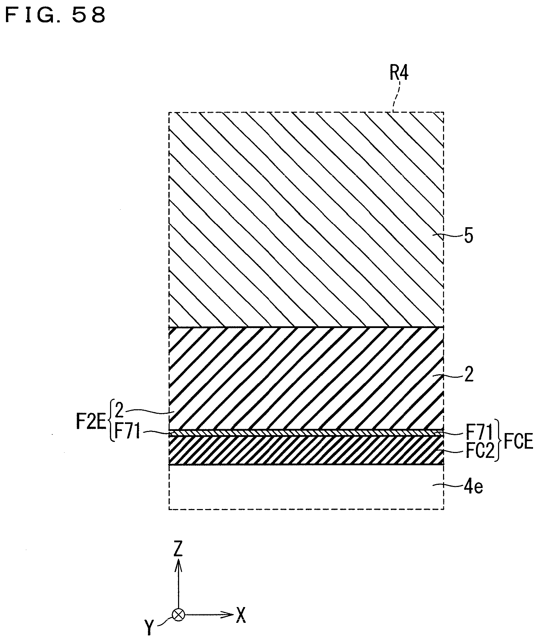

Fig. 57 is an explanation diagram illustrating a cross-section structure of an electrode unit 911 used for an active gas generation apparatus of a second aspect according to the embodiment 7. Fig. 58 is an explanation diagram illustrating a detailed structure of a focus region R4 in Fig. 57. An XYZ rectangular coordinate system is illustrated in each of Fig. 57 and Fig. 58.

The electrode unit 911 illustrated in Fig. 57 has an actual usage structure that the electrode unit 91 of the basic aspect illustrated in Fig. 53 is applied to the electrode unit 55 according to the embodiment 2. In the electrode unit 911, the high voltage side dielectric film 2 is used as the dielectric film F2, the ground side dielectric film 3 is used as the dielectric film F3, the power supply body 5 is used as the high voltage electrode F5, and the conductor film F71 is used as the conductor film F7. The conductive film 7 (Fig. 20 and Fig. 21) not shown in Fig. 57 is used as the ground electrode F6.

In this manner, the active gas generation apparatus having the actual usage structure of the second aspect according to the embodiment 7 serves as the active gas generation apparatus including the electrode unit 911.

A whole configuration of the active gas generation apparatus of the second aspect according to the embodiment 7 is similar to that of the active gas generation apparatus 71 illustrated in Fig. 1. Accordingly, the electrode unit 911 illustrated in Fig. 57 corresponds to any of the whole configuration of the electrode units 51 to 53 in the active gas generation apparatus 75 illustrated in Fig. 1.

That is to say, the second aspect of the active gas generation apparatus according to the embodiment 7 includes the electrode units 51 to 53 as the plurality of electrode units and the chassis 1 housing the electrode units 51 to 53 in the chassis space S1 (refer to Fig. 8) and having conductivity in the manner similar to the active gas generation apparatus 71 according to the embodiment 1.

The same sign is assigned to the structure similar to those in the electrode unit 50 (51 to 53) according to the embodiment 1, those in the electrode unit 55 according to the embodiment 2, or those in the electrode unit 831 according to the embodiment 5, and the description is appropriately omitted. Characterizing portions of the electrode unit 911 are mainly described hereinafter.

As illustrated in Fig. 57, the electrode unit 911 includes the concave part bottom surface 26 in the lower surface of the high voltage side dielectric film 2 and the convex part bottom surface 23 provided around the concave part bottom surface in the manner similar to the electrode unit 50 (51 to 53) according to the embodiment 1. A formation position of the convex part bottom surface 23 is set higher than that of the concave part bottom surface 26 in a height direction along the +Z direction. The conductor film F7 and the dielectric protection film FC2 are provided on the concave part bottom surface 26, and are not provided on the convex part bottom surface 23.

The electrode unit 911 includes the dielectric film support member 10B having the support surface 10F as the dielectric support surface supporting the convex part bottom surface 23 of the high voltage side dielectric film 2 from the lower side.

As illustrated in Fig. 57, the dielectric film support member 10B further includes the fixing auxiliary surface 10XF as the protection member fixing auxiliary surface disposed on the lower side of the surrounding region of the dielectric protection film FC2 provided on the concave part bottom surface 26 of the high voltage side dielectric film 2.

In the manner similar to the electrode units 50 and 55, the electrode unit 911 includes the dielectric film suppression member 11 suppressing the high voltage side dielectric film 2 as the first electrode dielectric film from the upper side, and the dielectric film suppression member 11 is not overlapped with the power supply body 5 in a plan view.

In the dielectric film support member 10B, the O ring 17 functioning as the elastic member is inserted between the fixing auxiliary surface 10XF as the protection member fixing auxiliary surface and the lower surface of the dielectric protection film FC2. The conductor film F71 is not formed in the region overlapped with the fixing auxiliary surface 10XF in a plan view. Accordingly, the concave part bottom surface 26 of the high voltage side dielectric film 2 and the upper surface of the dielectric protection film FC2 are set to be firmly attached each other by elastic force of the O ring 17. This point is described in detail hereinafter.

In Fig. 57, the O ring 17 is sandwiched between the dielectric film support member 10B and the high voltage side dielectric film 2 via the dielectric protection film FC2, thereby being deformed. The upper surface of the dielectric protection film FC2 is firmly attached to the lower surface of the high voltage side dielectric film 2 where the conductor film F71 is not formed by the elastic force of the O ring 17 functioning as the elastic member.

The electrode unit 911 used in the second aspect according to the embodiment 7 has the effect similar to the second aspect according to the embodiment 3 and the basic aspect according to the embodiment 7. Furthermore, the electrode unit 911 has a specific effect described hereinafter.

The laminated structure with the built-in conductor film made up of the high voltage side dielectric film 2 (dielectric film F2), the conductor film F71 (conductor film F7), and the dielectric protection film FC2 can be obtained by first and second manufacturing methods described hereinafter, for example.

The first manufacturing method is a manufacturing method including Steps S11 to S14, and Steps S11 to S14 are described hereinafter.

S11...The conductor film F71 is formed on the upper surface of the dielectric protection film FC2 to obtain a conductor film-equipped dielectric protection film FCE (a combination structure of the dielectric protection film FC2 and the conductor film F71) illustrated in Fig. 58. A sputtering method or an ion plating technique is used as the method of forming the conductor film F7 on the dielectric protection film FC2.

S12...The conductor film-equipped dielectric protection film FCE is disposed on the fixing auxiliary surface 10XF of the dielectric film support member 10B via the O ring 17. The conductor film F71 is not formed on the upper side of the fixing auxiliary surface 10XF in the conductor film-equipped dielectric protection film FCE.

S13...The high voltage side dielectric film 2 is disposed on the support surface 10F of the dielectric film support member 10B.

S14...The dielectric film suppression member 11 is provided to suppress the high voltage side dielectric film 2 from the upper side.

After Step S14 is execute, the upper surface of the conductor film F71 and the upper surface of the dielectric protection film FC2 (where the conductor film F71 is not provided) is firmly attached to the lower surface of the high voltage side dielectric film 2 by the elastic force of the O ring 17 functioning as the elastic member.

In this manner, the laminated structure with the built-in conductor film can be obtained without occurrence of the gap inside by the first manufacturing method including Steps S11 to S14. Flatness of the upper surface of the dielectric protection film FC2 is preferably increased by polishing, for example, to form the conductor film F71 in Step S11 with high accuracy. For example, when the film thickness of the conductor film F71 is set to 20 nm, a surface roughness of the upper surface of the dielectric protection film FC2 is preferably equal to or smaller than 20 nm.

The second manufacturing method is a manufacturing method including Steps S21 to S24, and Steps S21 to S24 are described hereinafter.

S21...The conductor film F7 is formed on the lower surface of the high voltage side dielectric film 2 to obtain a conductor film-equipped dielectric film F2E (a combination structure of the dielectric film F7 and the conductor film F7) illustrated in Fig. 58. A sputtering method or an ion plating technique is used as the method of forming the conductor film F7 on the high voltage side dielectric film 2.

S22...The dielectric protection film FC2 is disposed on the fixing auxiliary surface 10XF of the dielectric film support member 10B via the O ring 17. The conductor film F7 is not formed on the upper side of the fixing auxiliary surface 10XF in the conductor film-equipped dielectric film F2E.

S23...The conductor film-equipped dielectric film F2E is disposed on the support surface 10F of the dielectric film support member 10B. The conductor film F7 is not formed on the lower surface of the conductor film-equipped dielectric film F2E disposed on the support surface 10F.

S24...The dielectric film suppression member 11 is provided to suppress the conductor film-equipped dielectric film F2E from the upper side.

After Step S24 is execute, the upper surface of the dielectric protection film FC2 is firmly attached to the lower surface of the conductor film F7 and the lower surface of the high voltage side dielectric film 2 (where the conductor film F7 is not provided) by the elastic force of the O ring 17 functioning as the elastic member.

In this manner, the laminated structure with the built-in conductor film can be obtained without occurrence of the gap inside by the second manufacturing method including Steps S21 to S24. Flatness of the lower surface of the high voltage side dielectric film 2 is preferably increased by polishing, for example, to form the conductor film F7 in Step S21 with high accuracy. For example, when the film thickness of the conductor film F71 is set to 20 nm, a surface roughness of the lower surface of the high voltage side dielectric film 2 is preferably equal to or smaller than 20 nm.

Original constituent materials of the high voltage side dielectric film 2 and the ground side dielectric film 3 need not be changed in the electrode unit 911, and main changes from the electrode unit 55 are improvement from the dielectric film support member 10 to the dielectric film support member 10B and addition of the conductor film F7 and the dielectric protection film FC2, for example. Thus, the manufacturing method of the electrode unit 911 including the first manufacturing method or the second manufacturing method described above is not complicated.

In the second aspect of the active gas generation apparatus according to the embodiment 7, the dielectric film support member 10B of the electrode unit 911 supports the convex part bottom surface 23 of the ground side dielectric film 3 from the lower side on the support surface 10F as the dielectric support surface. Furthermore, the concave part bottom surface 26 of the high voltage side dielectric film 2 and the upper surface of the dielectric protection film FC2 are set to be firmly attached each other by the elastic force of the O ring 17 functioning as the elastic member.

Accordingly, the second aspect of the active gas generation apparatus according to the embodiment 7 can stably fix the laminated structure with the built-in conductor film with the relatively simple structure of providing the dielectric film support member 10B and the O ring 17.

In addition, the area of the power supply body 5 as the first electrode conductive film is suppressed to bare minimum, thus a sufficient insulation distance can be ensured with the dielectric film suppression member 11.

Accordingly, the second aspect of the active gas generation apparatus according to the embodiment 7 can obtain the structure of reliably prevent the defect which may occur between the power supply body 5 and the dielectric film suppression member 11.

In addition, the second aspect of the active gas generation apparatus according to the embodiment 7 can achieve improvement of an adhesion accuracy between the concave part bottom surface 26 of the high voltage side dielectric film 2 and the upper surface of the dielectric protection film FC2 with a relatively simple structure using the elastic force of the O ring 17.

Furthermore, in the second aspect of the active gas generation apparatus according to the embodiment 7 including the electrode unit 911 illustrated in Fig. 57, the plurality of gas ejection ports 70 have a feature similar to the electrode unit 55 according to the embodiment 2 and the electrode unit 811 of the second aspect. That is to say, the plurality of gas ejection ports 70 are provided in the form of being close to each other toward the lower side so that the plural pieces of partial active gas collide with each other in the collision region 80, and the collision region 80 is located in the lower side tapered region 41t (refer to Fig. 36 and Fig. 37) or on the upper side of the lower side tapered region 41t.

Thus, the second aspect of the active gas generation apparatus according to the embodiment 7 can uniformly supply the material gas G2 to the processing space in the subsequent stage in the manner similar to the active gas generation apparatus according to the embodiment 2 and the second aspect according to the embodiment 3.

### <Embodiment 8>

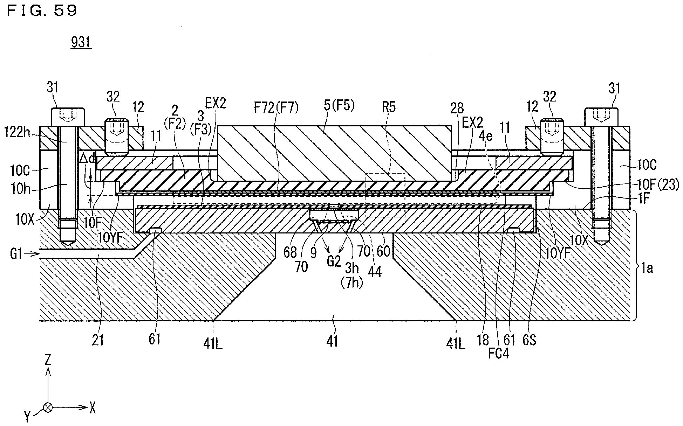

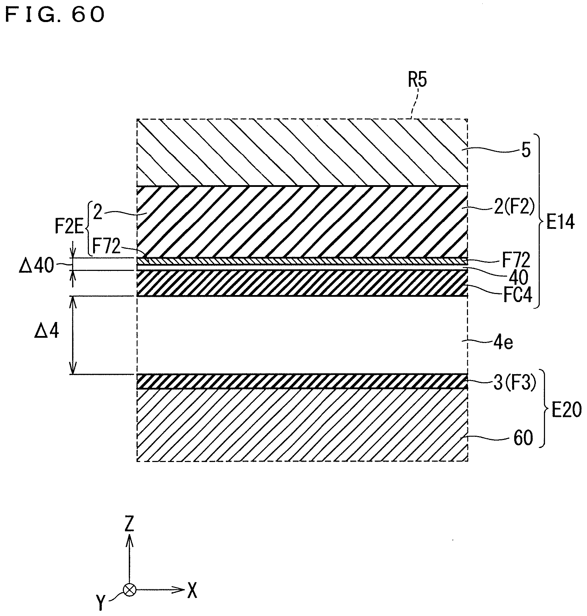

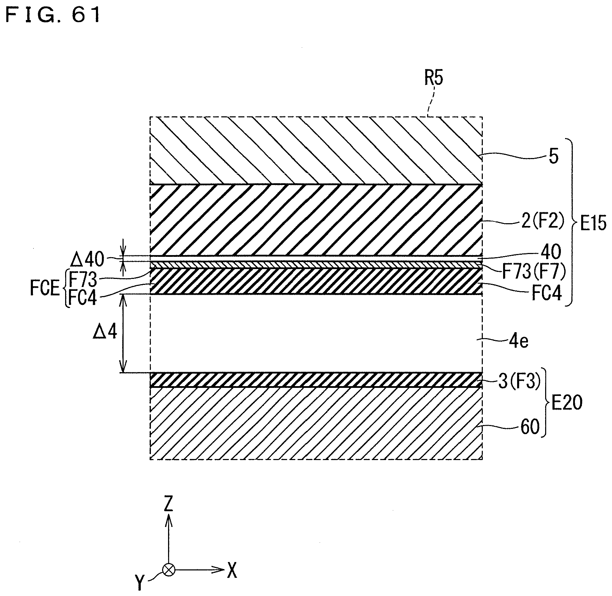

Fig. 59 is an explanation diagram illustrating a cross-section structure of an active gas generation apparatus of first and second aspects according to an embodiment 8. Fig. 60 is an explanation diagram illustrating a detailed structure of a focus region R5 in Fig. 59 in a first embodiment according to the embodiment 8. Fig. 61 is an explanation diagram illustrating a detailed structure of a focus region R5 in Fig. 59 in a second embodiment according to the embodiment 8. An XYZ rectangular coordinate system is illustrated in Fig. 59 to Fig. 61.

The electrode unit 931 illustrated in Fig. 59 has an actual usage structure corresponding to the electrode unit 831 according to the embodiment 5 illustrated in Fig. 49.

A basic aspect of the embodiment 8 corresponding to the first aspect has a structure that the conductor film F7 is provided on the lower surface of the dielectric film F2 and the protection member space 40 is provided between the lower surface of the conductor film F7 and the upper surface of the dielectric protection film FC4 in the electrode unit 83 illustrated in Fig. 47.

The basic aspect of the embodiment 8 corresponding to the second aspect has a structure that the conductor film F7 is provided on the upper surface of the dielectric protection film FC4 and the protection member space 40 is provided between the upper surface of the conductor film F7 and the lower surface of the dielectric film F2 in the electrode unit 83 illustrated in Fig. 47.

In the electrode unit 931, the high voltage side dielectric film 2 is used as the dielectric film F2, the ground side dielectric film 3 is used as the dielectric film F3, the power supply body 5 is used as the high voltage electrode F5, a conductor film F72 (first aspect) or a conductor film F73 (second aspect) is used as the conductor film F7, and the dielectric film support member 10C is used as the dielectric film support member M10 illustrated in Fig. 48. The conductive film 7 (Fig. 20 and Fig. 21) not shown in Fig. 59 is used as the ground electrode F6. Fig. 59 illustrates the conductor film F72.

In this manner, the active gas generation apparatus of the first and second aspects according to the embodiment 8 serves as the active gas generation apparatus including the electrode unit 931.

A whole configuration of the active gas generation apparatus of the first and second aspects according to the embodiment 8 is similar to that of the active gas generation apparatus 71 illustrated in Fig. 1. Accordingly, the electrode unit 931 illustrated in Fig. 59 corresponds to any of the whole configuration of the electrode units 51 to 53 in the active gas generation apparatus 75 illustrated in Fig. 1.

That is to say, the first and second aspects of the active gas generation apparatus according to the embodiment 8 includes the electrode units 51 to 53 as the plurality of electrode units and the chassis 1 housing the electrode units 51 to 53 in the chassis space S1 (refer to Fig. 8) and having conductivity in the manner similar to the active gas generation apparatus 71 according to the embodiment 1.

The same sign is assigned to the structure similar to those in the electrode unit 50 (51 to 53) according to the embodiment 1, those in the electrode unit 55 according to the embodiment 2, or those in the electrode unit 831 according to the embodiment 5, and the description is appropriately omitted. Characterizing portions of the electrode unit 931 are mainly described hereinafter.

As illustrated in Fig. 59, the electrode unit 931 includes the concave part bottom surface 26 in the lower surface of the high voltage side dielectric film 2 and the convex part bottom surface 23 provided around the concave part bottom surface in the manner similar to the electrode unit 50 (51 to 53) according to the embodiment 1. A formation position of the convex part bottom surface 23 is set higher than that of the concave part bottom surface 26 in a height direction along the +Z direction.

In the first aspect illustrated in Fig. 60, the conductor film F72 is provided on the lower surface of the concave part bottom surface 26, the dielectric protection film FC4 is provided on the lower side of the dielectric film F72 via the protection member space 40, and the conductor film F72 and the dielectric protection film FC 4 are not provided on the convex part bottom surface 23.

In this manner, in the first aspect illustrated in Fig. 60, the dielectric protection film FC4 is disposed on the side of the lower surface of the high voltage side dielectric film 2 and the conductor film F72 via the protection member space 40 having the minute gap length Δ40.

Accordingly, in the high voltage side electrode constituting part E14 in the first aspect of the electrode unit 931, the dielectric protection film FC4, the protection member space 40, the conductor film F72, the high voltage side dielectric film 2, and the power supply body 5 are disposed in this order along the height direction (+Z direction).

In the meanwhile, in the second aspect illustrated in Fig. 61, the conductor film-equipped dielectric protection film FCE as the combination structure of the conductor film F73 and the dielectric protection film FC4 is provided on the lower side of the concave part bottom surface 26 via the protection member space 40, and the conductor film F73 and the dielectric protection film FC4 are not provided on the convex part bottom surface 23.

In this manner, in the second aspect illustrated in Fig. 61, the conductor film-equipped dielectric protection film FCE as the combination structure of the conductor film F73 and the dielectric protection film FC4 is disposed on the side of the lower surface of the high voltage side dielectric film 2 via the protection member space 40 having the minute gap length Δ40.

Accordingly, in the high voltage side electrode constituting part E15 in the second aspect of the electrode unit 931, the dielectric protection film FC4, the conductor film F73, the protection member space 40, the high voltage side dielectric film 2, and the power supply body 5 are disposed in this order along the height direction (+Z direction).

When the first aspect illustrated in Fig. 60 and the second aspect illustrated in Fig. 61 are collectively referred hereinafter, they are referred to as "actual structure of the embodiment 8" or simply "embodiment 8" in some cases.

The discharge space 4e having the gap length Δ4 is located between the dielectric protection film FC4 and the ground side dielectric film 3 in the actual structure of the embodiment 8. The power supply body 5 is provided on the upper surface of the high voltage side dielectric film 2, and the ground conductor 60 is provided on the side of the lower surface of the ground side dielectric film 3.

The active gas generation apparatus as the first aspect according to the embodiment 8 illustrated in Fig. 59 and Fig. 60 has the following feature.

The conductor film F72 as the electrode reinforcement conductive film is provided to be firmed attached on the lower surface of the high voltage side dielectric film 2 as the first electrode dielectric film.

The dielectric protection film FC4 as the dielectric protection member is provided on the lower side of the conductor film F72, and includes the whole conductor film F72 in a plan view, and the protection member space 40 is provided between the dielectric protection film FC4 and the conductor film F72. Part of the protection member space 40 where the conductor film F72 is not formed serves as a space between the dielectric protection film FC4 and the high voltage side dielectric film 2.

A space where the dielectric protection film FC4 and the ground side dielectric film 3 as the second electrode dielectric film face each other is the dielectric space 18, and the protection target dielectric film is the high voltage side dielectric film 2.

The high voltage side electrode constituting part E14 as the first electrode constituting part has a feature that it further includes the dielectric protection film FC4 and the conductor film F72.

Further included is the alternating-current power source 15 applying the applied voltage VP between the power supply body 5 of the high voltage side electrode constituting part E14 and the ground conductor 6 of the ground side electrode constituting part E20, and the dielectric barrier discharge is generated in the discharge space 4e when the applied voltage is applied from the alternating-current power source 15.

The conductor film F72 is larger than the power supply body 5 in a plan view, and has a planar shape smaller than the high voltage side dielectric film 2 in a plan view, and the ground conductor 6 includes the conductor film F72 in a plan view.

The discharge space 4e includes the extension main discharge space as the region where the conductor film F7 and the ground conductor 6 are overlapped with each other in a plan view in the dielectric space 18.

The applied voltage from the alternating-current power source 15, the discharge space 4e, and the protection member space 40 are set to satisfy the discharge occurrence requirements that the dielectric barrier discharge is generated in the discharge space 4e, and the dielectric barrier discharge is not generated in the protection member space 40, in application of the applied voltage.

In the meanwhile, the active gas generation apparatus as the second aspect according to the embodiment 8 illustrated in Fig. 59 and Fig. 61 has the following feature.

The conductor film F73 as the electrode reinforcement conductive film is provided to be firmly attached on the upper surface of the dielectric protection film FC4, and the dielectric protection film FC4 includes the whole conductor film F73 in a plan view.

The protection member space 40 is provided between the conductor film F73 and the high voltage side dielectric film 2. The part of the protection member space 40 where the conductor film F73 is not formed serves as the space between the dielectric protection film FC4 and the high voltage side dielectric film 2.

The space where the dielectric protection film FC4 and the ground side dielectric film 3 face each other is the dielectric space 18, and the protection target dielectric film is the high voltage side dielectric film 2.

The high voltage side electrode constituting part E15 has a feature that it further includes the dielectric protection film FC4 and the conductor film F73.

Further included is the alternating-current power source 15 applying the applied voltage between the power supply body 5 of the high voltage side electrode constituting part E15 and the ground conductor 6 of the ground side electrode constituting part E20, and the dielectric barrier discharge is generated in the discharge space 4e when the applied voltage is applied in the alternating-current power source 15.

The conductor film F73 is larger than the power supply body 5 in a plan view, and has a planar shape smaller than the high voltage side dielectric film 2 and the dielectric protection film FC4 in a plan view, and the ground conductor 6 includes the conductor film F73 in a plan view.

The discharge space 4e includes the extension main discharge space as the region where the conductor film F73 and the ground conductor 6 are overlapped with each other in a plan view in the dielectric space 18.

The applied voltage from the alternating-current power source 15, the discharge space 4e, and the protection member space 40 are set to satisfy the discharge occurrence requirements that the dielectric barrier discharge is generated in the discharge space 4e, and the dielectric barrier discharge is not generated in the protection member space 40, in application of the applied voltage.

In the electrode unit 931 according to the embodiment 8, the gap length Δ40 as the discharge distance of the protection member space 40 is set to be sufficiently smaller than the gap length Δ4 as the discharge distance of the discharge space 4 to satisfy the discharge occurrence requirements described above. This feature is common between the first and second aspects.

As illustrated in Fig. 59, the dielectric film support member 10C further includes the support surface 10YF as the protection member support surface supporting the surrounding region of the dielectric protection film FC4 from the lower side.

The support surface 10YF supports the surrounding region of the dielectric protection film FC4 from the lower side, thus a position of the dielectric protection film FC4 in the height direction along the Z direction can be fixed.

In the case of the second aspect illustrated in Fig. 61, the support surface 10YF supports the surrounding region of the conductor film-equipped dielectric protection film FCE as the combination structure of the conductor film F73 and the dielectric protection film FC4 from the lower side.

In the dielectric film support member 10C, the formation position of the support surface 10F as the dielectric support surface is higher than the support surface 10YF as the protection member support surface in a height direction, and a difference value Δd between the support surface 10F and the support surface 10YF in the height direction is set so that the protection member space 40 having the gap length Δ40 is formed between the lower surface of the high voltage side dielectric film 2 and the upper surface of the dielectric protection film FC4.

For example, when the dielectric protection film FC4 has a uniform film thickness dC4, both the conductor films F72 and F73 have a uniform film thickness d7, and the length of the concave part bottom surface 26 from the convex part bottom surface 23 in the depth direction as the -Z direction is the protrusion length t26, the difference value Δd is set be a length satisfying {Δd = dC4+d7+t26+Δ40}. At this time, the gap length Δ40 of the protection member space 40 needs to be set to be sufficiently smaller than the gap length Δ4 of the discharge space 4 to satisfy the discharge occurrence requirements described above. The film thickness d7 of the conductor films F72 and F73 is sufficiently small, thus the gap length of the dielectric protection film FC4 and the high voltage side dielectric film 2 forming part of the protection member space 40 is substantially the same as the gap length Δ40.

The first aspect of the electrode unit 931 illustrated in Fig. 59 and Fig. 60 can be obtained by the following third manufacturing method, for example. The third manufacturing method is a manufacturing method including Steps S31 to S34 described hereinafter.

S31...The conductor film F72 is formed on the lower surface of the high voltage side dielectric film 2 to obtain a conductor film-equipped dielectric film F2E illustrated in Fig. 60.

S32...The dielectric protection film FC2 is disposed on the support surface 10YF of the dielectric film support member 10C. The conductor film F7 is not formed on the lower surface of the conductor film-equipped dielectric film F2E disposed on the support surface 10F.

S33...The conductor film-equipped dielectric film F2E is disposed on the support surface 10F of the dielectric film support member 10C. The conductor film F72 is not formed on the lower surface of the conductor film-equipped dielectric film F2E disposed on the support surface 10F.

S34...The dielectric film suppression member 11 is provided to suppress the conductor film-equipped dielectric film F2E from the upper side.

After Step S34 is executed, the protection member space 40 is formed between the upper surface of the dielectric protection film FC4 and the lower surface of the conductor film F72 and between the upper surface of the dielectric protection film FC4 and the lower surface of the high voltage side dielectric film 2 (where the conductor film F72 is not provided).

In this manner, the first aspect of the electrode unit 931 including the high voltage side electrode constituting part E14 can be obtained by the third manufacturing method including Steps S31 to S34.

The second aspect of the electrode unit 931 illustrated in Fig. 59 and Fig. 61 can be obtained by the following fourth manufacturing method, for example. The fourth manufacturing method is a manufacturing method including Steps S41 to S44 described hereinafter.

S41...The conductor film F73 is formed on the upper surface of the dielectric protection film FC2 to obtain the conductor film-equipped dielectric film FCE as illustrated in Fig. 61.

S42...The conductor film-equipped dielectric protection film FCE is disposed on the support surface 10YF of the dielectric film support member 10C. The conductor film F7 is not formed on the upper side of the support surface 10YF in the conductor film-equipped dielectric protection film FCE.

S43...The high voltage side dielectric film 2 is disposed on the support surface 10F of the dielectric film support member 10C.

S44...The dielectric film suppression member 11 is provided to suppress the high voltage side dielectric film 2 from the upper side.

After Step S44 is executed, the protection member space 40 is formed between the upper surface of the conductor film F73 of the conductor film-equipped dielectric protection film FCE and the high voltage side dielectric film 2 and between the upper surface of the dielectric protection film FC2 (where the conductor film F73 is not provided) and the high voltage side dielectric film 2.

The active gas generation apparatus including the electrode unit 931 as the actual structure of the embodiment 8 has the effect similar to the active gas generation apparatus according to the embodiment 5 illustrated in Fig. 47 to Fig. 51, and further includes a specific effect described hereinafter.

In the active gas generation apparatus according to the embodiment 8, the conductor film F72 or the conductor film F73 as the electrode reinforcement conductive film is provided between the dielectric protection film FC4 as the dielectric protection member and the high voltage side dielectric film 2 (dielectric film F2) as the first electrode dielectric film. The conductor film F72 or the conductor film F73 has shape characteristics that it is larger than the power supply body 5 (high voltage electrode F5) as the first electrode conductive film in a plan view.

Thus, the active gas generation apparatus according to the embodiment 8 can obtain the discharge space 4e including the extension main discharge space having a larger area by reason that the formation area of the conductor film F72 or the conductor film F73 gets larger than that of the power supply body 5.

Accordingly, in the active gas generation apparatus according to the embodiment 8, the formation area of the power supply body 5 can be suppressed to bare minimum, and the dielectric barrier discharge can be generated in the relatively large discharge space 4e including the extension main discharge space.

In the first aspect of the active gas generation apparatus according to the embodiment 8, the dielectric protection film FC4 as the dielectric protection member includes the protection member space 40 between the dielectric protection film FC4 and the conductor film F72 as the electrode reinforcement conductive film. The dielectric protection film FC4 and the conductor film F72 or the high voltage side dielectric film 2 need not be firmly attached to each other, thus the apparatus configuration can be simplified.

In the meanwhile, in the second aspect of the active gas generation apparatus according to the embodiment 8, the protection member space 40 is located between the conductor film F73 and the high voltage side dielectric film 2, thus the dielectric protection film FC4 and the high voltage side dielectric film 2 need not be firmly attached to each other, and the apparatus configuration can be simplified.

In the active gas generation apparatus according to the embodiment 8, the gap length Δ40 of the protection member space 40 is set to be sufficiently smaller than the gap length Δ4 of the discharge space 4e, thus the applied voltage, the discharge space 4, and the protection member space 40 satisfying the above discharge occurrence requirements can be set relatively easily.

As a result, the active gas generation apparatus according to the embodiment 8 can accurately obtain the active gas G2 between the dielectric film 2 (F2) and the dielectric film 3 (F3) without a space where the discharge phenomenon occurs other than the discharge space 4e.

The high voltage side electrode constituting part E14 in the first aspect of the electrode unit 931 includes the dielectric protection film FC4, and in the electrode unit 931, the applied voltage applied between the dielectric films F2 and F3 satisfies the above discharge occurrence requirements.

Thus, the first aspect of the active gas generation apparatus according to the embodiment 8 including the electrode unit 931 can generate the dielectric barrier discharge in the relatively large discharge space 4e including the extension main discharge space formed between the dielectric protection film FC4 and the dielectric film 3 (F3) without generating the dielectric barrier discharge in the protection member space 40 formed between the dielectric protection film FC4 and the conductive film F72.

In the meanwhile, the high voltage side electrode constituting part E15 in the second aspect of the electrode unit 931 includes the dielectric protection film FC4, and in the electrode unit 931, the applied voltage applied between the dielectric films F2 and F3 satisfies the above discharge occurrence requirements.

Thus, the second aspect of the active gas generation apparatus according to the embodiment 8 can generate the dielectric barrier discharge in the relatively large discharge space 4e including the extension main discharge space formed between the dielectric protection film FC4 and the dielectric film 3 (F3) without generating the dielectric barrier discharge in the protection member space 40 formed between the high voltage side dielectric film 2 and the conductive film F73.

As a result, the active gas generation apparatus according to the embodiment 8 can activate the material gas G1 supplied to the relatively large discharge space 4e to generate the active gas G2.

Furthermore, in the electrode unit 931 in the active gas generation apparatus according to the embodiment 8, the dielectric film support member 10C supports the surrounding region of the high voltage side dielectric film 2 from the lower side on the support surface 10F as the dielectric support surface, and supports the surrounding region of the dielectric protection film FC4 from the lower side on the support surface 10YF as the protection member support surface.

In addition, in the electrode unit 931, the difference value Δd between the support surface 10F and the support surface 10YF is set so that the protection member space 40 having the gap length Δ40 is formed in part of a space between the lower surface of the high voltage side dielectric film 2 and the upper surface of the dielectric protection film FC4.

Accordingly, the active gas generation apparatus according to the embodiment 8 can stably fix the dielectric protection film FC4 or the conductor film-equipped dielectric protection film FCE (combination structure of the conductor film F73 and the dielectric protection film FC4) having the protection member space 40 with the high voltage side dielectric film 2.

Furthermore, the plurality of gas ejection ports 70 in the active gas generation apparatus according to the embodiment 8 including the electrode unit 931 illustrated in Fig. 59 to Fig. 61 have a feature similar to the electrode unit 55 according to the embodiment 2 or the electrode unit 831 according to the embodiment 5. That is to say, the plurality of gas ejection ports 70 are provided in the form of being close to each other toward the lower side so that the plural pieces of partial active gas collide with each other in the collision region 80, and the collision region 80 is located in the lower side tapered region 41t (refer to Fig. 36 and Fig. 37) or on the upper side of the lower side tapered region 41t.

As a result, the active gas generation apparatus according to the embodiment 8 can uniformly supply the material gas G2 to the processing space in the subsequent stage in the manner similar to the electrode unit 55 according to the embodiment 2 and the electrode unit 831 according to the embodiment 5.

### <Other>

The present disclosure is described in detail, however, the foregoing description is in all aspects illustrative, thus the present disclosure is not limited thereto. It is therefore understood that numerous modification examples not exemplified can be devised without departing from the scope of the present disclosure.

For example, the plural pieces of partial active gas are made to collide with each other in one collision region 80 in the embodiment 2, however, the plural pieces of partial active gas may be selectively made to collide with each other in two or more collision regions.

With regard to the embodiment 3 to the embodiment 6, an active gas generation apparatus including first and second improved electrode units is considered.

The first improved electrode unit has a structure including the dielectric protection film FC2 according to the embodiment 3 and the dielectric protection film FC5 according to the embodiment 6 as a combination structure of the electrode unit 81 and the electrode unit 84.

The second improved electrode unit has a structure including the dielectric protection film FC3 according to the embodiment 4 and the dielectric protection film FC4 according to the embodiment 5 as a combination structure of the electrode unit 82 and the electrode unit 83.

In this manner, each embodiment can be arbitrarily combined, or each embodiment can be appropriately varied or omitted within a scope of the present disclosure.

### EXPLANATION OF REFERENCE SIGNS

1 chassis
2 high voltage side dielectric film
3 ground side dielectric film
4, 4e discharge space
5 power supply body
6, 60 ground conductor
7 conductive film
8 cover dielectric film
9 shield dielectric film
10, 10B, 10C, M10 dielectric film support member
11 dielectric film suppression member
12 press member
13 buffer conductor
15 alternating current power source
21 gas flow path
22 cooling path
40 protection member space
41 chassis opening part
41a upper side region
41t lower side tapered region
50, 51 to 53, 55, 81 to 84, 91, 810, 811, 830, 831, 911, 931 electrode unit
61 material gas buffer space
62 slit space
63 side surface space
68 active gas buffer space
69, 70 gas ejection port
71, 75 active gas generation apparatus
80 collision region
E1, E10 to E15 high voltage side electrode constituting part
E2, E20 to E22 ground side electrode constituting part
F2, F3 dielectric film
F5, F6 high voltage electrode
F7, F71 to F73 dielectric film
FC2 to FC5 dielectric protection film

## Claims

1. An active gas generation apparatus including an electrode unit activating material gas supplied to a discharge space and generating active gas, wherein
the electrode unit includes:
a first electrode constituting part; and
a second electrode constituting part provided on a lower side of the first electrode constituting part,
the first electrode constituting part includes a first electrode dielectric film and a first electrode conductive film provided on an upper surface of the first electrode dielectric film,
the second electrode constituting part includes a second electrode dielectric film and a second electrode conductive film provided on a lower surface of the second electrode dielectric film,
a dielectric space is provided between the first electrode dielectric film and the second electrode dielectric film,
the discharge space includes a main discharge space as a region in which the first and second electrode conductive films are overlapped with each other in a plan view in the dielectric space,
the electrode unit further includes a dielectric protection member provided on a side of the dielectric space with respect to a protection target dielectric film as at least one of the first electrode dielectric film and the second electrode dielectric film, and
a constituent material of the dielectric protection member has protection properties that irradiation of the protection target dielectric film with ions generated by dielectric barrier discharge is blocked in generation of the dielectric barrier discharge in the discharge space and chemical reaction with the ions does not occur.

2. The active gas generation apparatus according to claim 1, wherein
the dielectric protection member is provided to be firmly attached to the protection target dielectric film without a gap.

3. The active gas generation apparatus according to claim 2, wherein
the dielectric protection member is provided to be firmly attached on a lower surface of the first electrode dielectric film, and a space where the dielectric protection member and the second electrode dielectric film face each other serves as the dielectric space,
the protection target dielectric film is the first electrode dielectric film,
the first electrode constituting part further includes the dielectric protection member,
the active gas generation apparatus further includes
a power source applying applied voltage between the first electrode conductive film of the first electrode constituting part and the second electrode conductive film of the second electrode constituting part, and
the dielectric barrier discharge is generated in the discharge space in application of the applied voltage.

4. The active gas generation apparatus according to claim 1, further comprising
an electrode reinforcement conductive film provided on the lower surface of the first electrode dielectric film, wherein
the dielectric protection member wholly covers the electrode reinforcement conductive film and is provided on the lower surface of the first electrode dielectric film, and a laminated structure is provided in an order of the first electrode dielectric film, the electrode reinforcement conductive film, and the dielectric protection member without a gap,
a space where the dielectric protection member and the second electrode dielectric film face each other serves as the dielectric space,
the protection target dielectric film is the first electrode dielectric film,
the first electrode constituting part further includes the dielectric protection member and the electrode reinforcement conductive film,
the active gas generation apparatus further includes
a power source applying applied voltage between the first electrode conductive film of the first electrode constituting part and the second electrode conductive film of the second electrode constituting part,
the dielectric barrier discharge is generated in the discharge space in application of the applied voltage,
the electrode reinforcement conductive film is larger than the first electrode conductive film in a plan view and has a planar shape smaller than the first electrode dielectric film in a plan view, and the second electrode conductive film includes the electrode reinforcement conductive film in a plan view, and
the discharge space includes an extension main discharge space where the electrode reinforcement conductive film and the second electrode conductive film are overlapped with each other in a plan view in the dielectric space.

5. The active gas generation apparatus according to claim 3, wherein
the lower surface of the first electrode dielectric film includes a concave part bottom surface and a convex part bottom surface provided around the concave part bottom surface, a formation position of the convex part bottom surface is higher than a formation position of the concave part bottom surface in a height direction, the dielectric protection member is provided on the concave part bottom surface, and the dielectric protection member is not provided on the convex part bottom surface,
the electrode unit includes:
a dielectric film support member including a dielectric support surface supporting the convex part bottom surface of the first electrode dielectric film from a lower side; and
a dielectric film suppression member suppressing the first electrode dielectric film from an upper side, the dielectric film suppression member not being overlapped with the first electrode conductive film in a plan view,
the dielectric film support member further includes a protection member fixing auxiliary surface disposed on a lower side of the dielectric protection member provided on the concave part bottom surface, and
the electrode unit further includes an elastic member inserted between the protection member fixing auxiliary surface and a lower surface of the dielectric protection member, and the concave part bottom surface of the first electrode dielectric film and an upper surface of the dielectric protection member are set to be firmly attached to each other by elastic force of the elastic member.

6. The active gas generation apparatus according to claim 4, wherein
the lower surface of the first electrode dielectric film includes a concave part bottom surface and a convex part bottom surface provided around the concave part bottom surface, a formation position of the convex part bottom surface is higher than a formation position of the concave part bottom surface in a height direction, the electrode reinforcement conductive film and the dielectric protection member are provided on the concave part bottom surface, and the electrode reinforcement conductive film and the dielectric protection member are not provided on the convex part bottom surface,
the electrode unit includes:
a dielectric film support member including a dielectric support surface supporting the convex part bottom surface of the first electrode dielectric film from a lower side; and
a dielectric film suppression member suppressing the first electrode dielectric film from an upper side, the dielectric film suppression member not being overlapped with the first electrode conductive film in a plan view,
the dielectric film support member further includes a protection member fixing auxiliary surface disposed on a lower side of the dielectric protection member provided on the concave part bottom surface,
the electrode reinforcement conductive film is not formed in a region overlapped with the protection member fixing auxiliary surface in a plan view, and
the electrode unit further includes an elastic member inserted between the protection member fixing auxiliary surface and a lower surface of the dielectric protection member, and the concave part bottom surface of the first electrode dielectric film and an upper surface of the dielectric protection member are set to be firmly attached to each other by elastic force of the elastic member.

7. The active gas generation apparatus according to claim 5 or 6, wherein
the concave part bottom surface is formed into a circular shape in a plan view,
the convex part bottom surface is annularly formed around the concave part bottom surface,
the protection member fixing auxiliary surface of the dielectric film support member is annularly formed in a plan view,
the dielectric film support member includes:
a groove part annularly formed in the protection member fixing auxiliary surface in a plan view; and
an O ring provided in the groove part and having an annular shape in a plan view, and
the elastic member is the O ring.

8. The active gas generation apparatus according to claim 2, wherein
the dielectric protection member is provided to be firmly attached on an upper surface of the second electrode dielectric film, and a space where the first electrode dielectric film and the dielectric protection member face each other serves as the dielectric space,
the protection target dielectric film is the second electrode dielectric film,
the second electrode constituting part further includes the dielectric protection member, and
the active gas generation apparatus further includes
a power source applying applied voltage between the first electrode conductive film of the first electrode constituting part and the second electrode conductive film of the second electrode constituting part.

9. The active gas generation apparatus according to claim 1, further comprising
a power source applying applied voltage between the first electrode conductive film of the first electrode constituting part and the second electrode conductive film of the second electrode constituting part,
the dielectric protection member is provided to include a protection member space between the dielectric protection member and the protection target dielectric film, and
the applied voltage, the discharge space, and the protection member space are set to satisfy discharge occurrence requirements that the dielectric barrier discharge is generated in the discharge space, and the dielectric barrier discharge is not generated in the protection member space, in application of the applied voltage.

10. The active gas generation apparatus according to claim 9, wherein
the dielectric protection member includes the protection member space between the dielectric protection member and the lower surface of the first electrode dielectric film, and a space where the dielectric protection member and the second electrode dielectric film face each other serves as the dielectric space,
the protection target dielectric film is the first electrode dielectric film, and
the first electrode constituting part further includes the dielectric protection member.

11. The active gas generation apparatus according to claim 1, further comprising
an electrode reinforcement conductive film provided to be firmly attached on the lower surface of the first electrode dielectric film, wherein
the dielectric protection member is provided on a lower side of the electrode reinforcement conductive film and wholly includes the electrode reinforcement conductive film in a plan view, and a protection member space is provided between the dielectric protection member and the electrode reinforcement conductive film,
a space where the dielectric protection member and the second electrode dielectric film face each other serves as the dielectric space,
the protection target dielectric film is the first electrode dielectric film,
the first electrode constituting part further includes the dielectric protection member and the electrode reinforcement conductive film,
the active gas generation apparatus further includes
a power source applying applied voltage between the first electrode conductive film of the first electrode constituting part and the second electrode conductive film of the second electrode constituting part,
the dielectric barrier discharge is generated in the discharge space in application of the applied voltage,
the electrode reinforcement conductive film is larger than the first electrode conductive film in a plan view and has a planar shape smaller than the first electrode dielectric film in a plan view, and the second electrode conductive film includes the electrode reinforcement conductive film in a plan view,
the discharge space includes an extension main discharge space where the electrode reinforcement conductive film and the second electrode conductive film are overlapped with each other in a plan view in the dielectric space, and
the applied voltage, the discharge space, and the protection member space are set to satisfy discharge occurrence requirements that the dielectric barrier discharge is generated in the discharge space, and the dielectric barrier discharge is not generated in the protection member space, in application of the applied voltage.

12. The active gas generation apparatus according to claim 1, further comprising
an electrode reinforcement conductive film provided to be firmly attached on an upper surface of the dielectric protection member, the dielectric protection member wholly including the electrode reinforcement conductive film in a plan view,
a protection member space is provided between the electrode reinforcement conductive film and the first electrode dielectric film,
a space where the dielectric protection member and the second electrode dielectric film face each other serves as the dielectric space,
the protection target dielectric film is the first electrode dielectric film,
the first electrode constituting part further includes the dielectric protection member and the electrode reinforcement conductive film,
the active gas generation apparatus further includes
a power source applying applied voltage between the first electrode conductive film of the first electrode constituting part and the second electrode conductive film of the second electrode constituting part,
the dielectric barrier discharge is generated in the discharge space in application of the applied voltage,
the electrode reinforcement conductive film is larger than the first electrode conductive film in a plan view and has a planar shape smaller than the first electrode dielectric film in a plan view, and the second electrode conductive film includes the electrode reinforcement conductive film in a plan view,
the discharge space includes an extension main discharge space where the electrode reinforcement conductive film and the second electrode conductive film are overlapped with each other in a plan view in the dielectric space, and
the applied voltage, the discharge space, and the protection member space are set to satisfy discharge occurrence requirements that the dielectric barrier discharge is generated in the discharge space, and the dielectric barrier discharge is not generated in the protection member space, in application of the applied voltage.

13. The active gas generation apparatus according to claim 10, wherein
the lower surface of the first electrode dielectric film includes a concave part bottom surface and a convex part bottom surface provided around the concave part bottom surface, a formation position of the convex part bottom surface is higher than a formation position of the concave part bottom surface in a height direction, the concave part bottom surface is overlapped with the dielectric protection member in a plan view, and the convex part bottom surface is not overlapped with the dielectric protection member in a plan view,
the electrode unit includes:
a dielectric film support member including a dielectric support surface supporting the convex part bottom surface of the first electrode dielectric film from a lower side; and
a dielectric film suppression member suppressing the first electrode dielectric film from an upper side, the dielectric film suppression member not being overlapped with the first electrode conductive film in a plan view,
the dielectric film support member further includes a protection member support surface supporting the dielectric protection member from a lower side, and
a formation position of the dielectric support surface is higher than a formation position of the protection member support surface in a height direction, a difference value between the dielectric support surface and the protection member support surface in a height direction is set so that the protection member space is formed between a lower surface of the first electrode dielectric film and an upper surface of the dielectric protection member.

14. The active gas generation apparatus according to claim 11 or 12, wherein
the lower surface of the first electrode dielectric film includes a concave part bottom surface and a convex part bottom surface provided around the concave part bottom surface, a formation position of the convex part bottom surface is higher than a formation position of the concave part bottom surface in a height direction, the concave part bottom surface is overlapped with the dielectric protection member and the electrode reinforcement conductive film in a plan view, and the convex part bottom surface is not overlapped with the dielectric protection member and the electrode reinforcement conductive film in a plan view,
the electrode unit includes:
a dielectric film support member including a dielectric support surface supporting the convex part bottom surface of the first electrode dielectric film from a lower side; and
a dielectric film suppression member suppressing the first electrode dielectric film from an upper side, the dielectric film suppression member not being overlapped with the first electrode conductive film in a plan view,
the dielectric film support member further includes a protection member support surface supporting the dielectric protection member from a lower side, and
a formation position of the dielectric support surface is higher than a formation position of the protection member support surface in a height direction, a difference value between the dielectric support surface and the protection member support surface in a height direction is set so that the protection member space is formed in a part of a space between a lower surface of the first electrode dielectric film and an upper surface of the dielectric protection member.

15. The active gas generation apparatus according to claim 9, wherein
the dielectric protection member includes the protection member space between the dielectric protection member and the upper surface of the second electrode dielectric film, and a space where the first electrode dielectric film and the dielectric film protection member face each other serves as the dielectric space,
the protection target dielectric film is the second electrode dielectric film, and
the second electrode constituting part further includes the dielectric protection member.

16. The active gas generation apparatus according to any one of claims 3 to 7 and 10 to 14, further comprising
a chassis housing the electrode unit in a chassis space and having conductivity, wherein
the chassis includes a chassis bottom part including a flat surface and a conductor housing space concaved from the flat surface in a depth direction,
the electrode unit further includes a reference potential conductor provided to a lower side of the second electrode constituting part to be housed in the conductor housing space,
the reference potential conductor includes an active gas buffer space on an upper portion, and the second electrode constituting part is disposed to cover the active gas buffer space,
the second electrode dielectric film includes a dielectric through port passing through the second electrode dielectric film in a region overlapped with the active gas buffer space in a plan view, and the second electrode conductive film includes a conductive film opening part in a region overlapped with the active gas buffer space in a plan view, the conductive film opening part is overlapped with the dielectric through port in a plan view,
the active gas generation apparatus further includes
a plurality of gas ejection ports each provided to pass through the reference potential conductor from a bottom surface of the active gas buffer space, the plurality of gas ejection ports not being overlapped with the dielectric through port in a plan view,
the discharge space includes an auxiliary discharge space including the dielectric through port and part of the active gas buffer space in addition to the main discharge space,
active gas outputted from the plurality of gas ejection ports is regulated as plural pieces of partial active gas,
the chassis bottom part of the chassis includes a chassis opening part in a region overlapped with the active gas buffer space in a plan view, and the plural pieces of partial active gas are introduced to a lower side through the chassis opening part,
the chassis opening part includes a tapered region having a tapered shape with increasing opening area toward a lower side, and
the plurality of gas ejection ports are provided in a form of getting closer to each other toward a lower side so that the plural pieces of partial active gas collide with each other in a collision region, and the collision region is located in the tapered region or on an upper side of the tapered region.
